(19) Europäisches Patentamt
European Patent Office
Office européen des brevets

(11) EP 4 394 508 A1

# (12) EUROPEAN PATENT APPLICATION

(43) Date of publication:
**03.07.2024 Bulletin 2024/27**

(21) Application number: **23179243.3**

(22) Date of filing: **14.06.2023**

(51) International Patent Classification (IPC):
***G03F 7/004*** *(2006.01)* ***C07F 7/22*** *(2006.01)*

(52) Cooperative Patent Classification (CPC):
**G03F 7/0042;** C07F 7/2224

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.12.2022 KR 20220186382**

(71) Applicant: **Samsung Electronics Co., Ltd.**
**Suwon-si, Gyeonggi-do 16677 (KR)**

(72) Inventors:
- **KOH, Haengdeog**
  **16678 Suwon-si (KR)**
- **KWAK, Yoonhyun**
  **16678 Suwon-si (KR)**
- **KIM, Mijeong**
  **16678 Suwon-si (KR)**
- **NAM, Youngmin**
  **16678 Suwon-si (KR)**
- **AHN, Chanjae**
  **16678 Suwon-si (KR)**
- **LEE, Changheon**
  **16678 Suwon-si (KR)**
- **IM, Kyuhyun**
  **16678 Suwon-si (KR)**
- **CHOI, Sungwon**
  **16678 Suwon-si (KR)**
- **HAN, Sunghyun**
  **16678 Suwon-si (KR)**

(74) Representative: **Elkington and Fife LLP**
**Prospect House**
**8 Pembroke Road**
**Sevenoaks, Kent TN13 1XR (GB)**

Remarks:
Amended claims in accordance with Rule 137(2) EPC.

## (54) RESIST COMPOSITION AND PATTERN FORMING METHOD USING THE SAME

(57) Provided are a resist composition and a pattern forming method using the same. The resist composition may include an organometallic compound represented by Formula 1 below and a polymer repeating unit represented by Formula 2 below.

<Formula 1> $M_{11}(R_{11})_n(OR_{12})_{(4-n)}$

EP 4 394 508 A1

<Formula 2>

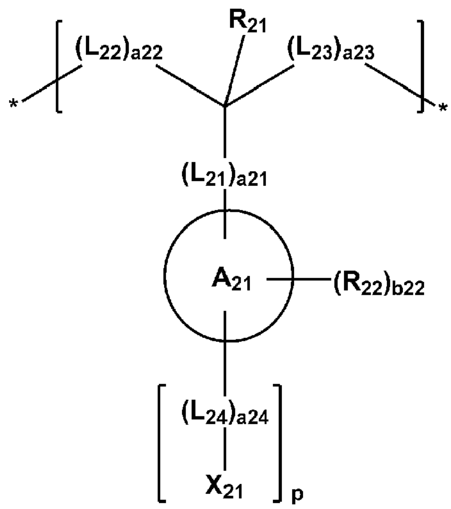

In Formulas 1 and 2, descriptions of $M_{11}$, $R_{11}$, $R_{12}$, n, $A_{21}$, $L_{21}$ to $L_{24}$, a21 to a24, $R_{21}$, $R_{22}$, b22, p, and $X_{21}$ refer to the specification.

FIG. 1

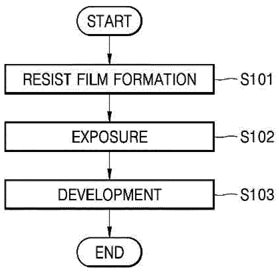

## Description

FIELD OF THE INVENTION

An embodiment of the present disclosure relates to a resist composition and a pattern forming method using the same.

BACKGROUND OF THE INVENTION

To form fine patterns in manufacturing semiconductors, resists of which physical properties change in response to light are used. Among them, a chemically amplified resist has been widely used. In a chemically amplified resist, an acid formed by a reaction between light and a photoacid generator reacts again with a base resin, to cause the solubility of the base resin in a developing solution to be changed, and thus patterning is possible.

However, when using the chemically amplified resist, the formed acid may diffuse up to an unexposed area and may cause a decrease in uniformity of patterns, or an increase in surface roughness, etc. In addition, as a semiconductor process scale becomes finer and finer, diffusion control of acids is not easy, and thus the development of a new type of resist may be required.

Recently, in order to overcome the limitations of chemically amplified resists, attempts to develop materials of which physical properties change due to an exposure have been made. However, there is still a limitation in that a dose required for an exposure is high.

SUMMARY OF THE INVENTION

Accordingly, an embodiment provides a resist composition of which physical properties change even by low-dose radiation exposure, and which provides a pattern having improved resolution, and a pattern forming method using the same.

Additional aspects will be set forth in part in the description which follows and, in part, will be apparent from the description, or may be learned by practice of the presented embodiments of the disclosure.

According to an example embodiment, a resist composition may include an organometallic compound represented by Formula 1 and a polymer including a repeating unit represented by Formula 2:

<Formula 1> $M_{11}(R_{11})_n(OR_{12})_{(4-n)}$

<Formula 2>

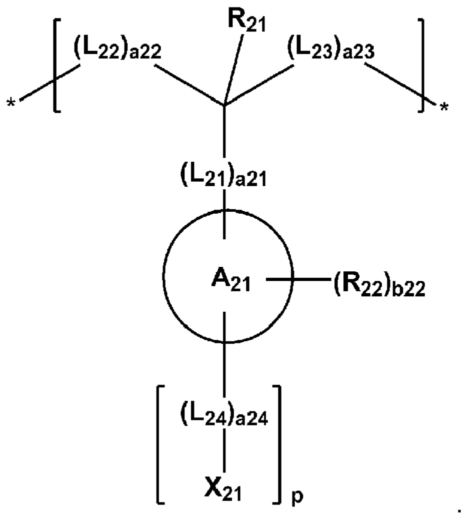

In Formulas 1 and 2,

$M_{11}$ may be indium (In), tin (Sn), antimony (Sb), tellurium (Te), thallium (Tl), lead (Pb), bismuth (Bi), silver (Ag), or polonium (Po),

$R_{11}$ may be a linear, branched, or cyclic $C_1$-$C_{30}$ monovalent hydrocarbon group optionally containing a heteroatom,
$R_{12}$ may be a linear, branched, or cyclic $C_1$-$C_{30}$ monovalent hydrocarbon group optionally containing a heteroatom, or *-$M_{12}(R_{13})_m(OR_{14})_{(3-m)}$,
n may be an integer of 1 to 4,
$M_{12}$ may be indium (In), tin (Sn), antimony (Sb), tellurium (Te), thallium (Tl), lead (Pb), bismuth (Bi), silver (Ag), or polonium (Po),
$R_{13}$ and $R_{14}$ each independently may be a linear, branched, or cyclic $C_1$-$C_{30}$ monovalent hydrocarbon group optionally containing a heteroatom,
m may be an integer of 0 to 3,
$L_{21}$ to $L_{24}$ each independently may be a single bond, O, S, C (=O), C (=O)O, OC (=O), C(=O)NH, NHC(=O), a linear, branched, or cyclic $C_1$-$C_{30}$ divalent hydrocarbon group optionally containing a heteroatom, or a combination thereof,
a21 to a24 each independently may be an integer of 1 to 4,
$A_{21}$ may be a $C_1$-$C_{30}$ aryl group or a $C_1$-$C_{30}$ heteroaryl group,
$R_{21}$ and $R_{22}$ each independently may be hydrogen, deuterium, a halogen atom or a linear, branched, or cyclic $C_1$-$C_{30}$ monovalent hydrocarbon group optionally containing a heteroatom,
b22 may be an integer of 1 to 10,
p may be an integer of 1 to 5,
$X_{21}$ may be a reactive group that reacts with the organometallic compound, and
* may be a bonding site to a neighboring atom.

According to an example embodiment, a resist composition may include an organometallic compound represented by Formula 1; and a monomer represented by Formula 20:

<Formula 1> $M_{11}(R_{11})_n(OR_{12})_{(4-n)}$

<Formula 20>

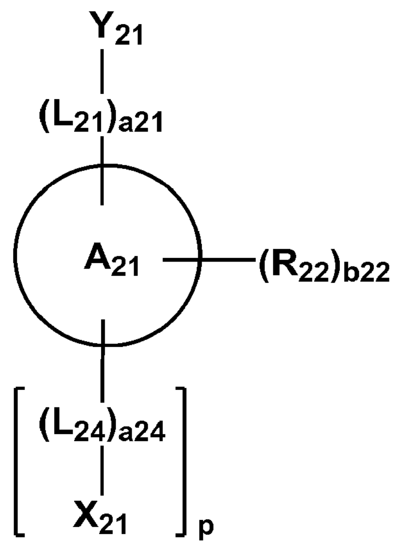

In Formulas 1 and 20,

$M_{11}$ may be indium (In), tin (Sn), antimony (Sb), tellurium (Te), thallium (Tl), lead (Pb), bismuth (Bi), silver (Ag), or polonium (Po),
$R_{11}$ may be a linear, branched, or cyclic $C_1$-$C_{30}$ monovalent hydrocarbon group optionally containing a heteroatom,
$R_{12}$ may be a linear, branched, or cyclic $C_1$-$C_{30}$ monovalent hydrocarbon group optionally containing a heteroatom, or *-$M_{12}(R_{13})_m(OR_{14})_{(3-m)}$,
n may be an integer of 1 to 4,
$M_{12}$ may be indium (In), tin (Sn), antimony (Sb), tellurium (Te), thallium (Tl), lead (Pb), bismuth (Bi), silver (Ag), or polonium (Po),
$R_{13}$ and $R_{14}$ each independently may be a linear, branched, or cyclic $C_1$-$C_{30}$ monovalent hydrocarbon group optionally containing a heteroatom,

m may be an integer of 0 to 3,
$Y_{21}$ may be a polymerizable group;
$L_{21}$ and $L_{24}$ each independently may be a single bond, O, S, C (=O), C (=O)O, OC (=O), C(=O)NH, NHC(=O), a linear, branched, or cyclic $C_1$-$C_{30}$ divalent hydrocarbon group optionally containing a heteroatom, or a combination thereof,
a21 and a24 each independently may be an integer of 1 to 4,
$A_{21}$ may be a $C_1$-$C_{30}$ aryl group or a $C_1$-$C_{30}$ heteroaryl group,
$R_{22}$ may be hydrogen, deuterium, a halogen, or a linear, branched, or cyclic $C_1$-$C_{30}$ monovalent hydrocarbon group optionally containing a heteroatom,
b22 may bean integer of 1 to 10;
p may be an integer of 1 to 5; and
$X_{21}$ may be a reactive group.

According to an example embodiment, a pattern forming method may include applying any one of the above-described resist compositions to form a resist film on a substrate; exposing at least a portion of the resist film with high-energy rays to provide an exposed resist film; and developing the exposed resist film by using a developing solution.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a flowchart showing a pattern forming method according to an embodiment.
FIGS. 2A, 2B, and 2Care side-sectional views showing a pattern forming method according to an embodiment.
FIGS. 3A to 3D are $^1$H-NMR and 119Sn-NMR spectrums of FB and T1.
FIGS. 4A to 4J are each a view showing change of film thickness after being developed according to a dose of Comparative Examples 1 and 2, and Examples 1 to 11.
FIGS. 5A to 5E are side cross-sectional views illustrating a method of forming a patterned structure according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.
When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.
The disclosure may have various modifications and may be embodied in different forms, and particular embodiments will be explained in detail with reference to the accompany drawings. It should be understood, however, that it is not intended to limit the disclosure to the particular forms disclosed, but rather, is intended to include all modifications, equivalents, and alternatives falling within the scope of the claims. In describing the disclosure, detailed descriptions of related art may be omitted when it is determined that such detailed descriptions would obscure the gist of the disclosure.
Although the terms "first," "second," "third", and the like may be used herein to describe various elements, these terms are only used to distinguish one element from another element. The order, type and the like of the elements should not be limited by these terms.
In the description, when a layer, a film, a region, a plate, etc., is referred to as being "on" or "above" another

part, it can be not only directly on, below, left, or right in contact, but also include being above, under, left, or right without contact.

The singular forms include the plural forms as well unless the context clearly indicates otherwise. It will be understood that the term "includes" or "comprises", when used in this specification, unless specifically noted to the contrary, specifies the presence of stated features, integers, steps, operations, elements, parts, components, materials, or a combination thereof, but does not preclude the presence or addition of one or more other features, integers, steps, operations, elements, parts, components, materials, or combinations thereof.

Whenever a range of values is enumerated, the range includes all values that fall within the range, as explicitly written, and additionally includes the boundaries of the range. Accordingly, the range " X to Y" includes all values between X and Y, and also includes X and Y.

As used herein, the term "$C_x$-$C_y$" means that a number of carbon atoms forming a substituent is x to y. For example, "$C_1$-$C_6$" means that a number of carbon atoms forming a substituent is 1 to 6, and "$C_6$-$C_{20}$" means that a number of carbon atoms forming a substituent is 6 to 20.

As used herein, a "monovalent hydrocarbon group" may mean a monovalent residue derived from an organic compound including carbon and hydrogen or a derivative thereof. Specific examples thereof may include: a linear, or branched alkyl group (for example, a methyl group, an ethyl group, a prophyl group, an isopropyl group, a butyl group, a sec-butyl group, a tert-butyl group, a pentyl group, a neopentyl group, a hexyl group, a heptyl group, a 2-ethylhexyl group, and a nonyl group); a monovalent saturated cyclic aliphatic hydrocarbon group (a cycloalkyl group)(for example, a cyclopentyl group, a cyclohexyl group, a cyclopentylmethyl group, a cyclopentylethyl group, a cyclopentylbutyl group, a cyclohexylmethyl group, a cyclohexylethyl group, a cyclohexylbutyl group, a 1-adamantyl group, a 2-adamantyl group, a 1-adamantylmethyl group, a norbornyl group, a norbornylmethyl group, a tricyclodecanyl group, a tetracyclodecanyl group, a tetracyclodecanylmethyl group, and a dicyclohexylmethyl group); a monovalent unsaturated aliphatic hydrocarbon (an alkenyl group, an alkynyl group) (for example, an allyl group); a monovalent unsaturated cyclic aliphatic hydrocarbon group (a cycloalkenyl group) (for example, a 3-cyclohexenyl group); an aryl group (for example, a phenyl group, a 1-naphthyl group, and a 2-naphthyl group); an arylalkyl group (for example, a benzyl group and a diphenylmethyl group); a monovalent hydrocarbon group containing a heteroatom (for example, a tetrahydrofuranyl group, a methoxymethyl group, an ethoxymethyl group, a methylthiomethyl group, a methylacetamid group, a trifluoroethyl group, a (2-methoxyethoxy)methyl group, an acetoxymethyl group, a 2-carboxy-1-cyclohexyl group, a 2-oxopropyl group, a 4-oxo-1-adamantyl group, and a 3-oxocyclohexyl group), or any combination thereof, etc. In addition, in these groups, since some hydrogens may be substituted with a moiety containing a heteroatom, for example an oxygen atom, a sulfur atom, a nitrogen atom, or a halogen atom, or some carbons may be substituted with a moiety containing a heteroatom, for example, oxygen, sulfur, or nitrogen. Therefore, these groups may contain a hydroxy group, a cyano group, a carbonyl group, a carboxyl group, an ether bond, an ester bond, a sulfonate ester bond, a carbonate, a lactone ring, a sultone ring, a carboxylic anhydride moiety, or a haloalkyl moiety.

As used herein, a "divalent hydrocarbon group" may be a divalent residue, and may mean that one of hydrogens of the monovalent hydrocarbon group has been replaced by a bonding site with a neighboring atom. The divalent hydrocarbon may include, for example, a linear or branched alkylene group, a cycloalkylene group, an akenylene group, an alkynylene group, a cycloalkylene group, an arylene group, or any group in which some carbons thereof are substituted by a heteroatom.

As used herein, an "alkyl group" means a linear or branched monovalent saturated aliphatic hydrocarbon group, and specific examples of the alkyl group include a methyl group, an ethyl group, a propyl group, an isobutyl group, a sec-butyl group, a ter-butyl group, a pentyl group, an iso-amyl group, a hexyl group, etc. As used herein, an "alkylene group" means a linear, or branched divalent saturated aliphatic hydrocarbon group, and specific examples includes a methylene group, an ethylene group, a propylene group, a butylene group, an isobutylene group, etc.

As used herein, a "halogenated alkyl group" means a group in which at least one of hydrogens of the alkyl group is substituted with a halogen atom, and specific examples thereof include $CF_3$, etc.

As used herein, an "alkoxy group" means a monovalent group having Formula of $-OA_{101}$, wherein $A_{101}$ is the alkyl group. Specific examples thereof include a methoxy group, an ethoxy group, an isopropyl oxide group, etc.

As used herein, an "alkylthio group" means a monovalent group having Formula of $-SA_{101}$, wherein $A_{101}$ is the alkyl group.

As used herein, a "halogenated alkoxy group" means a group in which at least one of hydrogens of the alkoxy group is substituted with a halogen atom, and specific examples include $-OCF_3$.

As used herein, a "halogenated alkylthio group" means a group in which at least one hydrogen of an alkylthio group is substituted with a halogen atom, and specific examples include $-SCF_3$.

As used herein, a "cycloalkyl group" means a cyclic saturated monovalent hydrocarbon group, and specific examples include monocyclic groups such as a cyclopropyl group, a cyclobutyl group, a cyclopentyl group, a cyclohexyl group, and a cycloheptyl group, and a fused polycyclic groups such as a norbornyl group and an adamantyl group. As used herein, a "cycloalkylene group" means a cyclic divalent saturated hydrocarbon group, and specific examples include

a cyclopentylene group, a cyclohexylene group, an adamantylene group, an adamantylmethylene group, a norbornylene group, a norbornylmethylene group, a tricyclodecanylene group, a tetracyclododecanylene group, a tetracyclododecanylmethylene group, a dicyclohexylmethylene group, etc.

As used herein, a "cycloalkoxy group" means a monovalent group having Formula of $-OA_{102}$, wherein $A_{102}$ is the cycloalkyl group. Specific examples of the cycloalkoxy group include a cyclopropoxy group, a cyclobutoxy group, etc.

As used herein, a "cycloalkylthio group" means a monovalent group having Formula of $-SA_{102}$, wherein $A_{102}$ is the cycloalkyl group.

As used herein, in a "heterocycloalkyl group", some carbon atoms of the cycloalkyl group may be substituted by a moiety containing a heteroatom, for example, oxygen, sulfur, or nitrogen, and specifically, the heterocycloalkyl group, may contain an ether bond, an ester bond, a sulfonate ester bond, a carbonate, a lactone ring, a sultone ring, or a carboxylic acid anhydride moiety. As used herein, in a "heterocycloalkylene group", some carbon atoms of the cycloalkylene group are substituted by a moiety containing heteroatom, for example, oxygen, sulfur, or nitrogen.

As used herein, a "heterocycloalkoxy group" means a monovalent group having Formula of $-OA_{103}$, wherein $A_{103}$ is the heterocycloalkyl group.

As used herein, an "alkenyl group" means a linear, or branched unsaturated aliphatic monovalent hydrocarbon group containing at least one carbon-carbon double bond. As used herein, an "alkenylene group" means a linear, branched unsaturated aliphatic divalent hydrocarbon group containing at least one carbon-carbon double bond.

As used herein, an "alkenyloxy group" means a monovalent group having Formula of $-OA_{104}$, wherein $A_{104}$ is the alkenyl group.

As used herein, a "cycloalkynyl group" means a cyclic monovalent unsaturated hydrocarbon group containing at least one carbon-carbon double bond. As used herein, a "cycloalkenylene group" means a cyclic unsaturated divalent hydrocarbon group containing at least one carbon-carbon double bond.

As used herein, a "cycloalkenyloxy group" means a monovalent group having Formula of $-OA_{105}$, wherein $A_{105}$ is the cycloalkenyl group.

As used herein, in a "heterocycloalkenyl group", some carbon atoms of the cycloalkenylene group are substituted by a moiety containing a heteroatom, for example, oxygen, sulfur, or nitrogen. As used herein, in a "heterocycloalkenylene group", some carbon atoms of the cycloalkenylene group are substituted by a moiety containing a heteroatom, for example, oxygen, sulfur, or nitrogen.

As used herein, a "heterocycloalkenyloxy group" means a monovalent group having Formula of $-OA_{106}$, wherein $A_{106}$ is the heterocycloalkenyl group.

As used herein, an "alkynyl group" means an unsaturated aliphatic monovalent hydrocarbon group containing at least one of carbon-carbon triple bond.

As used herein, an "alkynyloxy group" means a monovalent group having Formula of $-OA_{107}$, wherein $A_{107}$ is the alkynyl group.

As used herein, an "aryl group" means a monovalent group having a carbocyclic aromatic system, and specific examples of the aryl group include a cyclopentadiene group, a phenyl group, a naphthyl group, an anthracenyl group, a phenanthrenyl group, a pyrenyl group, a chrysenyl group, etc.

As used herein, an "aryloxy group" means a monovalent group having Formula of $-OA_{108}$, wherein $A_{108}$ is the aryl group.

As used herein, a "heteroaryl group" means a monovalent group having a heterocyclic aromatic system, and specific examples of the heteroaryl group include a pyridinyl group, a pyrimidinyl group, a pyrazinyl group, a pyrrole group, a furan group, a thiophene group, an imidazole group, an oxazole group, a thiazole group, a pyridine group, a pyrazine group, and a triazine group, etc. As used herein, a "heteroarylene group" means a divalent group having a heterocyclic aromatic system.

As used herein, a "heteroaryloxy group" means a monovalent group having Formula of $-OA_{109}$, wherein $A_{109}$ is the heteroaryl group.

As used herein, a "substituent" includes: deuterium, halogen, a hydroxyl group, a cyano group, a nitro group, a carbonyl group, a carboxylic acid group, an amino group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group , a $C_1$-$C_{20}$ heteroaryl group, a $C_1$-$C_{20}$ heteroaryloxy group, or a $C_1$-$C_{20}$ heteroarylthio group;

a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group , a $C_1$-$C_{20}$ heteroaryl group, a $C_1$-$C_{20}$ heteroaryloxy group, or a $C_1$-$C_{20}$ heteroarylthio group, substituted with deuterium, halogen, a hydroxyl group, a cyano group, a nitro group, a carbonyl group, a carboxylic acid group, an amino group, an ether moiety, an

ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group, a $C_1$-$C_{20}$ heteroaryl group, a $C_1$-$C_{20}$ heteroaryloxy group, or a $C_1$-$C_{20}$ heteroarylthio group and any combination thereof; and any combination thereof.

Hereinafter, embodiments will be described with reference to the accompanying drawings. In describing with reference to the drawings, the same reference numerals are used for substantially identical or corresponding elements, and duplicate descriptions are omitted herein. In the drawings, the thickness is enlarged to show the different layers and regions clearly. In addition, in the drawings, the thicknesses of some layers and regions may be exaggerated for illustrative purposes. It should be understood that the embodiments described below are only illustrations, and various modifications from these embodiments are possible.

**[Resist composition-including polymer]**

A resist composition according to embodiments includes an organometallic compound represented by Formula 1 and a polymer including a repeating unit represented by Formula 2:

<Formula 1> $M_{11}(R_{11})_n(OR_{12})_{(4-n)}$

<Formula 2>

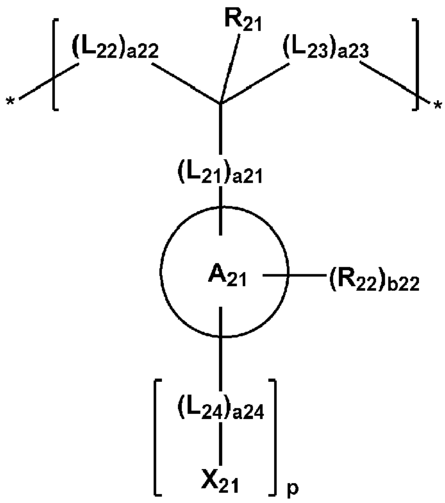

In Formulas 1 and 2,

$M_{11}$ is indium (In), tin (Sn), antimony (Sb), tellurium (Te), thallium (Tl), lead (Pb), bismuth (Bi), silver (Ag), or polonium (Po),

$R_{11}$ is a linear, branched, or cyclic $C_1$-$C_{30}$ monovalent hydrocarbon group optionally containing a heteroatom,

$R_{12}$ is a linear, branched, or cyclic $C_1$-$C_{30}$ monovalent hydrocarbon group optionally containing a heteroatom, or *-$M_{12}(R_{13})_m(OR_{14})_{(3-m)}$,

n is an integer of 1 to 4,

$M_{12}$ is indium (In), tin (Sn), antimony (Sb), tellurium (Te), thallium (Tl), lead (Pb), bismuth (Bi), silver (Ag), or polonium (Po),

$R_{13}$ and $R_{14}$ are each independently a linear, branched, or cyclic $C_1$-$C_{30}$ monovalent hydrocarbon group optionally containing a heteroatom,

m is an integer of 0 to 3,

$L_{21}$ to $L_{24}$ are each independently a single bond, O, S, C (=O), C (=O)O, OC (=O), C(=O)NH, NHC(=O), a linear, branched, or cyclic $C_1$-$C_{30}$ divalent hydrocarbon group optionally containing a heteroatom, or any combination thereof,

a21 to a24 are each independently an integer of 1 to 4,

$A_{21}$ is a $C_1$-$C_{30}$ aryl group or a $C_1$-$C_{30}$ heteroaryl group,

$R_{21}$ and $R_{22}$ are each independently, hydrogen, deuterium, a halogen, or a linear, branched, or cyclic $C_1$-$C_{30}$ monovalent hydrocarbon group optionally containing a heteroatom,
b22 is an integer of 1 to 10;
p is an integer of 1 to 5;
$X_{21}$ is a reactive group that reacts with the organometallic compound; and
* is a bonding site to a neighboring atom.

The organometallic compound may have a molecular weight of about 3000 g/mol or less, and specifically, about 100 g/mol to about 1000 g/mol. The organometallic compound is not a polymer and distinguished from a polymer of which one repeating unit includes a metal.

In Formula 1, a bond between $M_{11}$ and $R_{11}$ may be a $M_{11}$-carbon single bond, and a bond between $M_{12}$ and $R_{13}$ may be a $M_{12}$-carbon single bond. In the organometallic compound, bonding between $M_{11}$ and $R_{12}$ and bonding between $M_{12}$ and $R_{14}$ may be each achieved via an oxygen atom, but $R_{11}$ and $R_{13}$ may be bonded to $M_{11}$ and $M_{12}$, respectively, by the carbon atoms contained in $R_{11}$ and $R_{13}$, respectively.

For example, in Formula 1, $M_{11}$ and $M_{12}$ may be Sn, Sb, Te, Bi, or Ag.

Specifically, in Formula 1, $M_{11}$ and $M_{12}$ may be each independently Sn.

For example, in Formula 1, $M_{11}$ and $M_{12}$ may be the same or different from each other.

Specifically, in Formula 1, $M_{11}$ and $M_{12}$ may be the same.

For example, in Formula 1,

$R_{11}$ and $R_{13}$ may be each independently, represented by $*$-$(L_{11})_{a11}$-$X_{11}$,
$R_{12}$ and $R_{14}$ may be each independently represented by $*$-$(L_{12})_{a12}$-$X_{12}$,
$L_{11}$ and $L_{12}$ may be each independently $CR_aR_b$, C=O, S=O, $SO_2$, $PO_2$, or $PO_3$,
a11 and a12 may be each independently an integer of 0 to 3,
$X_{11}$ and $X_{12}$ may be each independently a substituted or unsubstituted $C_1$-$C_{30}$ alkyl group, a substituted or unsubstituted $C_1$-$C_{30}$ halogenated alkyl group, a substituted or unsubstituted $C_1$-$C_{30}$ alkoxy group, a substituted or unsubstituted $C_1$-$C_{30}$ alkylthio group, a substituted or unsubstituted $C_1$-$C_{30}$ halogenated alkoxy group, a substituted or unsubstituted $C_1$-$C_{30}$ halogenated alkylthio group, a substituted or unsubstituted $C_3$-$C_{30}$ cycloalkyl group, a substituted or unsubstituted $C_3$-$C_{30}$ cycloalkoxy group, a substituted or unsubstituted $C_3$-$C_{30}$ cycloalkylthio group, a substituted or unsubstituted $C_3$-$C_{30}$ heterocycloalkyl group, a substituted or unsubstituted $C_3$-$C_{30}$ heterocycloalkoxy group, a substituted or unsubstituted $C_3$-$C_{30}$ heterocycloalkylthio group, a substituted or unsubstituted $C_2$-$C_{30}$ alkenyl group, a substituted or unsubstituted $C_2$-$C_{30}$ alkenyloxy group, a substituted or unsubstituted $C_2$-$C_{30}$ alkenylthio group, a substituted or unsubstituted $C_3$-$C_{30}$ cycloalkenyl group, a substituted or unsubstituted $C_3$-$C_{30}$ cycloalkenyloxy group, a substituted or unsubstituted $C_3$-$C_{30}$ cycloalkenylthio group, a substituted or unsubstituted $C_3$-$C_{30}$ heterocycloalkenyl group, a substituted or unsubstituted $C_3$-$C_{30}$ heterocycloalkenyloxy group, a substituted or unsubstituted $C_3$-$C_{30}$ heterocycloalkenylthio group, a substituted or unsubstituted $C_2$-$C_{30}$ alkynyl group, a substituted or unsubstituted $C_2$-$C_{30}$ alkynyloxy group, a substituted or unsubstituted $C_2$-$C_{30}$ alkynylthio group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_1$-$C_{30}$ heteroaryl group, a substituted or unsubstituted $C_1$-$C_{30}$ heteroaryloxy group, or a substituted or unsubstituted $C_1$-$C_{30}$ heteroarylthio group,
$R_a$ and $R_b$ may be each independently hydrogen, deuterium, a hydroxyl group, a cyano group, a nitro group, a substituted or unsubstituted $C_1$-$C_{30}$ alkyl group, a substituted or unsubstituted $C_1$-$C_{30}$ alkoxy group, a substituted or unsubstituted $C_1$-$C_{30}$ alkylthio group, a substituted or unsubstituted $C_3$-$C_{30}$ cycloalkyl group, a substituted or unsubstituted $C_3$-$C_{30}$ cycloalkoxy group, or a substituted or unsubstituted $C_3$-$C_{30}$ cycloalkylthio group,
and * may be a bonding site to a neighboring atom.

According to an embodiment, $L_{11}$ may be $CR_aR_b$ or C=O, and $L_{12}$ may be C=O, S=O, $SO_2$, $PO_2$, $PO_3$, or $NO_2$.

According to an embodiment, $X_{11}$ and $X_{12}$ may be each independently a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_6$-$C_{30}$ aryloxy group, a substituted or unsubstituted $C_1$-$C_{30}$ heteroaryl group, or a substituted or unsubstituted $C_1$-$C_{30}$ heteroaryloxy group.

According to an embodiment, $X_{11}$ and $X_{12}$ may be each independently a $C_1$-$C_{20}$ alkyl group which is substituted or unsubstituted by at least one among deuterium, halogen, a hydroxy group, a $C_1$-$C_6$ alkyl group, a $C_1$-$C_6$ halogenated alkyl group, a $C_1$-$C_6$ alkoxy group, a $C_1$-$C_6$ halogenated alkoxy group, a $C_1$-$C_6$ halogenated alkylthio group, a $C_3$-$C_6$ cycloalkyl group, a $C_3$-$C_6$ cycloalkoxy group, a $C_3$-$C_6$ cycloalkylthio group, and a $C_6$-$C_{10}$ aryl group, or a $C_6$-$C_{20}$ aryl group which is substituted or unsubstituted by at least one among deuterium, halogen, a hydroxy group, a $C_1$-$C_6$ alkyl group, a $C_1$-$C_6$ halogenated alkyl group, a $C_1$-$C_6$ alkoxy group, a $C_1$-$C_6$ halogenated alkoxy group, a $C_1$-$C_6$ halogenated alkylthio group, a $C_3$-$C_6$ cycloalkyl group, a $C_3$-$C_6$ cycloalkoxy group, a $C_3$-$C_6$ cycloalkylthio, and a $C_6$-$C_{10}$ aryl group.

According to an embodiment,
$L_{11}$ may be $CR_aR_b$ or C=O,

$L_{12}$ may be C=O, S=O, $SO_2$, $PO_2$, $PO_3$, or $NO_2$,
a11 and a12 may be each independently an integer of 0 or 1, and
$X_{11}$ and $X_{12}$ may be each independently a $C_1$-$C_{20}$ alkyl group which is substituted or unsubstituted with deuterium, halogen, a hydroxy group, a $C_1$-$C_6$ alkyl group, a $C_1$-$C_6$ halogenated alkyl group, a $C_1$-$C_6$ alkoxy group, a $C_1$-$C_6$ halogenated alkoxy group, a $C_1$-$C_6$ halogenated alkylthio group, a $C_3$-$C_6$ cycloalkyl group, a $C_3$-$C_6$ cycloalkoxy group, a $C_3$-$C_6$ cycloalkylthio group, and a $C_6$-$C_{10}$ aryl group, or a $C_6$-$C_{20}$ aryl group which is substituted or unsubstituted with at least one among deuterium, halogen, a hydroxy group, a $C_1$-$C_6$ alkyl group, a $C_1$-$C_6$ halogenated alkyl group, a $C_1$-$C_6$ alkoxy group, a $C_1$-$C_6$ halogenated alkoxy group, a $C_1$-$C_6$ halogenated alkylthio group, a $C_3$-$C_6$ cycloalkyl group, a $C_3$-$C_6$ cycloalkoxy group, a $C_3$-$C_6$ cycloalkylthio group, and a $C_6$-$C_{10}$ aryl group.

Specifically, the organometallic compound may be represented by any one among Formulas 1-1 to 1-16 below:

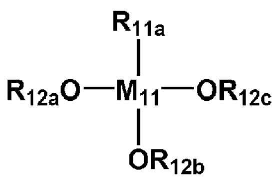
1-1

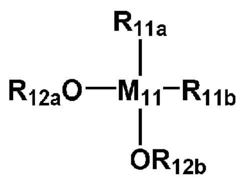
1-2

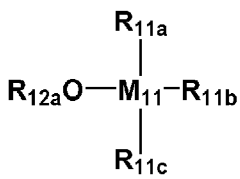
1-3

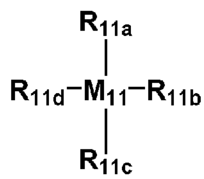
1-4

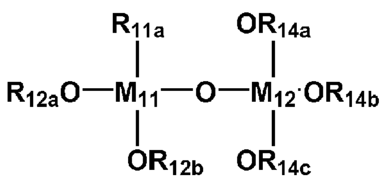
1-5

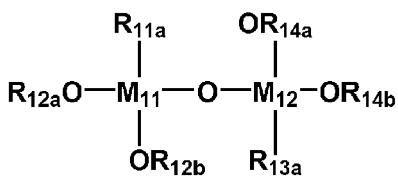
1-6

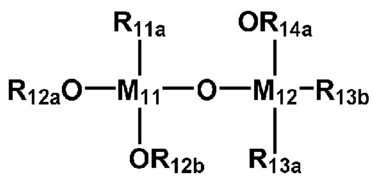
1-7

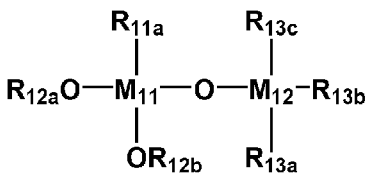
1-8

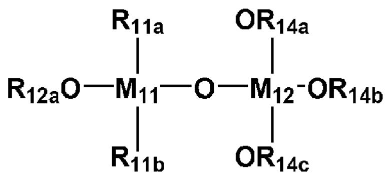
1-9

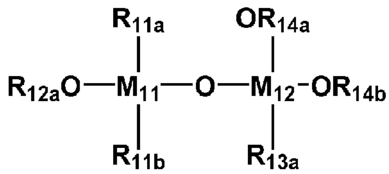
1-10

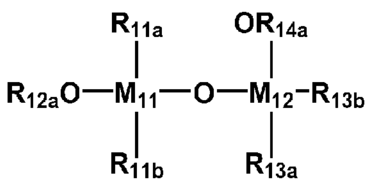
1-11

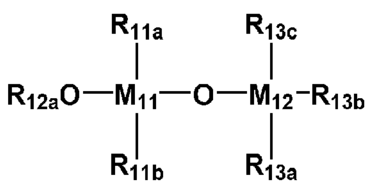
1-12

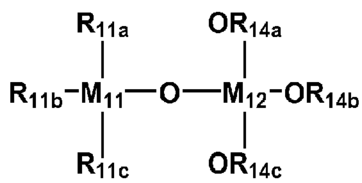
1-13

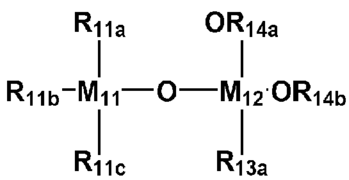
1-14

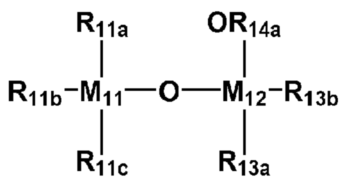
1-15

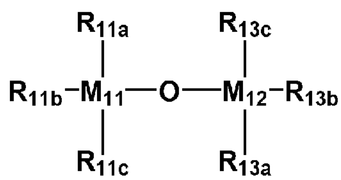
1-16

In Formulas 1-1 to 1-16,

$M_{11}$ and $M_{12}$ may each refer to a definition in Formula 1,
$R_{11a}$ to $R_{11d}$ may refer to a definition of $R_{11}$ in Formula 1,
$R_{12a}$ to $R_{12c}$ may refer to a definition of $R_{12}$ in Formula 1,
$R_{13a}$ to $R_{13c}$ may refer to a definition of $R_{13}$ in Formula 1, and
and $R_{14a}$ to $R_{14c}$ may refer to a definition of $R_{14}$ in Formula 1.

More specifically, the organometallic compound may be represented by any one among Formulas 1-1 to 1-4.

In particular, the organometallic compound may be selected from among group 1.

<Group I>

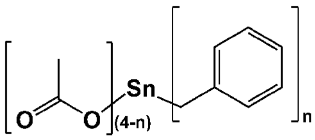 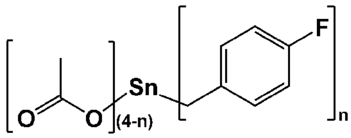 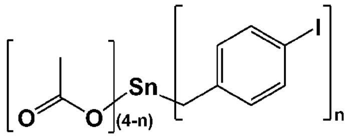

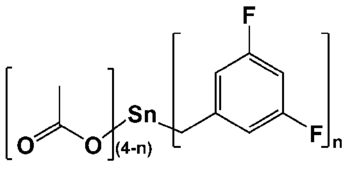 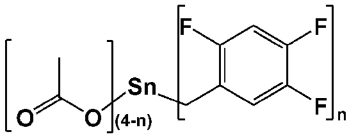 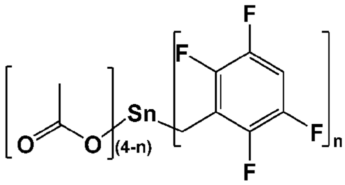

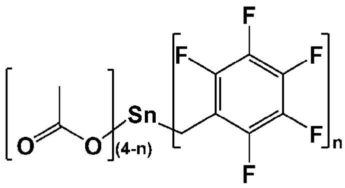 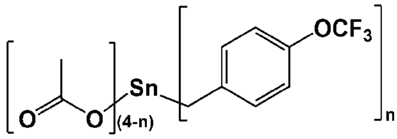 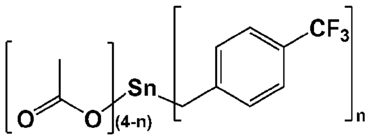

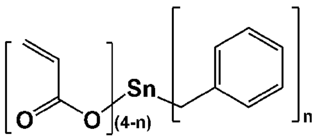 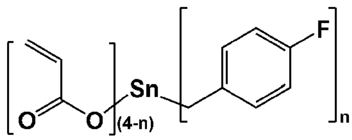 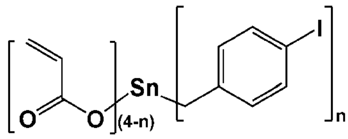

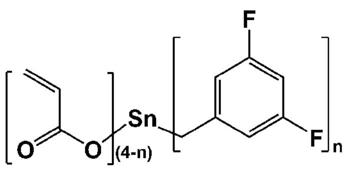 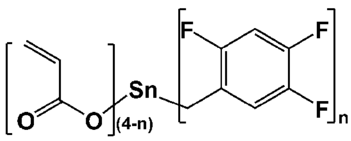 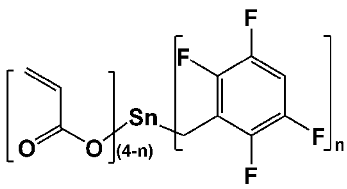

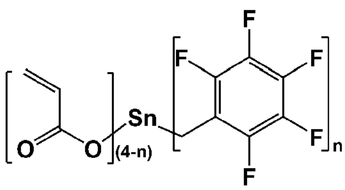 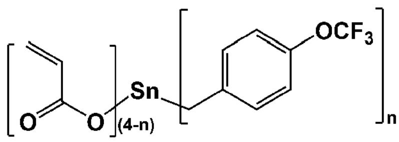 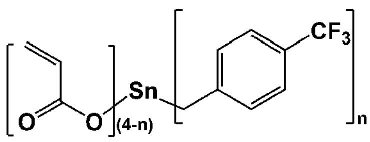

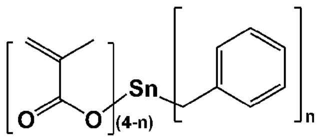 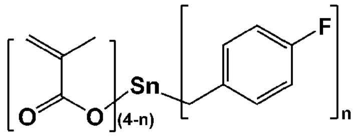 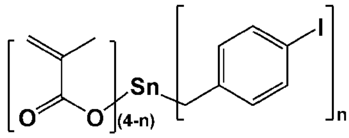

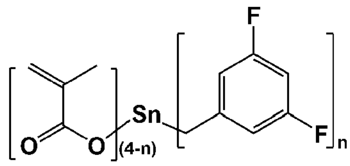 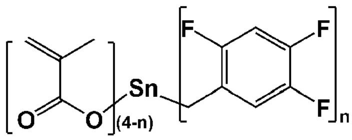 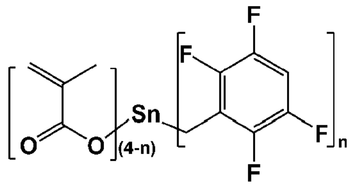

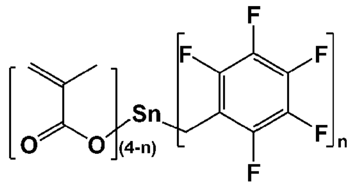 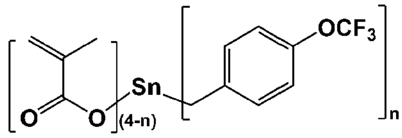 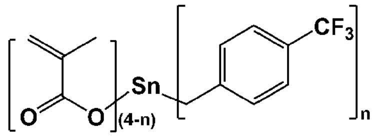

.

In the group I, n may be an integer of 1 to 4.

For example, in group I, n may be 2.

The polymer may include substantially no repeating unit of which structure is changed by acids. Herein, the repeating unit of which structure is changed by acids means a repeating unit including an acid labile group. The acid labile group may be an ester group having a tertiary bicyclic alkyl carbon, an ester group having a tertiary alicyclic carbon, or a cyclic acetal, etc. The acid labile group is desorbed from the polymer by acids, making it easier for the polymer to be dissolved in a developing solution such as a TMAH aqueous solution.

For example, in Formula 2, a21 to a24 may be each independently integers of 1 to 3.

For example, in Formula 2, $L_{21}$ to $L_{24}$ may be each independently a single bond, O, S, C(=O), C(=O)O, OC(=O), C(=O)NH, NHC(=O), a substituted or unsubstituted $C_1$-$C_{30}$ alkylene group, a substituted or unsubstituted $C_3$-$C_{30}$ cycloalkylene group, substituted or unsubstituted $C_1$-$C_{30}$ heterocycloalkylene group, a substituted or unsubstituted phenylene group, a substituted or unsubstituted naphthylene group, or any combination thereof.

For example, in Formula 2, $A_{21}$ may be a benzene group, a naphthalene group, a phenanthrene group, an anthracene group, a chrysene group, a pyrene group, a triphenylene group, a fluorene group, a pyrrole group, a furan group, a thiophene group, an imidazole group, an oxazole group, a thiazole group, a pyridine group, a pyrazine group, a triazine group, a quinoline group, an isoquinoline group, a benzoquinoline group, a quinoxaline group, a quinazoline group, a sinolin group, a phenanthroline group, a phenanthridine group, an indole group, a benzofuran group, a benzothiophene group, a benzimidazole group, a benzoxazole group, a benzothiazole group, a carbazole group, a dibenzofuran group, or a dibenzothiophene group.

Specifically, in Formula 2, $A_{21}$ may be a benzene group, a naphthalene group, a phenanthrene group, an anthracene group, a chrysene group, a pyrene group, a triphenylene group or a fluorene group.

For example, in Formula 2, $R_{21}$ may be hydrogen, deuterium, halogen, $CH_3$, $CH_2F$, $CHF_2$, $CF_3$, $CH_2CH_3$, $CHFCH_3$, $CHFCH_2F$, $CHFCHF_2$, $CHFCF_3$, $CF_2CH_3$, $CF_2CH_2F$, $CF_2CHF_2$, or $CF_2CF_3$.

For example, in Formula 2, $X_{21}$ may be an acidic proton-containing group.

Specifically, in Formula 2, $X_{21}$ may include H linked to N, P, O, or S by a single bond.

More specifically, in Formula 2, $X_{21}$ may include $NHR_{31}$, $PHR_{31}$, OH, SH or any combination thereof, and $R_{31}$ may be hydrogen, deuterium, or a linear, branched, or cyclic $C_1$-$C_{30}$ monovalent hydrocarbon group optionally containing a heteroatom.

Particularly, in Formula 2, $X_{21}$ may be $NHR_{31}$, $PHR_{31}$, OH, SH, $CO_2H$, $SO_3H$, $PO_3H_2$, or $PO(OR_{31})OH$, and $R_{31}$ may be a linear, branched, or cyclic $C_1$-$C_{30}$ monovalent hydrocarbon group optionally containing a heteroatom.

More particularly, in Formula 2, $X_{21}$ may be $NH_2$, $PH_2$, OH, SH, $CO_2H$, $SO_3H$, or $PO_3H_2$.

According to an embodiment, a repeating unit represented by Formula 1 may be selected from among group II.

<Group II>

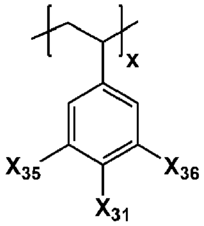
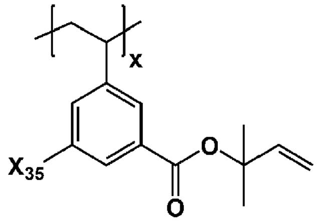
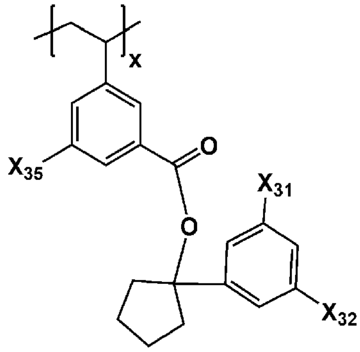
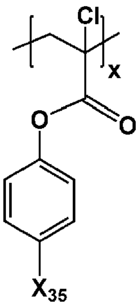

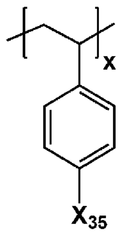
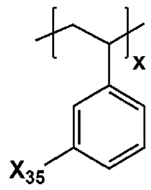
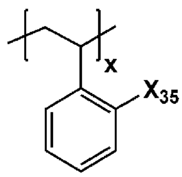

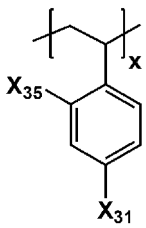
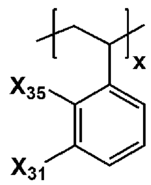
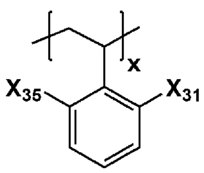
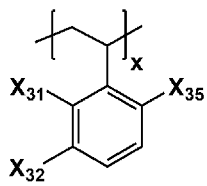

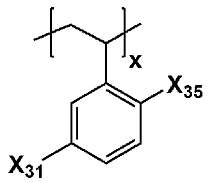
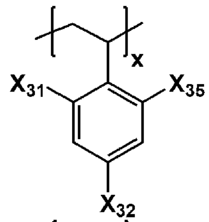
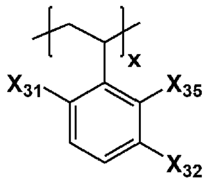
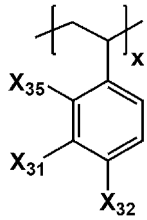

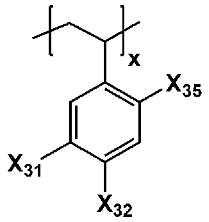
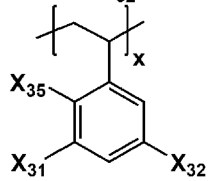
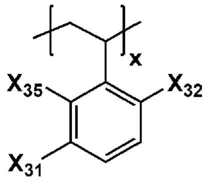
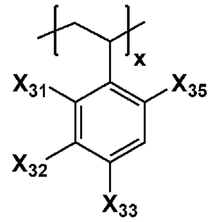

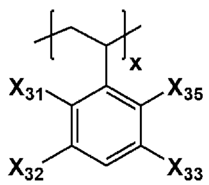
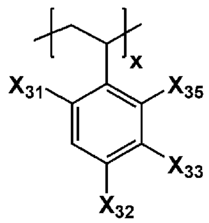
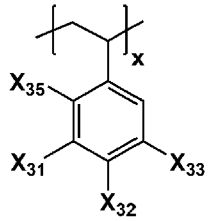
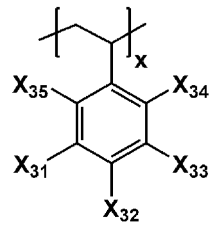

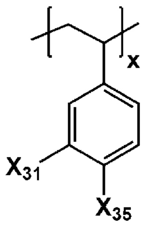 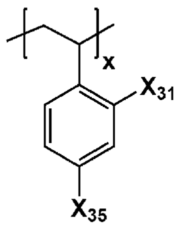 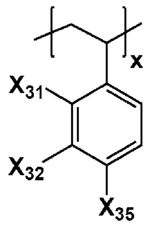 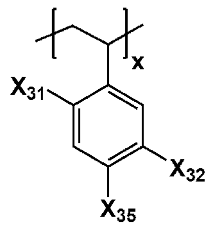

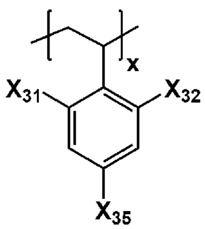 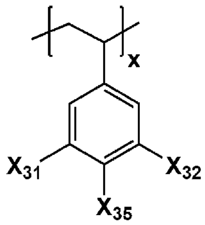 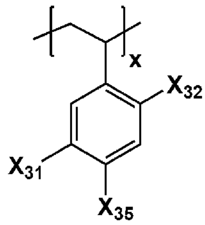 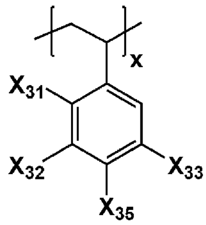

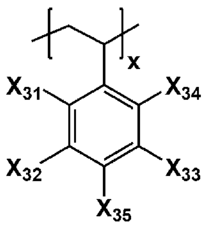

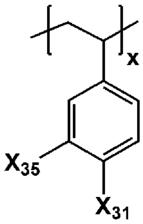
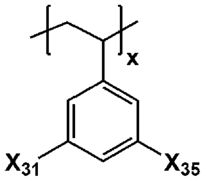
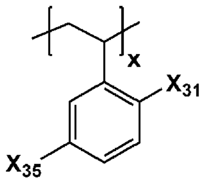
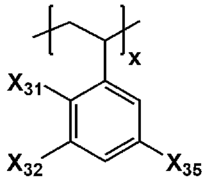

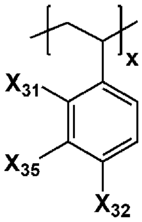
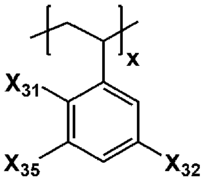
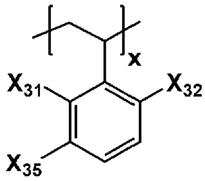
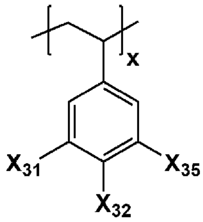

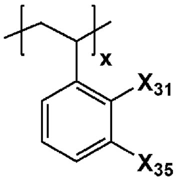
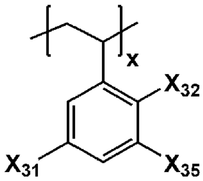
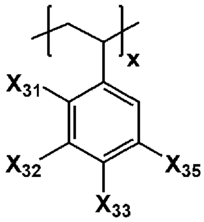
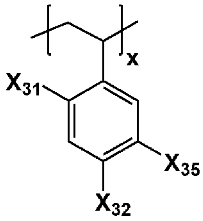

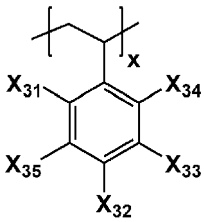
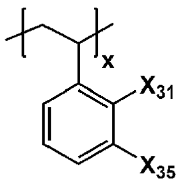
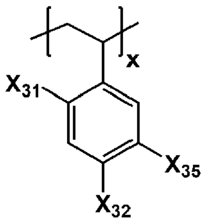

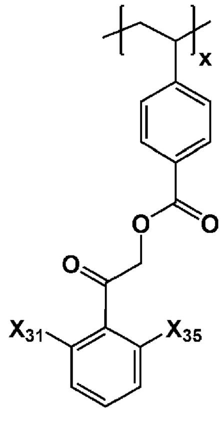
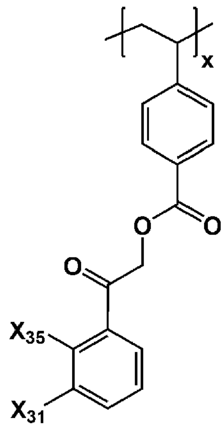
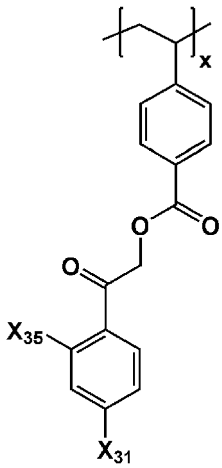
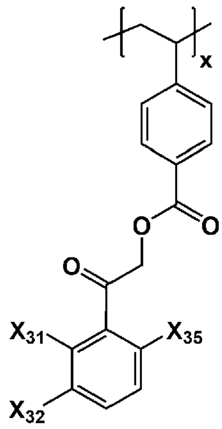
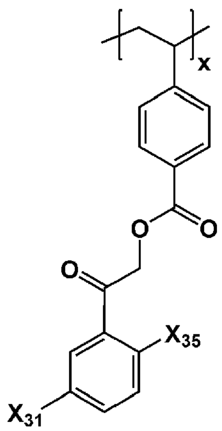
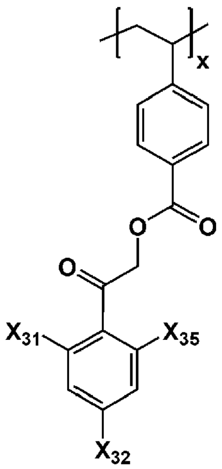
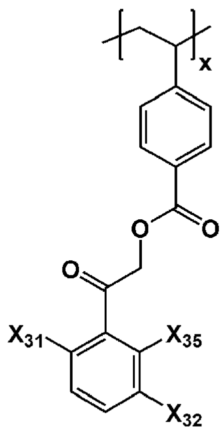
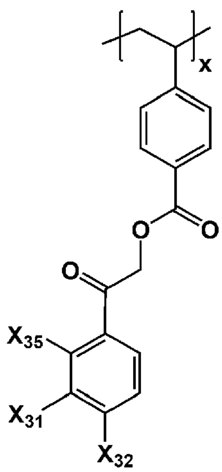

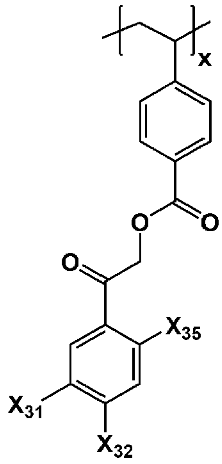
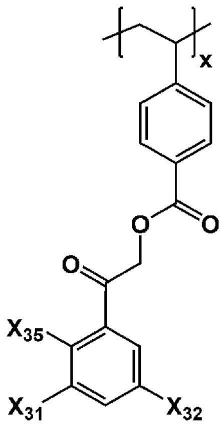
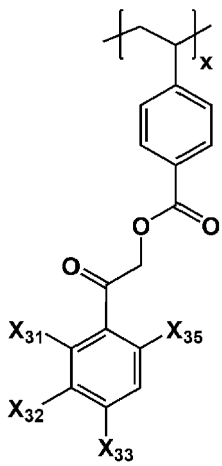
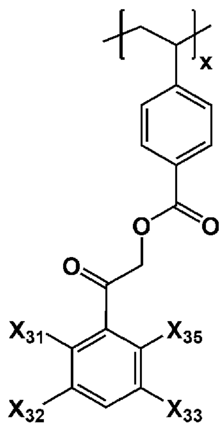

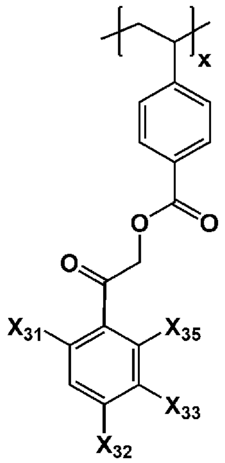
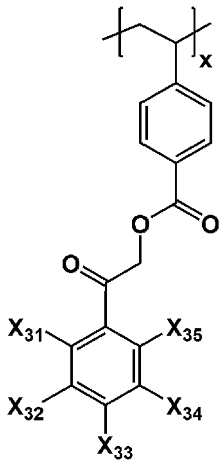

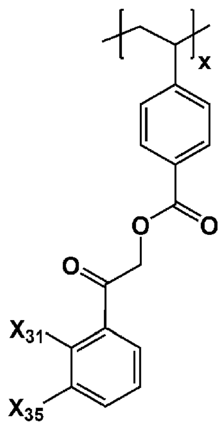
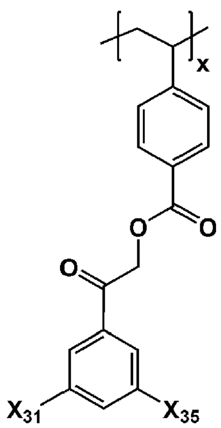
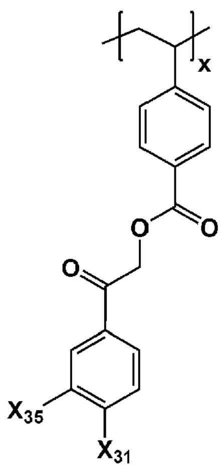
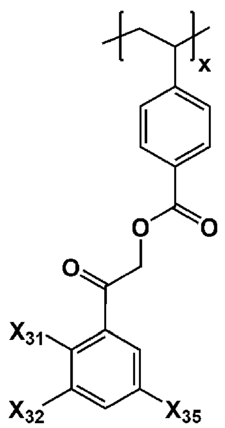

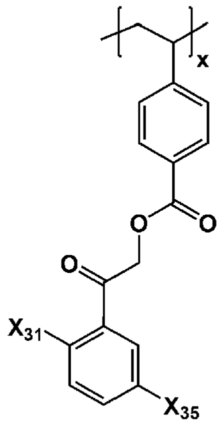
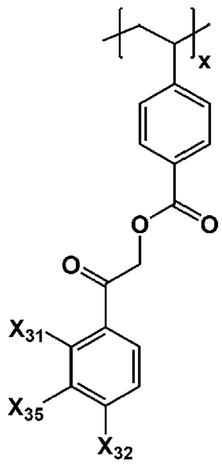
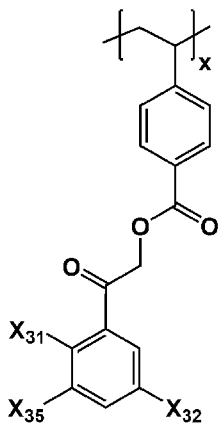
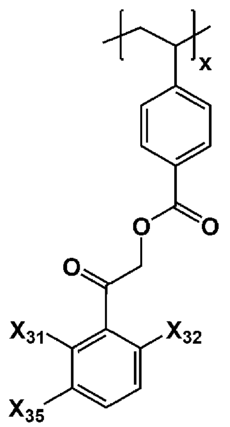

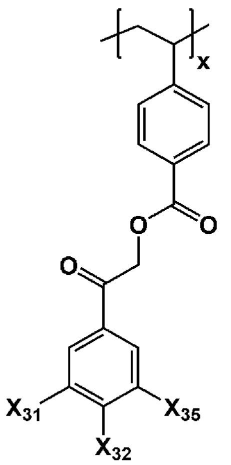

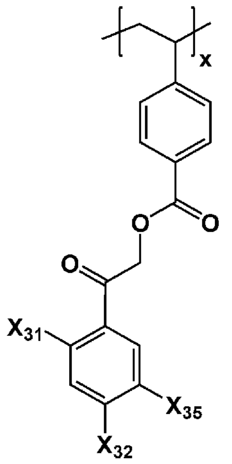

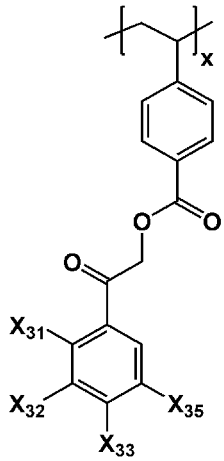

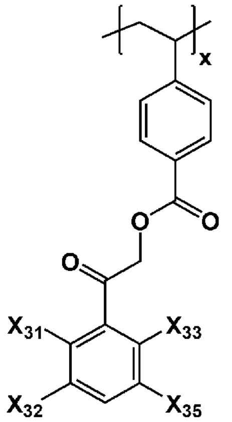

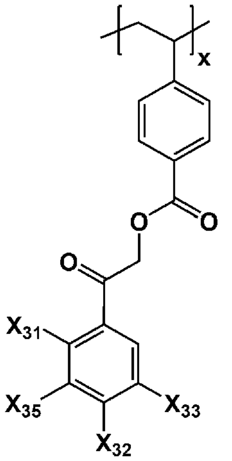

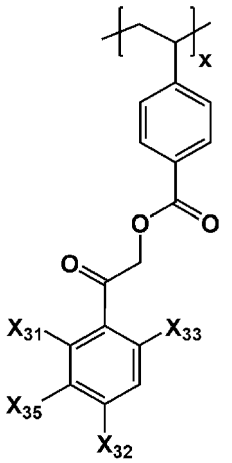

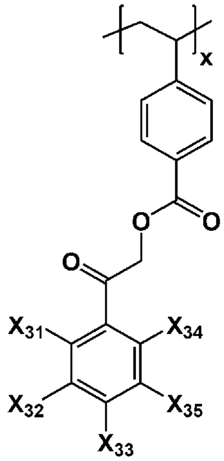

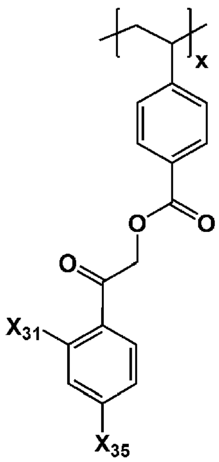
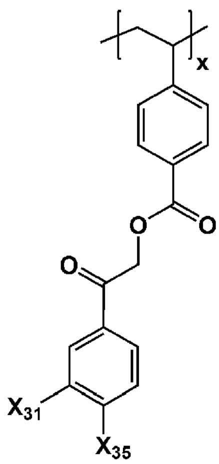
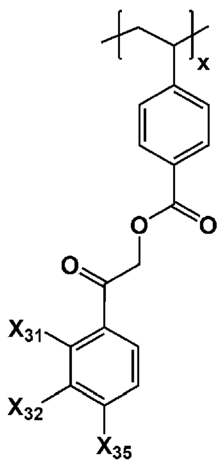
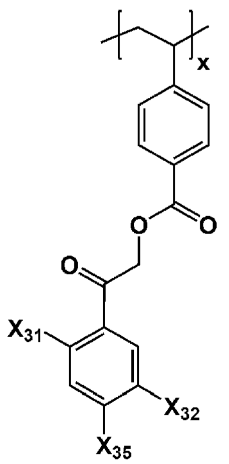
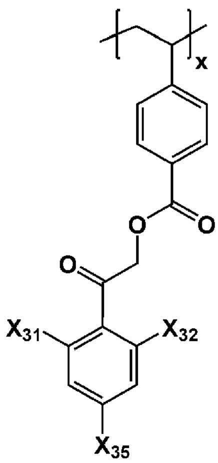
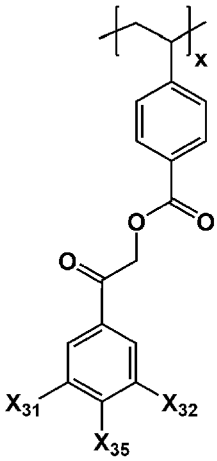
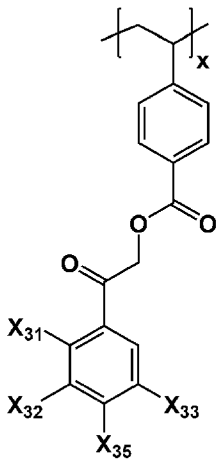
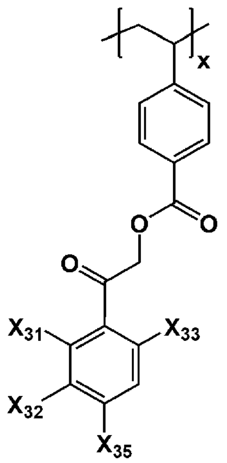
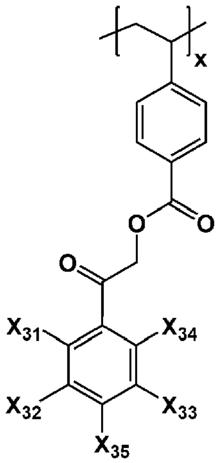
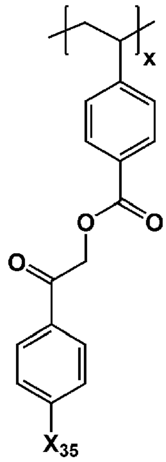
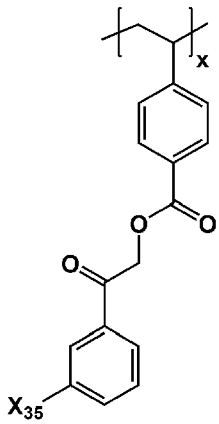
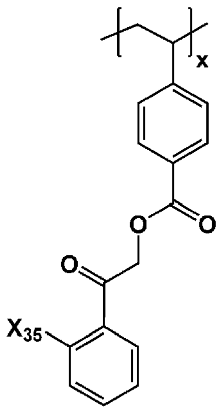
.

In the group II, $X_{31}$ to $X_{34}$ are each independently, F, I, or $CH_3$, and $X_{35}$ and $X_{36}$ are each independently OH or $NH_2$.

According to an embodiment, the polymer may include (or consist of) repeating units represented by Formula 2.

According to another embodiment, the polymer may be a copolymer including a repeating unit represented by Formula 2, for example, a block copolymer, or a random copolymer.

According to another embodiment, the polymer may further include a repeating unit represented by Formula 4:

<Formula 4>

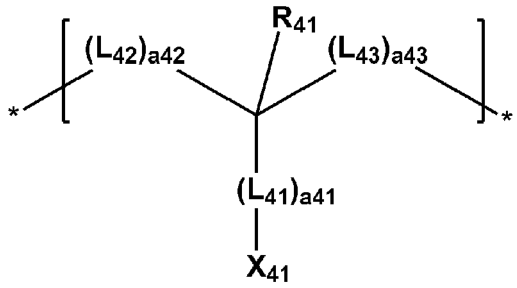

In Formula 4,

$R_{41}$ is hydrogen, deuterium, halogen, or a linear, branched, or cyclic $C_1$-$C_{30}$ monovalent hydrocarbon group optionally containing a heteroatom,
$L_{41}$ to $L_{43}$ are each independently a single bond, O, S, C (=O), C (=O)O, OC (=O), C(=O)NH, NHC(=O), a linear, branched, or cyclic $C_1$-$C_{30}$ divalent hydrocarbon group optionally containing a heteroatom, or any combination thereof,
a41 to a43 are each independently integers of 1 to 6,
$X_{41}$ is a non-acid labile group, and
* is each a bonding site to a neighboring atom.

Specifically, in Formula 4, $R_{41}$ refers to a description of $R_{21}$ in Formula 2.
Specifically, in Formula 4, $R_{41}$ refers to a description of $R_{21}$ in Formula 2.
For example, in Formula 4, $X_{41}$ may be hydrogen or a linear, branched, or cyclic $C_1$-$C_{20}$ monovalent hydrocarbon containing at least one polar moiety selected from among a hydroxy group, halogen, a cyano group, a carbonyl group, a carboxyl group, O, S, C(=O), C(=O)O, OC(=O), S(=O)O, OS(=O), a lactone ring, a sultone ring, and a carboxylic acid anhydride moiety.
Specifically, in Formula 4, $X_{41}$ may be represented by any one among Formulas 5-1 to 5-5:

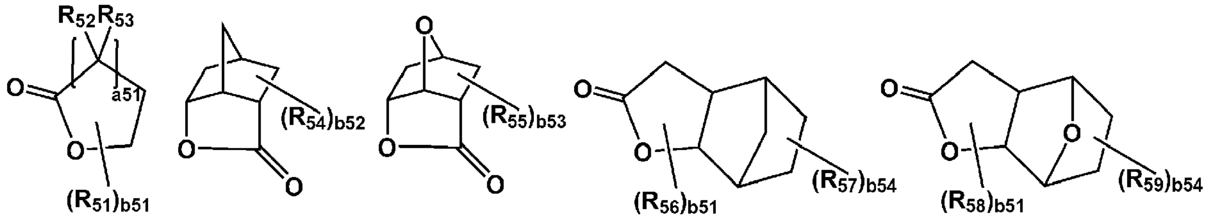

5-1 5-2 5-3 5-4 5-5

..

In Formulas 5-1 to 5-5,

a51 is 1 or 2;
$R_{51}$ to $R_{59}$ are each independently a bonding site to a neighboring atom, hydrogen, a hydroxy group, halogen, a cyano group, a $C_1$-$C_6$ alkyl group, a $C_1$-$C_6$ halogenated alkyl group, a $C_1$-$C_6$ alkoxy group, a $C_3$-$C_6$ cycloalkyl group, a $C_3$-$C_6$ cycloalkoxy group, or a $C_6$-$C_{10}$ aryl group;
one among $R_{51}$ to $R_{53}$, one of $R_{54}$, one of $R_{55}$, one of $R_{56}$ and $R_{57}$, and one among $R_{58}$ and $R_{59}$ are each bonding sites to a neighboring atom,
b51 is an integer of 1 to 4,
b52 is an integer of 1 to 10,
b 53 and b54 are each independently integers of 1 to 8, and
b55 is an integer of 1 to 6.

According to an embodiment, a repeating unit represented by Formula 4 may be represented by any one among

Formulas 4-1 and 4-2.

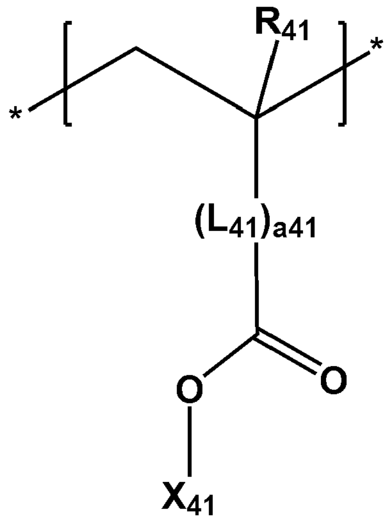

4-1

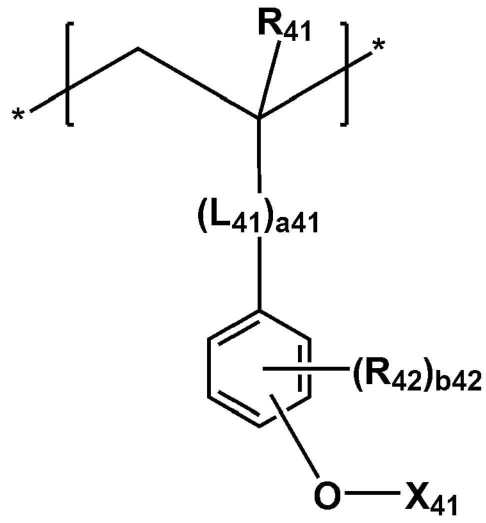

4-2

In Formulas 4-1 and 4-2,

definitions of $L_{41}$ and $X_{41}$ are each the same as those in Formula 4, a41 may be integers of 1 to 4,
$R_{42}$ is hydrogen, a linear, branched or cyclic $C_1$-$C_{20}$ monovalent hydrocarbon group,
b42 is an integer of 1 to 4, and
* is each a bonding site to a neighboring atom.

According to an embodiment, the polymer may include (or consist of) a repeating unit represented by Formula 2 and a repeating unit represented by Formula 4. Specifically, the polymer may include about 1 mol% to about 90 mol% of the repeating unit represented by Formula 4 and about 10 mol% to about 99 mol% of the repeating unit represented by Formula 1. More specifically, the polymer may include about 10 mol% to about 80 mol% of the repeating unit represented by Formula 4, and about 20 mol% to about 90 mol% of the repeating unit represented by Formula 1.

The polymer may include (or consist of) only repeating units having the same structure, and may also include two or more different kinds of repeating units.

The polymer may have an average molecular weight (Mw) of about 1000 to about 500000, specifically, 2000 or more, 3000 or more, 200000 or less, or 100000 or less, as measured by gel permeation chromatography using a tetrahydrofuran solvent and polystyrene as a standard material.

The polymer may have polydispersity index (PDI: Mw/Mn) of about 10.0 to about 6.0, specifically, about 1.0 to about 4.5. When falling within the above-described range, the dispersibility and/or compatibility of the polymer may be easily controlled, the possibility that foreign matter would remain on patterns may be reduced, or deterioration of a pattern profile may be limited and/or minimized. Accordingly, the resist composition may become more suitable for forming fine patterns.

Although not limited to a specific theory, in the organometallic compound, a radical may be formed by heat and/or high-energy rays. In particular, a radical may be formed from a metal-carbon bond of the organometallic compound, and the polymer may receive the radical, thereby forming a chemical bond. Due to the chemical bond, a crosslink may be formed at least between the organometallic compound and the polymer. In addition, the chemical bond may cause changes in physical properties, particularly the solubility of the polymer in a developing agent.

Since the physical properties of the polymer itself may be changed by the organometallic compound and/or high-energy rays, the resist composition may be used in a non-chemical amplified resist composition.

Since the polymer has a relatively high resistance against oxygen and/or moisture, and the physical properties of the polymer may be changed by only high-energy rays, a resist composition having improved storage stability, etc., may be provided.

Since a newly formed chemical bond induces changes in the physical properties of the polymer, it is possible to provide a resist composition capable of patterning even at a lower dose of high-energy rays compared to a system

that induces a change in physical properties by decomposing a main chain of a polymer.

The polymer may be produced by any suitable method. For example, the polymer may be produced by dissolving an unsaturated bond-containing monomer(s) in an organic solvent, followed by photopolymerization and/or thermal polymerization in the presence of a radical initiator.

A structure (a composition) of the polymer can be observed by performing FT-IR analysis, NMR analysis, fluorescence X-ray (XRF) analysis, mass spectrometry, UV analysis, single crystal X-ray structure analysis, powder X-ray diffraction (PXRD) analysis, liquid chromatography (LC) analysis, size exclusion chromatography (SEC) analysis, thermal analysis, etc. The detailed observation method is as described in an embodiment.

When exposed to high-energy rays, the solubility of the resist composition in a developing solution changes. The resist composition may be a negative-type resist composition in which an unexposed portion of a resist film is dissolved and removed to form a negative-type resist pattern.

In addition, a sensitive resist composition according to an embodiment may be used for an alkaline development process using an alkaline developing solution for developing treatment in forming a resist pattern, and may be for a solvent development process using a developing solution containing an organic solvent (hereinafter referred to as an organic developing solution) for developing treatment.

The resist composition is a non-chemically amplified resist composition, and therefore no photoacid generator may be substantially included.

In the resist composition, the polymer changes in physical properties by exposure, and thus substantially no compound having a molecular weight of 1000 or more except for the aforementioned polymer may be included.

In the resist composition, the organometallic compound may be included in an amount of about 10 parts by weight to about 1000 parts by weight, in particular about 20 parts by weight to about 500 parts by weight with respect to 100 parts by weight of the polymer. When falling within the above-mentioned range, a chemical bond between an organometallic compound and a polymer may be sufficiently formed, thereby providing a resist composition having improved sensitivity and/or resolution.

Since the polymer is as described above, an organic solvent and any other components contained as required will be described hereinbelow. Additionally, a polymer used in the resist composition may be used alone, or used in a combination of two or more different kinds of polymers.

<Organic solvent>

The resist composition may further include an organic solvent. The organic solvent contained in the resist composition is not particularly limited as long as it is capable of dissolving or dispersing polymers and any optional components contained as needed. The organic solvent may be used alone, or used in a combination of two or more different types of organic solvents. Additionally, a mixed solvent of water and an organic solvent may be used.

Examples of the organic solvent may include an alcohol-based solvent, an ether-based solvent, a ketone-based solvent, an amide-based solvent, an ester-based solvent, a sulfoxide-based solvent, a hydrocarbon-based solvent, etc.

More specifically, examples of the alcohol-based solvent may include: a monoalcohol-based solvent such as methanol, ethanol, n-propanol, isopropanol, 1-methoxy-2-propanol, 1-ethoxy-2-propanol, n-butanol, isobutanol, sec-butanol, tert-butanol, n-pentanol, isopentanol, 2-methylbutanol, sec-pentanol, tert-pentanol, 3-methoxybutanol, 3-methyl-3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, furfuryl alcohol, phenol, cyclohexanol, methylcyclohexanol, 3,3,5-trimethylcyclohexanol, benzyl alcohol, diacetone alcohol; a polyhydric alcohol-based solvent such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, and tripropylene glycol; a polyhydric alcohol-containing ether-based solvent such as an ethylene glycol monomethyl ether, ethylene glycol monoethyl ether, ethylene glycol monopropyl ether, ethylene glycol monobutyl ether, ethylene glycol monohexylether, ethylene glycol monophenylether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, diethylene glycol dimethyl ether, propylene glycol monomethyl ether, propylene glycol dimethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, etc.

Examples of the ether-based solvent may include: a dialkyl ether-based solvent such as diethyl ether, dipropyl ether, and dibutyl ether; a cyclic ether-based solvent such as tetrahydrofuran and tetrahydropyran; and an aromatic ring-containing ether-based solvent such as diphenyl ether and anisole.

Examples of the ketone-based solvent may include: a chain ketone-based solvent such as acetone, methyl ethyl ketone, methyl-n-propyl ketone, methyl-n-butyl ketone, methyl-n-pentyl ketone, diethyl ketone, methylisobutyl ketone, 2-heptanone, ethyl-n-butyl ketone, methyl-n-hexyl ketone, diisobutyl ketone, trimethyl nonanone; a cyclic ketone-based solvent such as cyclopentanone, cyclohexanone, cycloheptanone, cyclooctanone, methylcyclohexanone; 2,4-phentandion; acetonylaceton, acetphenon, etc.

Examples of the amid-based solvent may include: a cyclic amide-based solvent such as N, N'-dimethyl imidazolidinone and N-methyl-2-pyrrolidone; a chain amide-based solvent such as N-methyl formamide, N, N-dimethyl formamide, N, N-diethyl formamide, acetamide, N-methyl acetamide, N, N-dimethyl acetamide, and N-methyl propionamide.

Examples of the ester-based solvent may include: an acetate ester-based solvent such as methyl acetate, ethyl acetate, n-propyl acetate, isopropyl acetate, n-butyl acetate, isobutyl acetate, sec-butyl acetate, t-butyl acetate, n-pentyl acetate, isopentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, and n-nonyl acetate; a polyhydric alcohol-containing ether carboxylate-based solvent such as ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monopropyl ether acetate, propylene glycol monobutyl ether acetate, dipropylene glycol monomethyl ether acetate, and dipropylene glycol monoethyl ether acetate; a lactone-based solvent such as γ-butyrolactone and δ-valerolactone; a carbonate-based solvent such as dimethyl carbonate, diethyl carbonate, ethylene carbonate, and propylene carbonate; a lactate ester-based solvent such as methyl lactate, ethyl lactate, n-butyl lactate, and n-amyl lactate; glycoldiacetate, methoxytriglycol acetate, ethyl propionate, n-butyl propionate, isoamyl propionate, diethyloxalate, di-n-butyloxalate, methyl acetoacetate, ethyl acetoacetate, diethyl malonate, dimethyl phthalate, diethyl phthalate, etc.

Examples of the sulfoxide-based solvent may include dimethyl sulfoxide, diethyl sulfoxide, etc.

Examples of the hydrocarbon-based solvent may include: an aliphatic hydrocarbon-based solvent such as n-pentane, isopentane, n-hexane, isohexane, n-heptane, isoheptane, 2,2,4-trimethylpentane, n-octane, isooctane, cyclohexane, methylcyclohexane; an aromatic hydrocarbon-based solvent such as benzene, toluene, xylene, mesitylene, ethylbenzene, trimethylbenzene, methylethylbenzene, n-propylbenzene, isopropylbenzene, diethylbenzene, isobutylbenzene, triethylbenzene, diisopropylbenzene, n-amylnaphthalene, etc.

Specifically, the organic solvent may be selected from among an alcohol-based solvent, an amide-based solvent, an ester-based solvent, a sulfoxide-based solvent, and any combination thereof. More specifically, the solvent may be selected from among propylene glycol monomethyl ether, propylene glycol monoethyl ether, propylene glycol monomethyl ether acetate, N-methyl-2-pyrrolidone, N,N-dimethylacetamide, ethyl lactate, dimethyl sulfoxide, and any combination thereof.

The organic solvent may be used in an amount of about 200 parts by weight to about 5000 parts by weight, in particular, about 400 parts by weight to about 3000 parts by weight, with respect to 100 parts by weight of the polymers.

<Optional components>

The resist composition may further include a surfactant, a cross-linker, a leveling agent, a colorant, or any combination thereof, as needed.

The resist composition may further include a surfactant in order to improve the applicability, developability, etc. Specific examples of the surfactant may include, for example, a non-ionic surfactant such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, polyethylene glycol distearate, etc. As the surfactant, a commercially available product or a synthetic product may be used. Examples of the commercially available product of the surfactant may include KP341 (manufactured by Shin-Etsu Chemical Co., Ltd.), Polyflow No.75, Polyflow No.95 (hitherto, manufactured by Kyoeisha Chemical Co., Ltd.), Ftop EF301, Ftop EF303, Ftop EF352 (hitherto, manufactured by Mitsubishi Material Electronics Hwaseong Co., Ltd.), MEGAFACE (registered trademark) F171, MEGAFACE F173, R40, R41, R43 (hitherto, manufactured by DIC Corporation), Fluorad (registered trademark) FC430, Fluorad FC431 (hitherto, manufactured by 3M), AsahiGuard AG710 (manufactured by AGC Corporation), Surflon (registered trademark) S-382, Surflon SC-101, Surflon SC-102, Surflon SC-103, Surflon SC-104, Surflon SC-105, Surflon SC-106 (hitherto, manufactured by AGC Semi Chemical Co., Ltd.), etc.

The surfactant may be included in an amount of about 1 part by weight to about 20 parts by weight with respect to 100 parts by weight of the polymer. The surfactant may be used alone, or used in a mixture of two or more different types of the surfactants.

A preparation method of the resist composition is not particularly limited, and for example, a method of mixing a polymer and optional components added as required, in an organic solvent, may be used. The mixing temperature or time is not particularly limited. Filtration may be performed after mixing as needed.

**[Resist composition-including monomer]**

A resist composition according to embodiments includes: an organometallic compound represented by Formula

1; and a monomer represented by Formula 20:

<Formula 1> $M_{11}(R_{11})_n(OR_{12})_{(4-n)}$

<Formula 20>

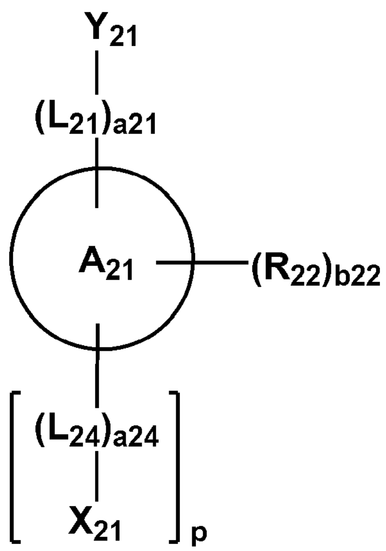

in Formulas 1 and 20,

$M_{11}$ is indium (In), tin (Sn), antimony (Sb), tellurium (Te), thallium (Tl), lead (Pb), bismuth (Bi), silver (Ag), or polonium (Po),
$R_{11}$ is a linear, branched, or cyclic $C_1$-$C_{30}$ monovalent hydrocarbon group optionally containing a heteroatom,
$R_{12}$ is a linear, branched, or cyclic $C_1$-$C_{30}$ monovalent hydrocarbon group optionally containing a heteroatom, or $*-M_{12}(R_{13})_m(OR_{14})_{(3-m)}$,
n is an integer of 1 to 4,
$M_{12}$ is indium (In), tin (Sn), antimony (Sb), tellurium (Te), thallium (Tl), lead (Pb), bismuth (Bi), silver (Ag), or polonium (Po),
$R_{13}$ and $R_{14}$ are each independently a linear, branched, or cyclic $C_1$-$C_{30}$ monovalent hydrocarbon group optionally containing a heteroatom,
m is an integer of 0 to 3,
$Y_{21}$ is a polymerizable group;
$L_{21}$ and $L_{24}$ are each independently a single bond, O, S, C (=O), C (=O)O, OC (=O), C(=O)NH, NHC(=O), a linear, branched, or cyclic $C_1$-$C_{30}$ divalent hydrocarbon group optionally containing a heteroatom, or any combination thereof,
a21 and a24 are each independently an integer of 1 to 4,
$A_{21}$ is a $C_1$-$C_{30}$ aryl group or a $C_1$-$C_{30}$ heteroaryl group,
$R_{22}$ is hydrogen, deuterium, a halogen, or a linear, branched, or cyclic $C_1$-$C_{30}$ monovalent hydrocarbon group optionally containing a heteroatom,
b22 is an integer of 1 to 10;
p is an integer of 1 to 5;
and $X_{21}$ is a reactive group that reacts with an organometallic compound.

For example, in Formula 20, $Y_{21}$ may include, as a partial structure, a vinyl group, an acrylate group, a methacrylate group, an oxirane group, an epoxy group, an oxetane group, a thiol group, or any combination thereof.
Specifically, in Formula 20, $Y_{21}$ may include, as a partial structure, the vinyl group, the acrylate group, the methacrylate group, or any combination thereof.
According to an embodiment, a monomer represented by Formula 20 may be selected from among group III.

<Group III>

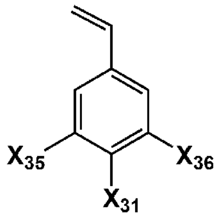
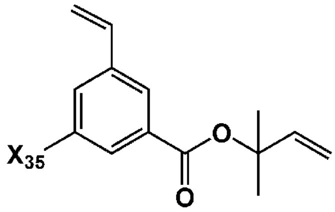
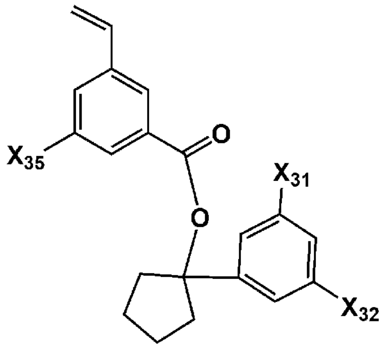
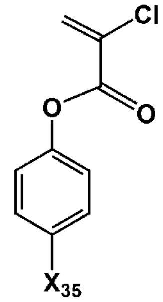

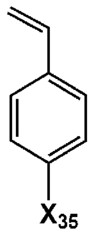
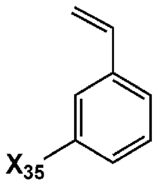
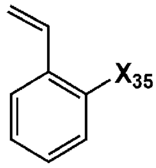

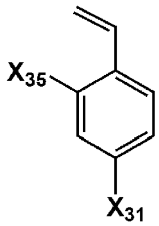
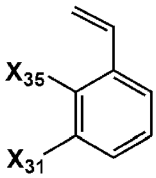
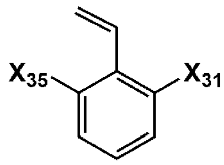
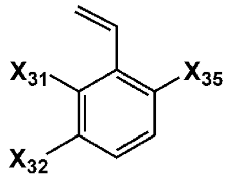

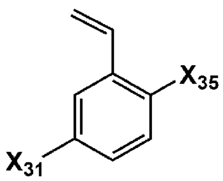
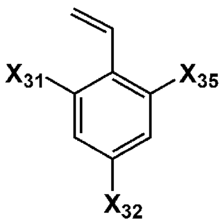
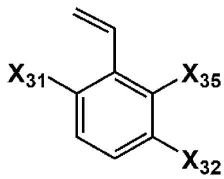
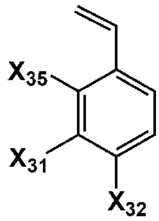

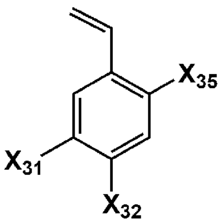
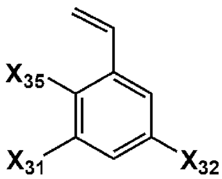
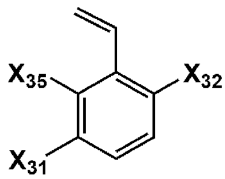
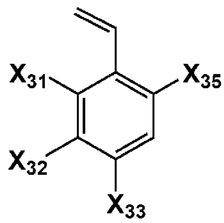

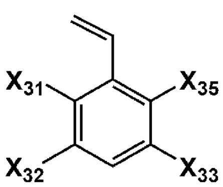
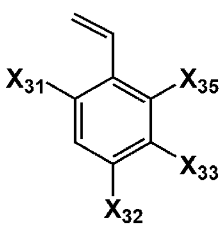
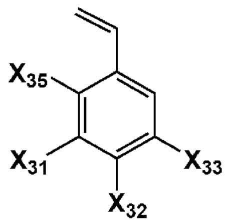
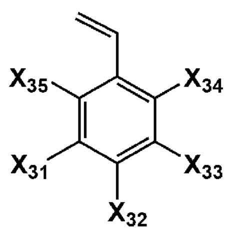

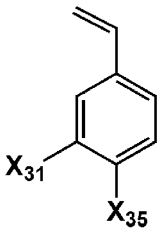
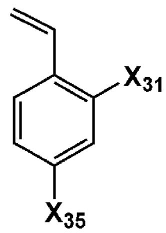
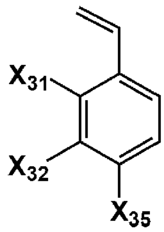
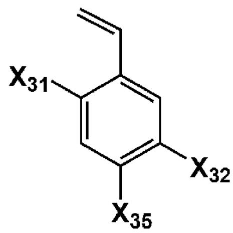
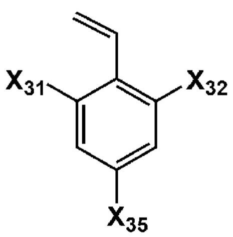
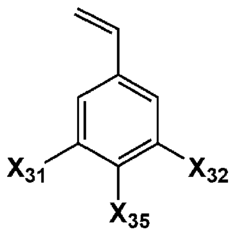
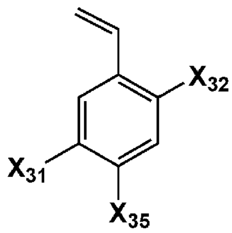
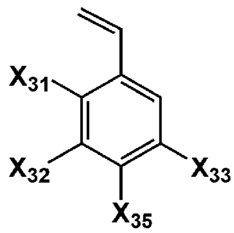
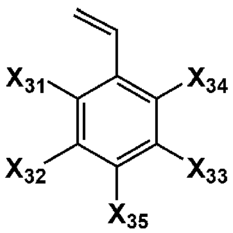

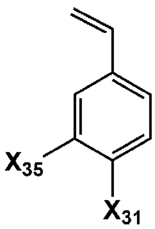
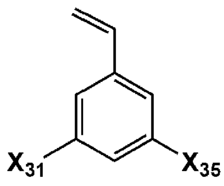
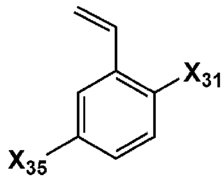
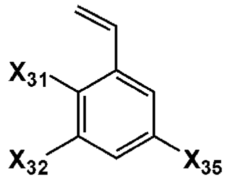

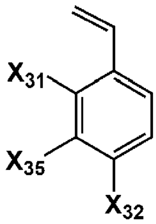
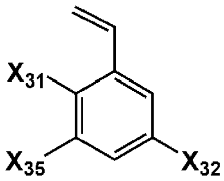
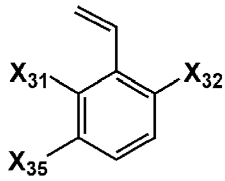
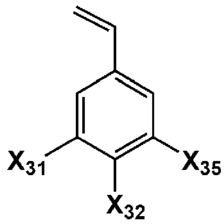

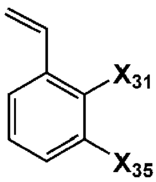
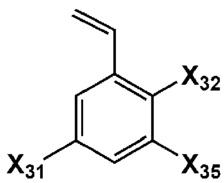
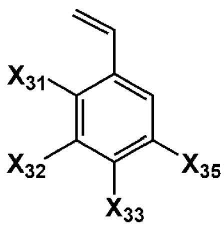
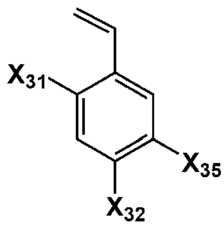

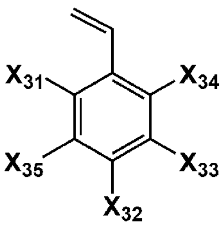
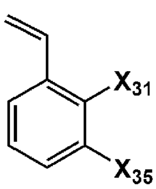
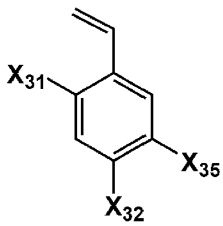

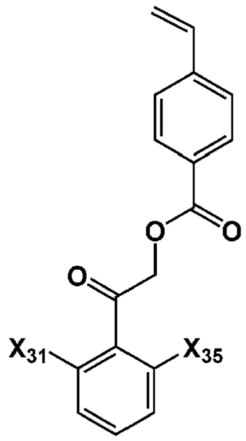
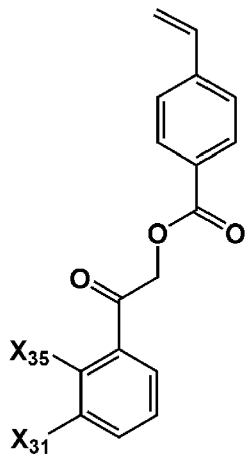
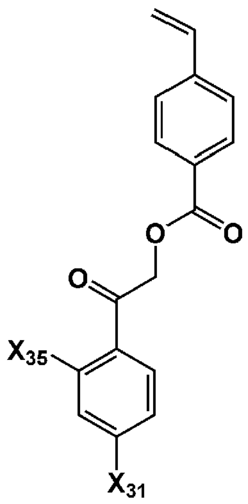
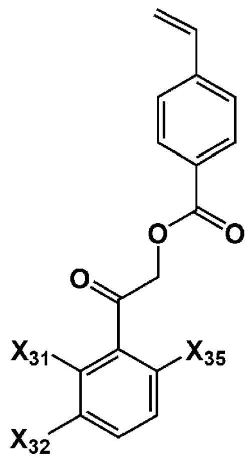

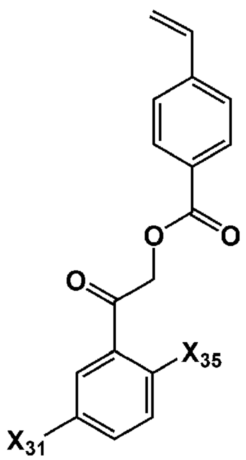
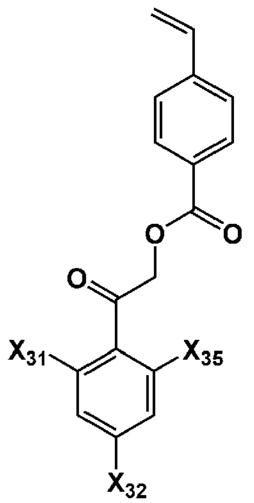
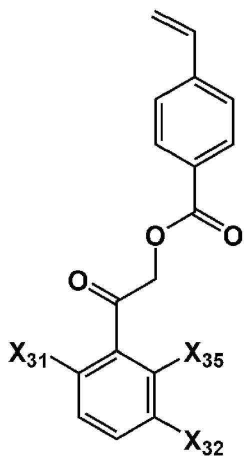
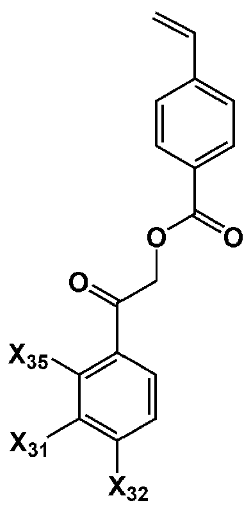

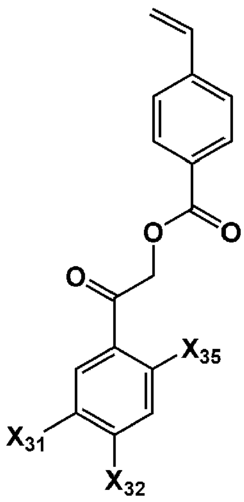

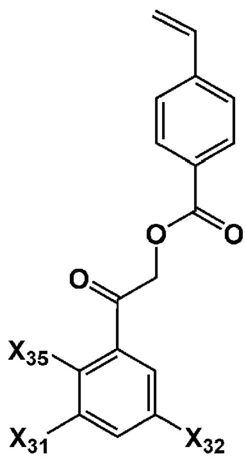

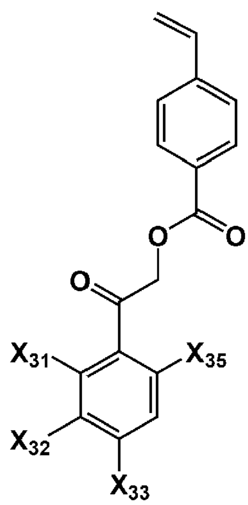

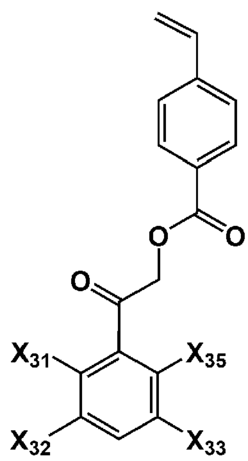

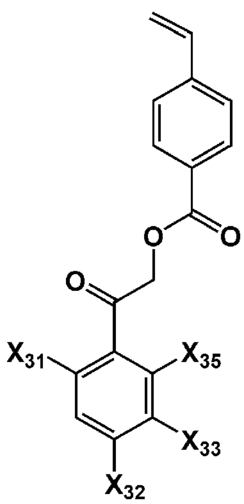

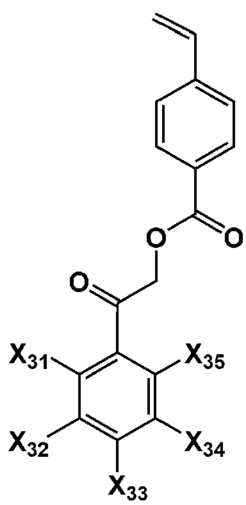

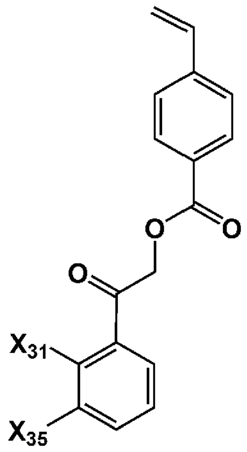
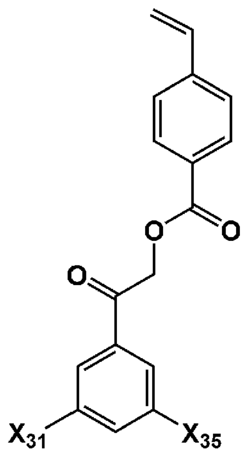
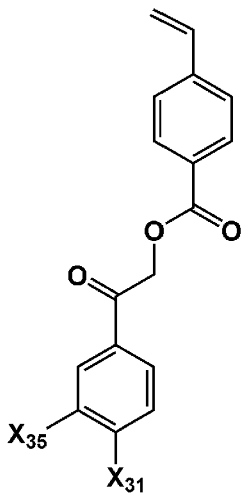
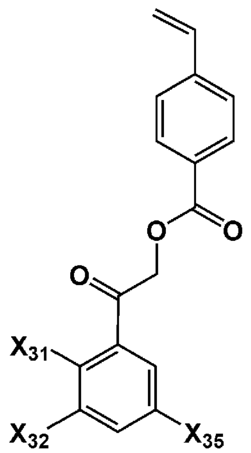

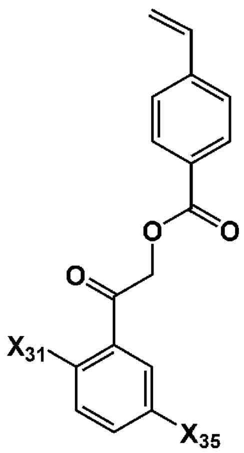
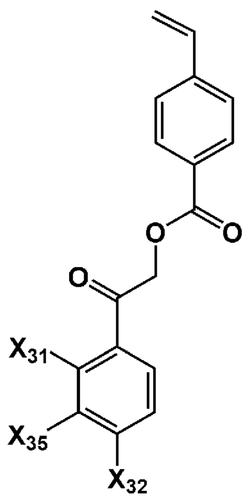
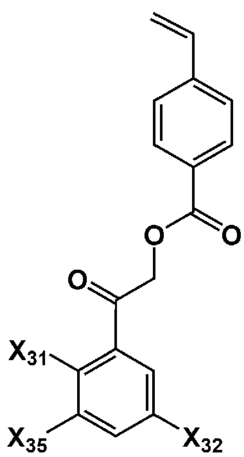
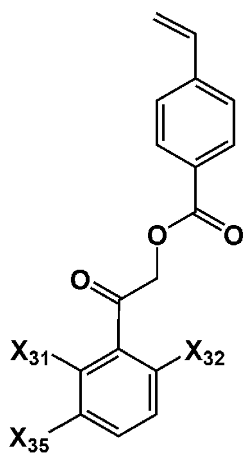

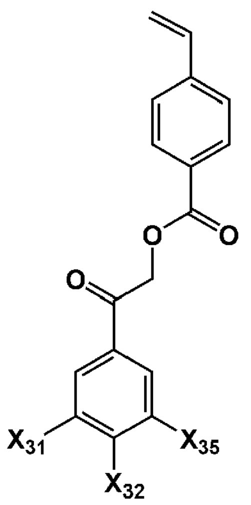

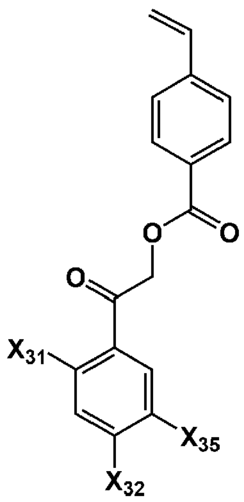

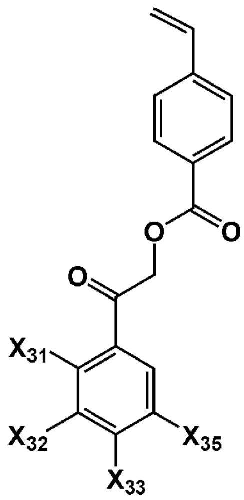

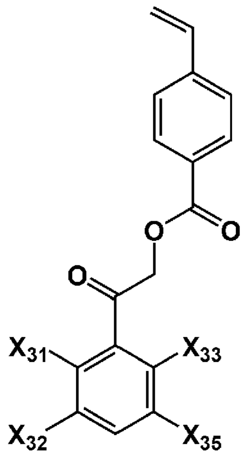

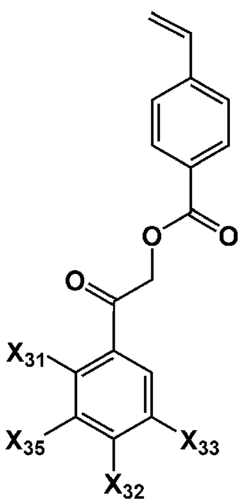

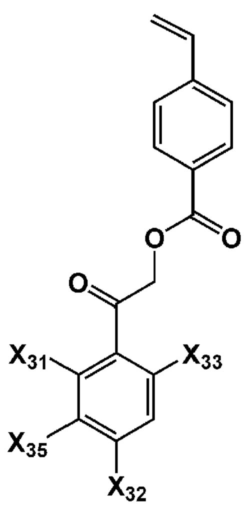

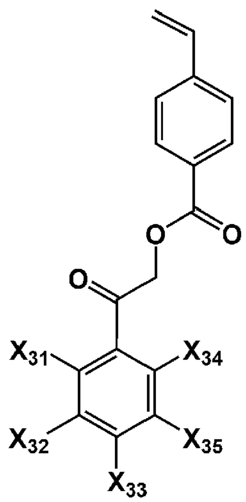

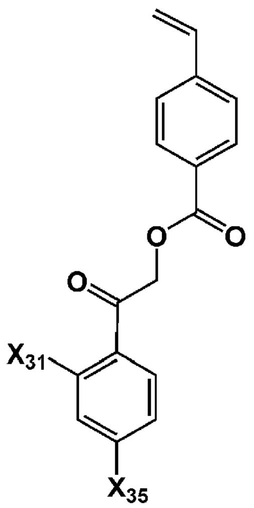
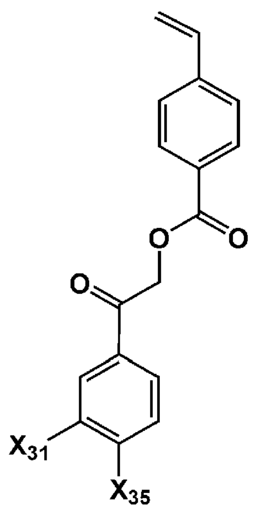
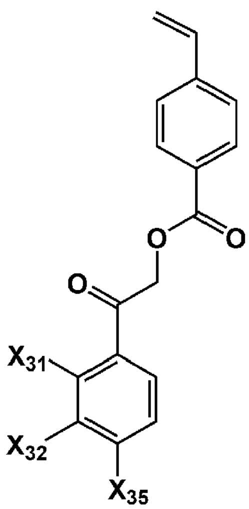
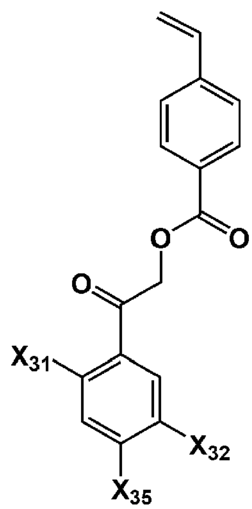
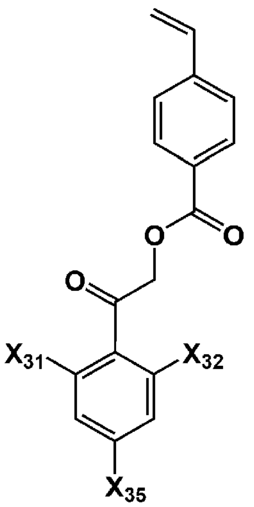
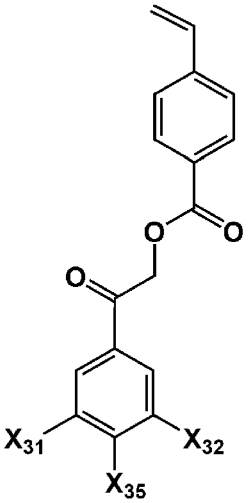
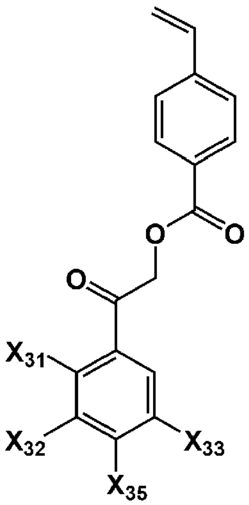
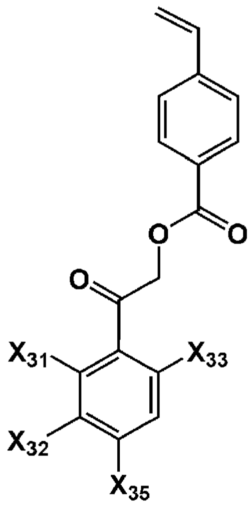
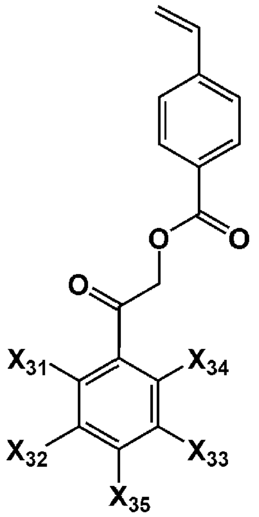
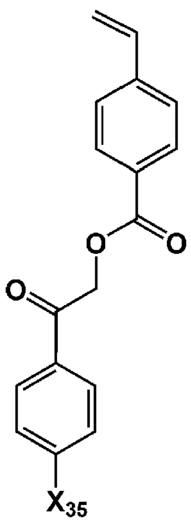
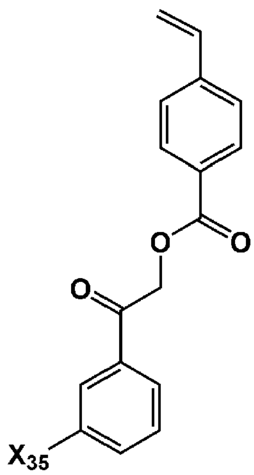
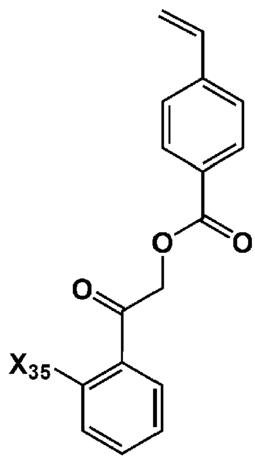

In group III, $X_{31}$ to $X_{34}$ are each independently F, I, or $CH_3$, and $X_{35}$ and $X_{36}$ are each independently OH or $NH_2$.

A resist composition including the monomer may be the same as the resist composition including the aforementioned polymer, except for including the monomer instead of the polymer. Descriptions of the resist composition including the monomer refer to the descriptions of the resist composition including the polymer.

**[Pattern forming method]**

Hereinafter, a pattern forming method according to embodiments will be described in more detail with reference to FIGS. 1 and 2A to 2C. FIG.1 is a flowchart illustrating a pattern forming method according to embodiments, and FIGS. 2A to 2C are side cross-sectional views illustrating a pattern forming method according to embodiments. Hereinafter, a pattern forming method using a negative resist composition will be concretely described as an example, but the pattern forming method is not limited thereto.

Referring to FIG.1, the pattern forming method includes applying a resist composition to form a resist film (S101), exposing at least a portion of the resist film by high-energy rays (S102), and developing an exposed resist film using a developing solution (S103). If necessary, above-mentioned processes may be omitted, or may be performed in a different order.

First a substrate 100 was prepared. Examples of the substrate 100 may include a semiconductor substrate such as a silicon substrate and a germanium substrate, a glass substrate, a quartz substrate, a ceramic substrate, a copper substrate, etc. In embodiments, the substrate 100 may include a III-V group compound such as GaP, GaAs, GaSb.

As shown in FIG. 2A, a resist film 110 may be formed by applying the resist composition through a specific coating method to a desired thickness onto the substrate 100. As needed, a thermal process (referred to as pre-bake (PB) or as post-annealing bake (PAB)) may also be performed to remove an organic solvent remaining on the resist film 110. Alternatively, a radical may be generated by heating the resist film 110, and then, when exposed, a crosslink may be formed by a chemical bond of radicals.

As the coating method, spin coating, dip-coating, roller coating or other general coating methods may be used. Among these methods, particularly, spin coating may be used, and the resist film 110 having a desired thickness may be formed by controlling the viscosity, concentration and/or spin speed of the resist composition. Specifically, the resist film 110 may have a thickness of about 10 nm to about 300 nm. More specifically, the resist film 110 may have a thickness of about 15 nm to about 200 nm.

The lower limit temperature for the post-annealing bake may be at least 60 °C, specifically 80 °C or higher. In addition, the upper limit temperature for the post-annealing bake may be at most 200 °C, specifically 180 °C or less. The lower limit time for the post-annealing bake may be at least 5 seconds or more, specifically 10 seconds or more. The upper limit time for post-annealing bake may be at most 600 seconds, specifically, 300 seconds or less.

Before applying the resist composition on the substrate 100, an etching target film (not shown) may be further formed on the substrate 100. The etching target film may mean a layer on which an image is transferred from a resist pattern and converted to a desired and/or alternatively predetermined pattern. According to an embodiment, the etching target film may be formed to include, for example, an insulating material, such as silicon oxide, silicon nitride, and silicon oxynitride. According to some embodiments, the etching target film may be formed to include a conductive material such as a metal, a metal nitride, a metal silicide, and a metal silicide nitride film. According to some embodiments, the etching target film may be formed to include a semiconducting material such as polysilicon.

According to an embodiment, an antireflection film may be further formed on the substrate 100 in order to improve and/or maximize the efficiency of the resist. The antireflection film may be an organic or inorganic antireflection film.

According to an embodiment, a protective film may be further formed on the resist film 100 to reduce an impact of alkaline impurities included in processes, etc. In addition, when performing a liquid immersion exposure, the protective film for a liquid immersion may be provided, for example, on the resist film 100 to avoid direct contact between a liquid immersion medium and the resist film 100.

Next, at least a portion of the resist film 100 may be exposed to high-energy rays. For example, as shown in FIG. 2B, at least a portion of the resist film 110 may be irradiated with the high-energy rays that have passed through a mask 120. As a result, the resist film 110 may have an exposed portion 111 and an unexposed portion 112.

Although not limited to a specific theory, radicals may be generated from the exposed portion 111 due to exposure, a chemical bond between the radicals may be formed, and thus the physical properties of the resist composition may change.

In some cases, the exposure is performed by using a liquid medium such as water and irradiating high-energy rays through a mask having a desired and/or alternatively predetermined pattern. Examples of the high-energy rays may include: electromagnetic waves, such as ultraviolet rays, far-ultraviolet rays, extreme ultraviolet (EUV, wavelength 13.5 nm) rays, X-rays, and $\gamma$-rays; and charged particle beams such as electron beams (EB) and $\alpha$-particles. An irradiation of the high-energy rays may be collectively referred to as an "exposure".

Examples of various light sources used for an exposure may include: a light source emitting laser light in the ultraviolet range such as KrF excimer laser (wavelength of 248 nm), ArF excimer laser (wavelength of 193 nm), or $F_2$ excimer laser (wavelength of 157 nm); a light source emitting harmonic laser light in the far ultraviolet or vacuum ultraviolet range by converting the wavelength of laser light from a solid-state laser light source (such as YAG or semiconductor laser); and a light source emitting electron beams or extreme ultraviolet (EUV) rays. When exposed, the exposure may

be normally performed through a mask corresponding to a desired pattern. However, when the light source is an electron beam, the exposure may be directly performed by drawing without using the mask.

When extreme ultraviolet lights are used as the high-energy rays, an accumulated dose of high-energy rays may be, for example, 2000 mJ/$cm^2$ or less, specifically 500 mJ/$cm^2$ or less. In addition, when electron beams are used as the high-energy rays, the accumulated dose may be 5000 $\mu$C/$cm^2$ or less, specifically, 1000 $\mu$C/$cm^2$ or less.

Additionally, post exposure bake (PEB) may be performed after the exposure. The lower limit temperature for PEB may be at least 50 °C, specifically 80 °C or more. The upper limit temperature for PEB may be at most 250 °C, specifically 200 °C or less. The lower limit time for PEB may be at least 5 seconds, specifically, 10 seconds or more. The upper limit time for PEB may be at most 600 seconds, specifically, 300 seconds or less.

Next, referring to FIG. 2C, the exposed resist film 110 may be developed by using a developing solution. The unexposed portion 112 may be washed away by the developing solution, the exposed portion 111 may be not washed away by the developing solution and remain.

Examples of the developing solution may include an alkaline developing solution, a developing solution that includes an organic solvent (hereinafter, also referred to as an "organic developing solution"), etc. Examples of a developing method may include a dipping method, a puddle method, a spray method, and a dynamic dosing method. For example, the developing temperature may be about 5 °C to about 60 °C and the developing time may be about 5 seconds to about 300 seconds.

Examples of the alkaline developing solution may include an alkaline aqueous solution in which one or more kinds of alkaline compounds, such as sodium hydroxide, potassium hydroxide, sodium carbonate, sodium silicate, sodium metasilicate, aqueous ammonia, ethylamine, n-propylamine, diethylamine, di-n-propylamine, triethylamine, methyl diethylamine, ethyl dimethylamine, triethanol amine, tetramethyl ammonium hydroxide (TMAH), pyrrole, piperidine, choline, 1,8-diazabicyclo[5.4.0]-7-undecene (DBU), 1,5-diazabicyclo[4.3.0]-5-nonene (DBN), are dissolved. Examples of the alkaline developing solution may further include a surfactant.

A lower limit amount of the alkaline compound in the alkaline developing solution may be at least 0.1 wt%, specifically, 0.5 wt% or more, and more specifically, 1 wt % or more. In addition, the upper limit amount of the alkaline compound in the alkaline developing solution may be at most 20 wt%, specifically, 10 wt% or less, and more specifically, 5 wt% or less.

As the organic solvent included in the organic developing solution, for example, the same organic solvent as those in the <Organic solvent> part of [Resist composition] may be used. Specifically, examples of the organic developing solution may include nBA (n-butyl acetate), PGME (propylene glycol methyl ether), PGMEA (propylene glycol methyl ether acetate), GBL ($\gamma$-butyrolactone), IPA (isopropanol), etc.

A lower limit amount of the organic solvent in the organic developing solution may be at least 80 wt%, specifically, 90 wt% or more, more specifically, 95 wt% or more, and particularly 99 wt% or more.

The organic developing solvent may include a surfactant. In addition, the organic developing solution may include small amount of moisture. Additionally, when developed, developing may be stopped by substituting the organic developing solution by a different type of a solvent.

A resist pattern after developing may be further cleaned. Ultrapure water, a rinse solution, etc., may be used as a cleaning solution. The rinse solution is not particularly limited unless the rinse solution dissolves the resist pattern, a solution including a general organic solvent may be used. For example, the rinse solution may be an alcohol-based solvent or an ester-based solvent. After cleaning, any residual rinse solution on the substrate and the pattern may be removed. In addition, when using ultrapure water, water remaining on the substrate or the pattern may be removed.

Additionally, the developing solution may be used alone or used in combination of two or more.

The resist pattern is formed as described above, and then etched, thereby obtaining a patterned wiring substrate. Etching may be performed through known methods, such as a dry etching method using plasma gas, a wet etching method using an alkaline solution, a copper (II) chloride solution, and an iron (III) chloride solution.

After the resist pattern is formed, plating may be performed. A plating method is not particularly limited, and may include, for example, copper plating, solder plating, nickel plating, gold plating, etc.

A resist pattern remaining after etching may be stripped off with the organic solvent. Examples of the organic solvent may include, although not particularly limited, propylene glycol monomethyl ether acetate (PGMEA), propylene glycol monomethyl ether (PGME), ethyl lactate (EL), etc. Although not particularly limited, examples of a stripping method include an immersion method, a spray method, etc. In addition, the wiring substrate on which the resist pattern is formed may be a multilayer wiring substrate, and may have a small diameter through-hole.

According to an embodiment, the wiring substrate may also be formed by a lift-off method, in which a metal is deposited in a vacuum after forming the resist pattern, and then the resist pattern is dissolved in a solution.

FIGS. 5A to 5E are side cross-sectional views illustrated a method of forming a patterned structure according to an embodiment.

The method in FIGS. 5A to 5E may be the same as the method in FIGS. 2A to 2C, except for the differences described below.

Referring to FIG. 5A, a material layer 130 may be formed on the substrate 100 before forming a resist film 110 on the substrate 100. The resist film 110 may be formed on top of the material layer 130. The material layer 130 may include an insulating material (e.g., silicon oxide, silicon nitride), a semiconductor material (e.g., silicon), a metal (e.g., copper). In some embodiments, the material layer 130 may be a multi-layer structure. A material of the material layer 130 may be different than a material of the substrate 100.
Referring to FIG. 5B, the resist film 110 may be exposed with high energy rays through a mask 120, after which the resist film 110 may include exposed areas 111 and unexposed areas 112.
Referring to FIG. 5C, the exposed resist film 110 may be developed by using a developing solution. The exposed areas 111 may be washed away by the developing solution, whereas the unexposed areas 112 may remain without being washed away by the developing solution.
Referring to FIG. 5D, exposed areas of the material layer 130 may be etched using the resist film 110 as a mask to form a material pattern 135 on the substrate 100.
Referring to FIG. 5E, the resist film 110 may be removed.
A resist composition according one or more embodiments may be used in a patterning process to form various types of semiconductor devices.
The disclosure will be described in more detail with reference to the following Examples and Comparative Examples, but the technical scope of the disclosure is not limited only to the following Examples.

**[Example]**

- PHS is poly(hydroxy styrene) of which product number is 436224, manufactured by Sigma-Aldrich®. PHS has a weight average molecular weight of about 25000.

**Synthesis Example 1: Synthesis of SP205**

In a 100 ml reactor, an initiator V601 (manufactured by Wako Chemical Co., Ltd, 0.426 g, 1.84 mmol), 1.5 g (9.3 mmol) of acetoxy styrene (AHS), 0.2 g (0.9 mmol) of an azo initiator (V601) were mixed and dissolved in 3 ml of 1,4-dioxane. Nitrogen bubbling was performed for about 20 minutes while stirring at room temperature. The reactor was again sealed after completing the bubbling, and then a polymerization was performed at 80 °C for 4 hours. After the reaction was completed, a polymerized product was precipitated in 200 ml of hexane. A precipitate was obtained using a glass filter and was dried overnight at 40 °C in a vacuum drying oven. 1g of polymer SP205 (yield 70%) having a weight average molecular weight of 4625 g/mol, and a PDI of 2.2 was obtained.

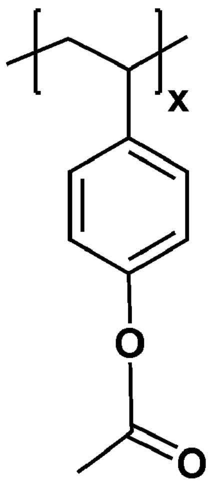

**SP205**

**Synthesis Example 2: Synthesis of SP5**

Polymer SP5 (yield 70%) having a weight average molecular weight of 10621 g/mol and a PDI of 2.1, was obtained in the same manner as Synthesis Example 1, except that 1-(3,5-difluoro phenyl)cyclopentyl 3-hydoxy-5-vinyl

benzoate was used in place of acetoxy styrene.

**Synthesis Example 3: Synthesis of SP30**

Polymer SP30 (yield 64%) having a weight average molecular weight of 10288 g/mol and a PDI of 2.0, was obtained in the same manner as Synthesis Example 1, except that 2-methyl but-3-en-2-il-3-hydroxy-5-vinyl benzoate was used in place of acetoxy styrene.

**Synthesis Example 4: Synthesis of SP32**

Polymer SP32 (yield 50%) having a weight average molecular weight of 4658 g/mol and a PDI of 1.7, was obtained in the same manner as Synthesis Example 1, except that 3-acetoxy styrene was used in place of acetoxy styrene.

**Synthesis Example 5: Synthesis of SP126**

Polymer SP126 (yield 52%) having a weight average molecular weight of 11638 g/mol and a PDI of 4.1, was obtained in the same manner as Synthesis Example 1, except that chloroacrylic 4-hydroxyphenyl was used in place of acetoxy styrene.

**Synthesis Example 6: Synthesis of SP194**

Polymer SP194 (yield 68%) having a weight average molecular weight of 5556 g/mol and a PDI of 2.05, was obtained in the same manner as Synthesis Example 1, except that 4-acetoxy-2-fluoro styrene was used in place of acetoxy styrene.

**Synthesis Example 7: Synthesis of SP150**

Polymer SP150 (yield 85%) having a weight average molecular weight of 6151 g/mol and a PDI of 1.11, was obtained in the same manner as Synthesis Example 1, except that amino styrene was used in place of acetoxy styrene.

**Synthesis Example 8: Synthesis of SP35**

Polymer SP35 (yield 59%) having a weight average molecular weight of 7409 g/mol and a PDI of 1.5, was obtained in the same manner as Synthesis Example 1, except that 3,5-dimethyl-4-acetoxy styrene was used in place of acetoxy styrene.

**Synthesis Example 9: Synthesis of T1**

(1) Synthesis of di(4-fluorobenzyl) tin dichloride (FB)

<Di(4-Fluorobenzyl) Tin Dichloride (FB)>

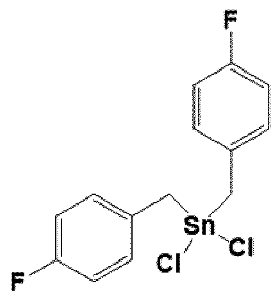

Tin powder (8.2 g, 69 mmol) and 120 ml of dried toluene were added to a 250 ml reaction flask and then heated at 90 °C. Next, 0.82 g of pure water was added as a catalyst, and 4-fluorobenzyl chloride (10 g, 69 mmol) was added dropwise over 10 minutes. A reaction temperature was raised to 130 °C, and then the obtained was heated to reflux for

4 hours. After the reaction was completed, an unreacted powder was removed through a filter, and then cooled to obtain a white crystal. The obtained white crystal was cleaned with cold toluene and dried overnight at 40 °C to obtain 10.92 g of a compound FB (yield: 60%). The obtained compound FB was analyzed through $^1$H-NMR and $^{119}$Sn-NMR and analysis results are shown in FIGS. 3A and 3B, respectively.

(2) synthesis of di(4-fluorobenzyl) tin dicarboxylate (T1)

<Di(4-Fluorobenzyl) Tin dicarboxylate (Acetate) (T1)>

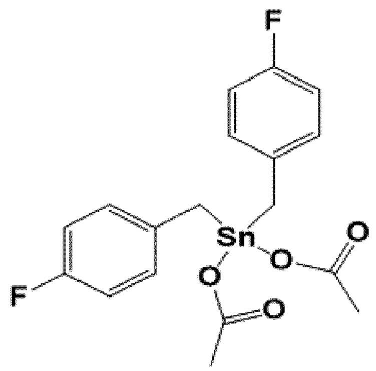

Di(4-fluorobenzyl) tin dichloride (0.5 g, 1.23 mmol) and 7 g of acetone were added to a 50 ml reaction flask in an ice water bath. To the flask, sodium acetate (0.2 g, 2.45 mmol) was added. After stirring overnight, the resultant mixture was filtered, and then an obtained solid was dried to obtain 0.45 g of a compound T1 (yield: 65%). The obtained compound T1 was analyzed by $^1$H-NMR and $^{119}$Sn-NMR and analysis results are shown in FIGS. 3C and 3D, respectively.

**Evaluation Example: thin film development evaluation**

Specifically, PHS, the polymer synthesized according to Synthesis Examples 1 to 8, and the compound T1 synthesized in Synthesis Example 9 were dissolved in an amount of 2% by weight in a casting solvent listed in Table 1. Herein, a weight ratio of the polymer and the organometallic compound is listed in Table 1. The casting solution was spin-coated at 1500 rpm onto a silicon wafer coated with a 3nm of HMDS as a lower film, and the resultant was then dried at 120 °C for 1 minute to produce a film having an initial thickness in Table 1. Thereafter, the produced film was exposed to DUV in a wavelength of 254 nm with a dose of about 0 mJ/cm$^2$ to about 60 mJ/cm$^2$, and dried at 150 °C to about 200 °C for 1 minute. The dried film was soaked at 25 °C for 60 seconds using a PGMEA solution in which 2 wt% of acetic acid was dissolved as the developing solution, and then a thickness of the remaining film was measured and shown in Table 2 and FIGS. 4A to 4J.

Table 1

| | Organic metal Compound | Polymer | Casting solvent | Weight ratio (T1: Polymer) | PAB (°C) | Initial thickness (nm) | PEB (°C) |
|---|---|---|---|---|---|---|---|
| Comparative Example 1 | T1 | - | Ethyl lactate | - | 120 | 19.6 | 200 |
| Comparative Example 2 | T1 | SP205 | Ethyl lactate | 2:1 | 120 | 22.0 | 150 |
| Example 1 | T1 | PHS | Ethyl lactate | 2:1 | 120 | 22.1 | 150 |
| Example 2 | T1 | SP5 | Ethyl lactate | 2:1 | 120 | 20.6 | 150 |
| Example 3 | T1 | SP30 | Ethyl lactate | 2:1 | 120 | 22.4 | 150 |

(continued)

| | Organic metal Compound | Polymer | Casting solvent | Weight ratio (T1: Polymer) | PAB (°C) | Initial thickness (nm) | PEB (°C) |
|---|---|---|---|---|---|---|---|
| Example 4 | T1 | SP32 | Ethyl lactate | 2:1 | 120 | 22.5 | 150 |
| Example 5 | T1 | SP126 | Ethyl lactate | 2:1 | 120 | 22.8 | 150 |
| Example 6 | T1 | SP194 | Ethyl lactate | 2:1 | 120 | 19.9 | 150 |
| Example 7 | T1 | SP150 | Ethyl lactate | 2:1 | 120 | 22.5 | 150 |
| Example 8 | T1 | SP35 | Ethyl lactate | 2:1 | 120 | 21.9 | 150 |

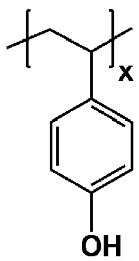

PHS

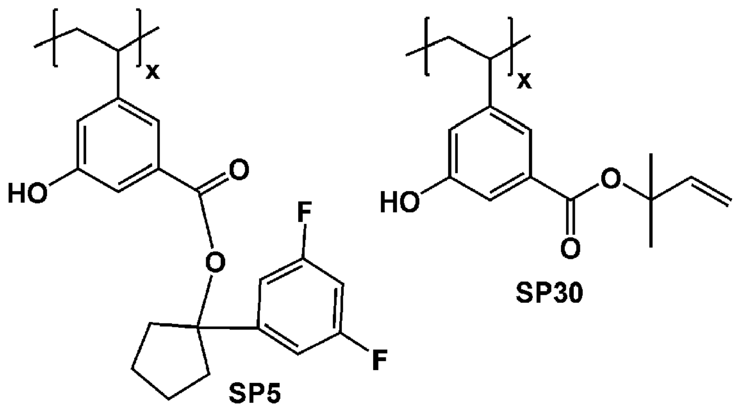

SP5

SP30

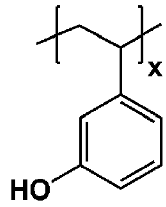

SP32

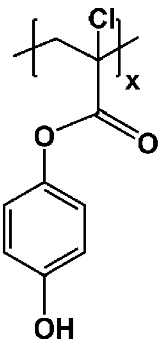

SP126

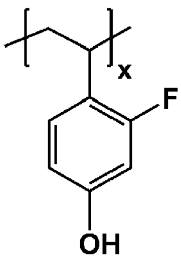

SP194

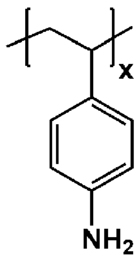

SP150

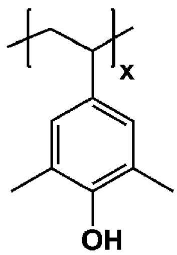

SP35

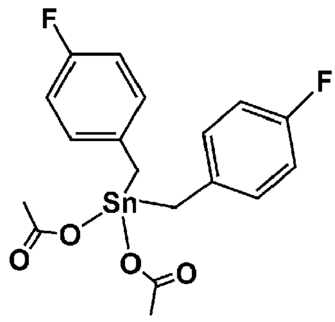

T1

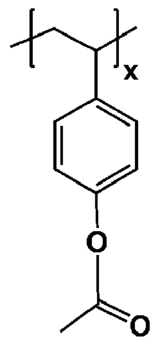

SP205

Table 2

| | Organometallic compound | Polymer | $E_{th}$ ($mJ/cm^2$) | $E_1$ ($mJ/cm^2$) | Film remaining ratio (%) | Y |
|---|---|---|---|---|---|---|
| Comparative Example 1 | T1 | - | 22 | 50 | 50 | 1.4 |
| Comparative Example 2 | T1 | SP205 | 42 | 70 | 39.1 | 1.8 |
| Example 1 | T1 | PHS | 12 | 25 | 88.2 | 2.8 |
| Example 2 | T1 | SP5 | 12 | 35 | 67.8 | 1.5 |
| Example 3 | T1 | SP30 | 11 | 32 | 71.4 | 1.5 |
| Example 4 | T1 | SP32 | 23 | 35 | 78.7 | 4.3 |
| Example 5 | T1 | SP126 | 4 | 20 | 92.5 | 1.3 |
| Example 6 | T1 | SP194 | 25 | 43 | 91.5 | 3.9 |
| Example 7 | T1 | SP150 | 3 | 18 | 90.1 | 1.2 |
| Example 8 | T1 | SP35 | 23 | 65 | 73.5 | 1.6 |

In above Table 2, $E_{th}$ means an exposure amount at the time when the thin film starts to be hardened, and $E_1$ means an exposure amount at a saturation point at which the thickness of the thin film no longer increases. The film remaining ratio represents a percentage value obtained by dividing the thickness of the thin film at the saturation point by the initial thickness of the thin film, and $\gamma$ is a contrast curve, which is a value calculated in accordance with Equation 1.

<Equation 1>

$$\gamma = \left| \log\left(\frac{E_{th}}{E_1}\right) \right|^{-1}$$

Referring to Table 2, it can be seen that Comparative Example 2 exhibits higher values of $E_{th}$ and $E_1$ than those of Comparative Example 1, and since SP 205 and T1 do not form a chemical bond therebetween, the resist composition according to Comparative Example 2 does not have substantially improved photosensitivity.

On the other hand, it can be seen that Examples 1 to 8 exhibit lower values of $E_{th}$ and/or $E_1$ than those according to Comparative Examples 1 and 2. Accordingly, it can be confirmed that resist compositions, according to Examples 1 to 10 have more improved sensitivity than resist compositions according to Comparative Examples 1 and 2.

In addition, it can be seen that Examples 1 to 8 have a more improved remaining ratio than Comparative

Example 1, which suggests that a chemical bond was formed between the radical formed from the organometallic compound and the radical formed from the polymer.

Embodiments of the disclosure may provide a resist composition having improved sensitivity and providing patterns with improved resolution.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

**1.** A resist composition comprising:

an organometallic compound represented by Formula 1; and
a polymer including a repeating unit represented by Formula 2,

<Formula 1> $M_{11}(R_{11})_n(OR_{12})_{(4-n)}$

<Formula 2>

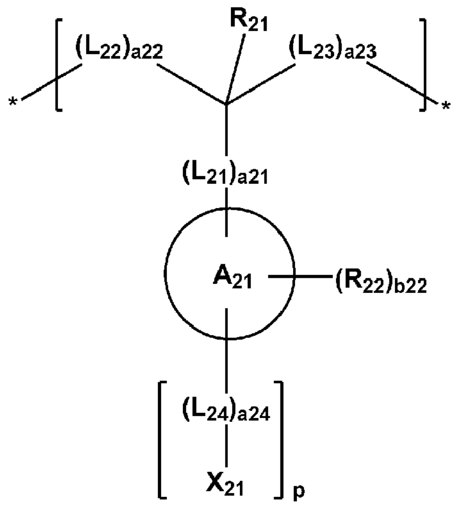

,

wherein, in Formulas 1 and 2,
$M_{11}$ is indium (In), tin (Sn), antimony (Sb), tellurium (Te), thallium (Tl), lead (Pb), bismuth (Bi), silver (Ag), or polonium (Po),
$R_{11}$ is a linear, branched, or cyclic $C_1$-$C_{30}$ monovalent hydrocarbon group optionally containing a heteroatom,
$R_{12}$ is a linear, branched, or cyclic $C_1$-$C_{30}$ monovalent hydrocarbon group optionally containing a heteroatom, or $*\text{-}M_{12}(R_{13})_m(OR_{14})_{(3-m)}$,
n is an integer of 1 to 4,
$M_{12}$ is indium (In), tin (Sn), antimony (Sb), tellurium (Te), thallium (Tl), lead (Pb), bismuth (Bi), silver (Ag), or polonium (Po),
$R_{13}$ and $R_{14}$ are each independently a linear, branched, or cyclic $C_1$-$C_{30}$ monovalent hydrocarbon group optionally containing a heteroatom,
m is an integer of 0 to 3,
$L_{21}$ to $L_{24}$ are each independently a single bond, O, S, C (=O), C (=O)O, OC (=O), C(=O)NH, NHC(=O), a linear, branched, or cyclic $C_1$-$C_{30}$ divalent hydrocarbon group optionally containing a heteroatom, or any combination thereof,
a21 to a24 are each independently an integer of 1 to 4,
$A_{21}$ is a $C_1$-$C_{30}$ aryl group or a $C_1$-$C_{30}$ heteroaryl group,

$R_{21}$ and $R_{22}$ are each independently a hydrogen atom, a deuterium atom, a halogen atom, or a linear, branched, or cyclic $C_1$-$C_{30}$ monovalent hydrocarbon group optionally containing a heteroatom,
b22 is an integer of 1 to 10;
p is an integer of 1 to 5;
$X_{21}$ is a reactive group reacting with the organometallic compound; and
* is a bonding site to a neighboring atom.

**2.** The resist composition of claim 1, wherein

a bond between $M_{11}$ and $R_{11}$ is an $M_{11}$-carbon single bond,
$R_{12}$ is *-$M_{12}(R_{13})_m(OR_{14})_{(3-m)}$, and
a bond of between $M_{12}$ and $R_{13}$ is an $M_{12}$-carbon single bond.

**3.** The resist composition of claims 1 or 2, wherein the organometallic compound has a molecular weight of 3000 g/mol or less; and/or
wherein $R_{12}$ is *-$M_{12}(R_{13})_m(OR_{14})_{(3-m)}$, and $M_{11}$ and $M_{12}$ are each independently Sn, Sb, Te, Bi, or Ag.

**4.** The resist composition of any of claims 1-3, wherein

$R_{11}$ and $R_{13}$ are each independently represented by *-$(L_{11})_{a11}$-$X_{11}$,
$R_{12}$ and $R_{14}$ are each independently represented by *-$(L_{12})_{a12}$-$X_{12}$,
$L_{11}$ and $L_{12}$ are independently $CR_aRb$, C=O, S=O, $SO_2$, $PO_2$, or $PO_3$,
a11 and a12 are independently an integer of 0 to 3,
$X_{11}$ and $X_{12}$ are independently a substituted or unsubstituted $C_1$-$C_{30}$ alkyl group, a substituted or unsubstituted $C_1$-$C_{30}$ halogenated alkyl group, a substituted or unsubstituted $C_1$-$C_{30}$ alkoxy group, a substituted or unsubstituted $C_1$-$C_{30}$ alkylthio group, a substituted or unsubstituted $C_1$-$C_{30}$ halogenated alkoxy group, a substituted or unsubstituted $C_1$-$C_{30}$ halogenated alkylthio group, a substituted or unsubstituted $C_3$-$C_{30}$ cycloalkyl group, a substituted or unsubstituted $C_3$-$C_{30}$ cycloalkoxy group, a substituted or unsubstituted $C_3$-$C_{30}$ cycloalkylthio group, a substituted or unsubstituted $C_3$-$C_{30}$ heterocycloalkyl group, a substituted or unsubstituted $C_3$-$C_{30}$ heterocycloalkoxy group, a substituted or unsubstituted $C_3$-$C_{30}$ heterocycloalkylthio group, a substituted or unsubstituted $C_2$-$C_{30}$ alkenyl group, a substituted or unsubstituted $C_2$-$C_{30}$alkenyloxy group, a substituted or unsubstituted $C_2$-$C_{30}$ alkenylthio group, a substituted or unsubstituted $C_3$-$C_{30}$ cycloalkenyl group, a substituted or unsubstituted $C_3$-$C_{30}$ cycloalkenyloxy group, a substituted or unsubstituted $C_3$-$C_{30}$ cycloalkenylthio group, a substituted or unsubstituted $C_3$-$C_{30}$ heterocycloalkenyl group, a substituted or unsubstituted $C_3$-$C_{30}$ heterocycloalkenyloxy group, a substituted or unsubstituted $C_3$-$C_{30}$ heterocycloalkenylthio group, a substituted or unsubstituted $C_2$-$C_{30}$ alkynyl group, a substituted or unsubstituted $C_2$-$C_{30}$ alkynyloxy group, a substituted or unsubstituted $C_2$-$C_{30}$ alkynylthio group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_1$-$C_{30}$ heteroaryl group, a substituted or unsubstituted $C_1$-$C_{30}$ heteroaryloxy group, or a substituted or unsubstituted $C_1$-$C_{30}$ heteroarylthio group,
$R_a$ and $R_b$ are each independently hydrogen, deuterium, a hydroxyl group, a cyano group, a nitro group, a substituted or unsubstituted $C_1$-$C_{30}$ alkyl group, a substituted or unsubstituted $C_1$-$C_{30}$ alkoxy group, a substituted or unsubstituted $C_1$-$C_{30}$ alkylthio group, a substituted or unsubstituted $C_3$-$C_{30}$ cycloalkyl group, a substituted or unsubstituted $C_3$-$C_{30}$ cycloalkoxy group, or a substituted or unsubstituted $C_3$-$C_{30}$ cycloalkylthio group,
and * is a bonding site to a neighboring atom.

**5.** The resist composition of any of claims 1-4,

wherein the organometallic compound is represented by any one of Formulas 1-1 to 1-16:

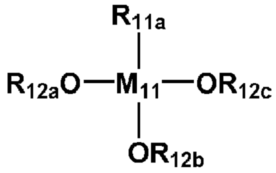
1-1

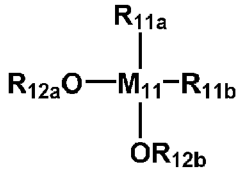
1-2

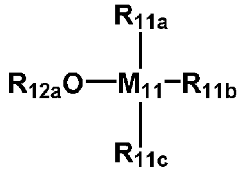
1-3

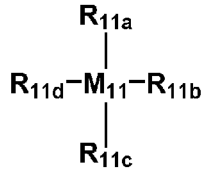
1-4

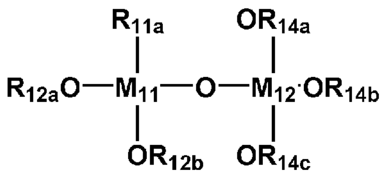

1-5

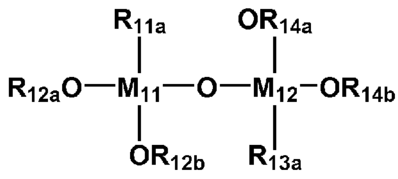

1-6

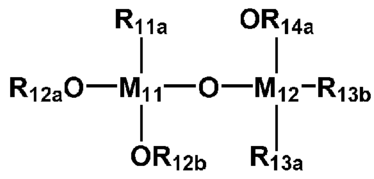

1-7

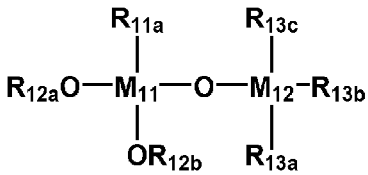

1-8

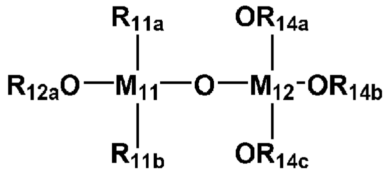

1-9

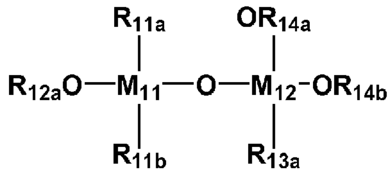

1-10

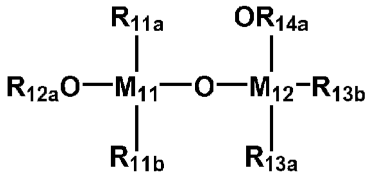

1-11

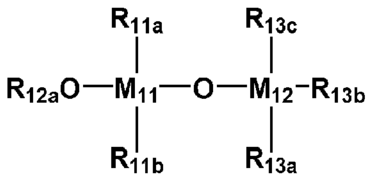

1-12

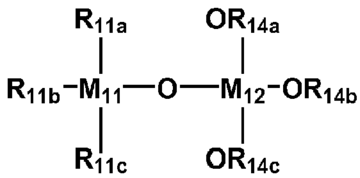

1-13

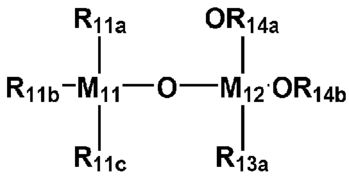

1-14

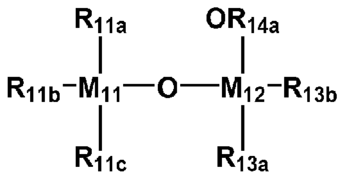

1-15

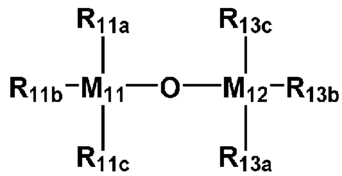

1-16

wherein, in Formulas 1-1 to 1-16,

$M_{11}$ and $M_{12}$ each independently are indium (In), tin (Sn), antimony (Sb), tellurium (Te), thallium (Tl), lead (Pb), bismuth (Bi), silver (Ag), or polonium (Po), $R_{11a}$ to $R_{11d}$, $R_{13a}$ to $R_{13c}$, $R_{14a}$ to $R_{14c}$ each independently are a linear, branched, or cyclic $C_1$-$C_{30}$ monovalent hydrocarbon group optionally containing a heteroatom,

$R_{12a}$ to $R_{12c}$ each independently are a linear, branched, or cyclic $C_1$-$C_{30}$ monovalent hydrocarbon group optionally containing a heteroatom, or *-M12(R13)m(OR14)(3-m), and

$M_{12}$ is indium (In), tin (Sn), antimony (Sb), tellurium (Te), thallium (Tl), lead (Pb), bismuth (Bi), silver (Ag), or polonium (Po).

**6.** The resist composition of any of claims 1-5,
wherein the polymer does not include a repeating unit having a structure changed by an acid.

**7.** The resist composition of any of claims 1-6,
wherein $A_{21}$ is a benzene group, a naphthalene group, a phenanthrene group, an anthracene group, a chrysene group, a pyrene group, a triphenylene group, a fluorene group, a pyrrole group, a furan group, a thiophene group, an imidazole group, an oxazole group, a thiazole group, a pyridine group, a pyrazine group, a triazine group, a quinoline group, an isoquinoline group, a benzoquinoline group, a quinoxaline group, a quinazoline group , a sinolin group, a phenanthroline group, a phenanthridine group, an indole group, a benzofuran group, a benzothiophene group, a benzimidazole group, a benzoxazole group, a benzothiazole group, a carbazole group, a dibenzofuran group , or a dibenzothiophene group.

**8.** The resist composition of any of claims 1-7, wherein $A_{21}$ is a benzene group, a naphthalene group, a phenanthrene group, an anthracene group, a chrysene group, a pyrene group, a triphenylene group, or a fluorene group; and/or wherein $X_{21}$ includes H bonded with a single bond to N, P, O or S.

**9.** The resist composition of any of claims 1-8,

wherein $X_{21}$ is $NHR_{31}$, $PHR_{31}$, OH, SH, $CO_2H$, $SO_3H$, $PO_3H_2$, or $PO(OR_{31})OH$,
$R_{31}$ is hydrogen, deuterium, or a linear, branched, or cyclic $C_1$-$C_{30}$ monovalent hydrocarbon group optionally containing a heteroatom.

**10.** The resist composition of any of claims 1-9, wherein $X_{21}$ is $NH_2$, $PH_2$, OH, SH, $CO_2H$, $SO_3H$, or $PO_3H_2$; and/or wherein the organometallic compound is 10 parts by weight to 1000 parts by weight with respect to 100 parts by weight of the polymer.

**11.** The resist composition of any of claims 1-10, wherein an average molecular weight (Mw) of the polymer is 1,000 to 500,000; and/or
wherein the resist composition further comprises an organic solvent, a surfactant, a crosslinking agent, a leveling agent, a colorant, or any combination thereof.

**12.** A resist composition comprising:

an organometallic compound represented by Formula 1; and
a monomer represented by Formula 20,

<Formula 1> $M_{11}(R_{11})_n(OR_{12})_{(4-n)}$

<Formula 20>

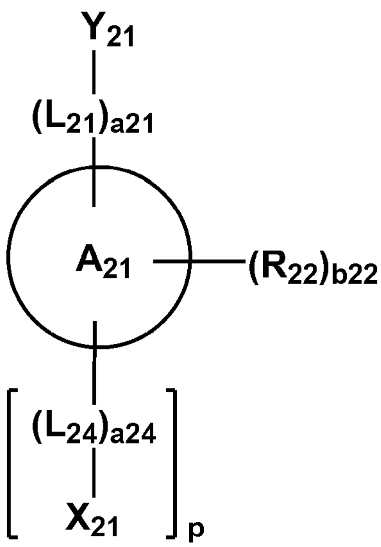

,

wherein, in Formulas 1 and 20,
$M_{11}$ is indium (In), tin (Sn), antimony (Sb), tellurium (Te), thallium (Tl), lead (Pb), bismuth (Bi), silver (Ag), or polonium (Po),
$R_{11}$ is a linear, branched, or cyclic $C_1$-$C_{30}$ monovalent hydrocarbon group optionally containing a heteroatom,
$R_{12}$ is a linear, branched, or cyclic $C_1$-$C_{30}$ monovalent hydrocarbon group optionally containing a heteroatom, or $^*$-$M_{12}(R_{13})_m(OR_{14})_{(3-m)}$,
n is an integer of 1 to 4,
$M_{12}$ is indium (In), tin (Sn), antimony (Sb), tellurium (Te), thallium (Tl), lead (Pb), bismuth (Bi), silver (Ag), or polonium (Po),
$R_{13}$ and $R_{14}$ are each independently a linear, branched, or cyclic $C_1$-$C_{30}$ monovalent hydrocarbon group optionally containing a heteroatom,
m is an integer of 0 to 3,
$Y_{21}$ is a polymerizable group,
$L_{21}$ and $L_{24}$ are each independently a single bond, O, S, C (=O), C (=O)O, OC (=O), C(=O)NH, NHC(=O), a

linear, branched, or cyclic $C_1$-$C_{30}$ divalent hydrocarbon group optionally containing a heteroatom, or any combination thereof,
a21 and a24 are each independently an integer of 1 to 4,
$A_{21}$ is a $C_1$-$C_{30}$ aryl group or a $C_1$-$C_{30}$ heteroaryl group,
$R_{21}$ and $R_{22}$ are each independently, hydrogen, deuterium, a halogen, or a linear, branched, or cyclic $C_1$-$C_{30}$ monovalent hydrocarbon group optionally containing a heteroatom,
b22 is an integer of 1 to 10;
p is an integer of 1 to 5; and
$X_{21}$ is a reactive group reacting with the organometallic compound;
preferably wherein $Y_{21}$ includes a vinyl group, an acrylate group, a methacrylate group, an oxirane group, an epoxy group, an oxetane group, a thiol group, or any combination thereof as a partial structure.

**13.** A pattern forming method comprising:

forming a resist film by applying the resist composition of any of claims 1-12 on a substrate;
exposing at least a portion of the resist film to high-energy rays to provide an exposed resist film; and
developing the exposed resist film by using a developing solution.

**14.** The pattern forming method of claim 13, wherein the exposing is performed by irradiation with deep ultraviolet (DUV), extreme ultraviolet (EUV) and/or electron beam (EB); and/or
wherein, by exposing the resist film, a chemical bond is formed between the organometallic compound and the polymer.

**15.** The pattern forming method of claims 13 or 14,

wherein the exposed resist film includes an exposed portion and an unexposed portion, and
the unexposed portion is removed in the developing of the exposed resist film.

**Amended claims in accordance with Rule 137(2) EPC.**

**1.** A resist composition comprising:

an organometallic compound represented by Formula 1; and
a polymer including a repeating unit represented by Formula 2,

<Formula 1> $M_{11}(R_{11})_n(OR_{12})_{(4-n)}$

<Formula 2>

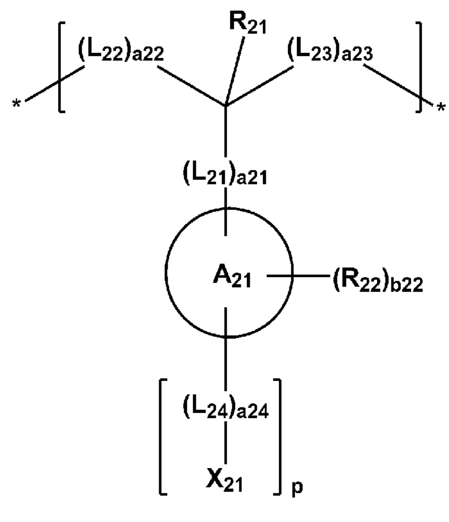

,

wherein, in Formulas 1 and 2,

$M_{11}$ is indium (In), tin (Sn), antimony (Sb), tellurium (Te), thallium (Tl), lead (Pb), bismuth (Bi), silver (Ag), or polonium (Po),
$R_{11}$ is a linear, branched, or cyclic $C_1$-$C_{30}$ monovalent hydrocarbon group optionally containing a heteroatom,
$R_{12}$ is a linear, branched, or cyclic $C_1$-$C_{30}$ monovalent hydrocarbon group optionally containing a heteroatom, or $*-M_{12}(R_{13})_m(OR_{14})_{(3-m)}$,
n is an integer of 1 to 4,
$M_{12}$ is indium (In), tin (Sn), antimony (Sb), tellurium (Te), thallium (Tl), lead (Pb), bismuth (Bi), silver (Ag), or polonium (Po),
$R_{13}$ and $R_{14}$ are each independently a linear, branched, or cyclic $C_1$-$C_{30}$ monovalent hydrocarbon group optionally containing a heteroatom,
m is an integer of 0 to 3,
$L_{21}$ to $L_{24}$ are each independently a single bond, O, S, C (=O), C (=O)O, OC (=O), C(=O)NH, NHC(=O), a linear, branched, or cyclic $C_1$-$C_{30}$ divalent hydrocarbon group optionally containing a heteroatom, or any combination thereof,
a21 to a24 are each independently an integer of 1 to 4,
$A_{21}$ is a $C_1$-$C_{30}$ aryl group or a $C_1$-$C_{30}$ heteroaryl group,
$R_{21}$ and $R_{22}$ are each independently a hydrogen atom, a deuterium atom, a halogen atom, or a linear, branched, or cyclic $C_1$-$C_{30}$ monovalent hydrocarbon group optionally containing a heteroatom,
b22 is an integer of 1 to 10;
p is an integer of 1 to 5;
$X_{21}$ is a reactive group reacting with the organometallic compound; and
* is a bonding site to a neighboring atom;
wherein the resist composition does not include a photoacid generator.

**2.** The resist composition of claim 1, wherein

a bond between $M_{11}$ and $R_{11}$ is an $M_{11}$-carbon single bond,
$R_{12}$ is $*-M_{12}(R_{13})_m(OR_{14})_{(3-m)}$, and
a bond of between $M_{12}$ and $R_{13}$ is an $M_{12}$-carbon single bond.

**3.** The resist composition of claims 1 or 2, wherein the organometallic compound has a molecular weight of 3000 g/mol or less; and/or wherein $R_{12}$ is $*-M_{12}(R_{13})_m(OR_{14})_{(3-m)}$, and $M_{11}$ and $M_{12}$ are each independently Sn, Sb, Te, Bi, or Ag.

**4.** The resist composition of any of claims 1-3, wherein

$R_{11}$ and $R_{13}$ are each independently represented by $*-(L_{11})_{a11}-X_{11}$,
$R_{12}$ and $R_{14}$ are each independently represented by $*-(L_{12})_{a12}-X_{12}$,
$L_{11}$ and $L_{12}$ are independently $CR_aRb$, C=O, S=O, $SO_2$, $PO_2$, or $PO_3$,
a11 and a12 are independently an integer of 0 to 3,
$X_{11}$ and $X_{12}$ are independently a substituted or unsubstituted $C_1$-$C_{30}$ alkyl group, a substituted or unsubstituted $C_1$-$C_{30}$ halogenated alkyl group, a substituted or unsubstituted $C_1$-$C_{30}$ alkoxy group, a substituted or unsubstituted $C_1$-$C_{30}$ alkylthio group, a substituted or unsubstituted $C_1$-$C_{30}$ halogenated alkoxy group, a substituted or unsubstituted $C_1$-$C_{30}$ halogenated alkylthio group, a substituted or unsubstituted $C_3$-$C_{30}$ cycloalkyl group, a substituted or unsubstituted $C_3$-$C_{30}$ cycloalkoxy group, a substituted or unsubstituted $C_3$-$C_{30}$ cycloalkylthio group, a substituted or unsubstituted $C_3$-$C_{30}$ heterocycloalkyl group, a substituted or unsubstituted $C_3$-$C_{30}$ heterocycloalkoxy group, a substituted or unsubstituted $C_3$-$C_{30}$ heterocycloalkylthio group, a substituted or unsubstituted $C_2$-$C_{30}$ alkenyl group, a substituted or unsubstituted $C_2$-$C_{30}$ alkenyloxy group, a substituted or unsubstituted $C_2$-$C_{30}$ alkenylthio group, a substituted or unsubstituted $C_3$-$C_{30}$ cycloalkenyl group, a substituted or unsubstituted $C_3$-$C_{30}$ cycloalkenyloxy group, a substituted or unsubstituted $C_3$-$C_{30}$ cycloalkenylthio group, a substituted or unsubstituted $C_3$-$C_{30}$ heterocycloalkenyl group, a substituted or unsubstituted $C_3$-$C_{30}$ heterocycloalkenyloxy group, a substituted or unsubstituted $C_3$-$C_{30}$ heterocycloalkenylthio group, a substituted or unsubstituted $C_2$-$C_{30}$ alkynyl group, a substituted or unsubstituted $C_2$-$C_{30}$ alkynyloxy group, a substituted or unsubstituted $C_2$-$C_{30}$ alkynylthio group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_1$-$C_{30}$ heteroaryl group, a substituted or unsubstituted $C_1$-$C_{30}$ heteroaryloxy group, or a substituted or

unsubstituted $C_1$-$C_{30}$ heteroarylthio group,
$R_a$ and $R_b$ are each independently hydrogen, deuterium, a hydroxyl group, a cyano group, a nitro group, a substituted or unsubstituted $C_1$-$C_{30}$ alkyl group, a substituted or unsubstituted $C_1$-$C_{30}$ alkoxy group, a substituted or unsubstituted $C_1$-$C_{30}$ alkylthio group, a substituted or unsubstituted $C_3$-$C_{30}$ cycloalkyl group, a substituted or unsubstituted $C_3$-$C_{30}$ cycloalkoxy group, or a substituted or unsubstituted $C_3$-$C_{30}$ cycloalkylthio group,
and * is a bonding site to a neighboring atom.

**5.** The resist composition of any of claims 1-4,
wherein the organometallic compound is represented by any one of Formulas 1-1 to 1-16:

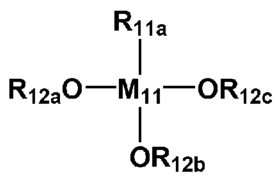
1-1

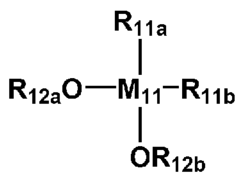
1-2

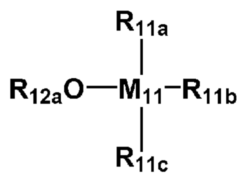
1-3

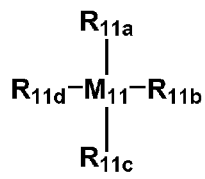
1-4

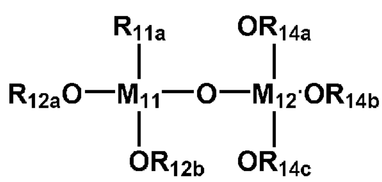
1-5

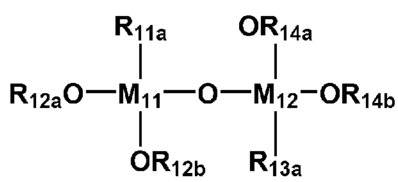
1-6

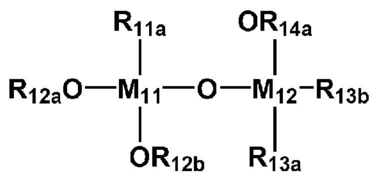
1-7

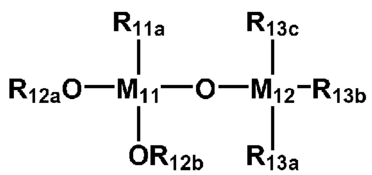
1-8

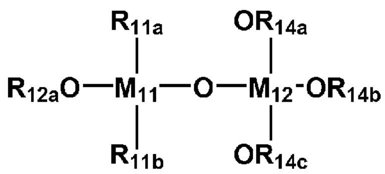
1-9

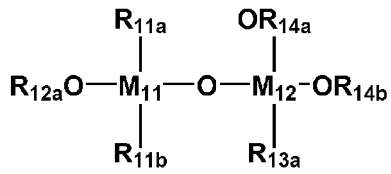
1-10

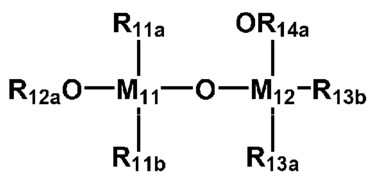
1-11

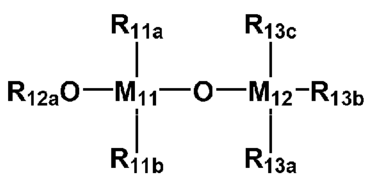
1-12

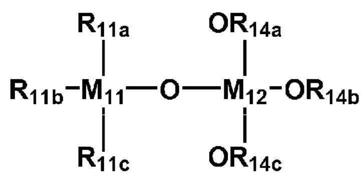
1-13

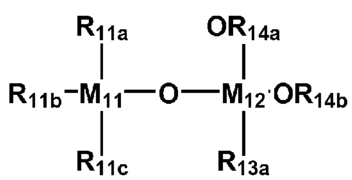
1-14

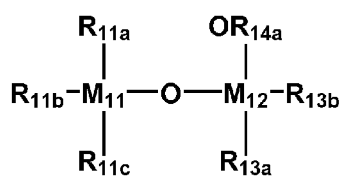
1-15

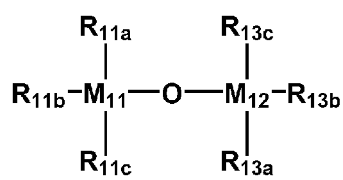
1-16

wherein, in Formulas 1-1 to 1-16,

$M_{11}$ and $M_{12}$ each independently are indium (In), tin (Sn), antimony (Sb), tellurium (Te), thallium (Tl), lead (Pb), bismuth (Bi), silver (Ag), or polonium (Po), $R_{11a}$ to $R_{11d}$, $R_{13a}$ to $R_{13c}$, $R_{14a}$ to $R_{14c}$ each independently are a linear, branched, or cyclic $C_1$-$C_{30}$ monovalent hydrocarbon group optionally containing a heteroatom,
$R_{12a}$ to $R_{12c}$ each independently are a linear, branched, or cyclic $C_1$-$C_{30}$ monovalent hydrocarbon group op-

tionally containing a heteroatom, or *-M12(R13)m(OR14)(3-m), and
$M_{12}$ is indium (In), tin (Sn), antimony (Sb), tellurium (Te), thallium (Tl), lead (Pb), bismuth (Bi), silver (Ag), or polonium (Po).

**6.** The resist composition of any of claims 1-5,
wherein the polymer does not include a repeating unit having a structure changed by an acid.

**7.** The resist composition of any of claims 1-6,
wherein $A_{21}$ is a benzene group, a naphthalene group, a phenanthrene group, an anthracene group, a chrysene group, a pyrene group, a triphenylene group, a fluorene group, a pyrrole group, a furan group, a thiophene group, an imidazole group, an oxazole group, a thiazole group, a pyridine group, a pyrazine group, a triazine group, a quinoline group, an isoquinoline group, a benzoquinoline group, a quinoxaline group, a quinazoline group , a sinolin group, a phenanthroline group, a phenanthridine group, an indole group, a benzofuran group, a benzothiophene group, a benzimidazole group, a benzoxazole group, a benzothiazole group, a carbazole group, a dibenzofuran group , or a dibenzothiophene group.

**8.** The resist composition of any of claims 1-7, wherein $A_{21}$ is a benzene group, a naphthalene group, a phenanthrene group, an anthracene group, a chrysene group, a pyrene group, a triphenylene group, or a fluorene group; and/or wherein $X_{21}$ includes H bonded with a single bond to N, P, O or S.

**9.** The resist composition of any of claims 1-8,

wherein $X_{21}$ is $NHR_{31}$, $PHR_{31}$, OH, SH, $CO_2H$, $SO_3H$, $PO_3H_2$, or $PO(OR_{31})OH$,
$R_{31}$ is hydrogen, deuterium, or a linear, branched, or cyclic $C_1$-$C_{30}$ monovalent hydrocarbon group optionally containing a heteroatom.

**10.** The resist composition of any of claims 1-9, wherein $X_{21}$ is $NH_2$, $PH_2$, OH, SH, $CO_2H$, $SO_3H$, or $PO_3H_2$; and/or wherein the organometallic compound is 10 parts by weight to 1000 parts by weight with respect to 100 parts by weight of the polymer.

**11.** The resist composition of any of claims 1-10, wherein an average molecular weight (Mw) of the polymer is 1,000 to 500,000; and/or
wherein the resist composition further comprises an organic solvent, a surfactant, a crosslinking agent, a leveling agent, a colorant, or any combination thereof.

**12.** A resist composition comprising:

an organometallic compound represented by Formula 1; and
a monomer represented by Formula 20,

<Formula 1> $M_{11}(R_{11})_n(OR_{12})_{(4-n)}$

<Formula 20>

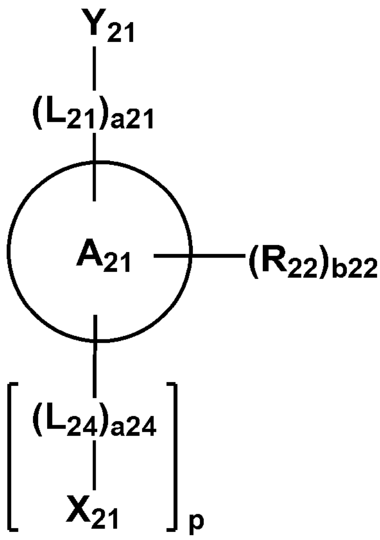

,

wherein, in Formulas 1 and 20,

$M_{11}$ is indium (In), tin (Sn), antimony (Sb), tellurium (Te), thallium (Tl), lead (Pb), bismuth (Bi), silver (Ag), or polonium (Po),
$R_{11}$ is a linear, branched, or cyclic $C_1$-$C_{30}$ monovalent hydrocarbon group optionally containing a heteroatom,
$R_{12}$ is a linear, branched, or cyclic $C_1$-$C_{30}$ monovalent hydrocarbon group optionally containing a heteroatom, or $*-M_{12}(R_{13})_m(OR_{14})_{(3-m)}$,
n is an integer of 1 to 4,
$M_{12}$ is indium (In), tin (Sn), antimony (Sb), tellurium (Te), thallium (Tl), lead (Pb), bismuth (Bi), silver (Ag), or polonium (Po),
$R_{13}$ and $R_{14}$ are each independently a linear, branched, or cyclic $C_1$-$C_{30}$ monovalent hydrocarbon group optionally containing a heteroatom,
m is an integer of 0 to 3,
$Y_{21}$ is a polymerizable group,
$L_{21}$ and $L_{24}$ are each independently a single bond, O, S, C (=O), C (=O)O, OC (=O), C(=O)NH, NHC(=O), a linear, branched, or cyclic $C_1$-$C_{30}$ divalent hydrocarbon group optionally containing a heteroatom, or any combination thereof,
a21 and a24 are each independently an integer of 1 to 4,
$A_{21}$ is a $C_1$-$C_{30}$ aryl group or a $C_1$-$C_{30}$ heteroaryl group,
$R_{22}$ is hydrogen, deuterium, a halogen, or a linear, branched, or cyclic $C_1$-$C_{30}$ monovalent hydrocarbon group optionally containing a heteroatom,
b22 is an integer of 1 to 10;
p is an integer of 1 to 5; and
$X_{21}$ is a reactive group reacting with the organometallic compound;
preferably wherein $Y_{21}$ includes a vinyl group, an acrylate group, a methacrylate group, an oxirane group, an epoxy group, an oxetane group, a thiol group, or any combination thereof as a partial structure;
wherein the resist composition does not include a photoacid generator.

**13.** A pattern forming method comprising:

forming a resist film by applying the resist composition of any of claims 1-12 on a substrate;
exposing at least a portion of the resist film to high-energy rays to provide an exposed resist film; and
developing the exposed resist film by using a developing solution.

**14.** The pattern forming method of claim 13, wherein the exposing is performed by irradiation with deep ultraviolet (DUV), extreme ultraviolet (EUV) and/or electron beam (EB); and/or
wherein, by exposing the resist film, a chemical bond is formed between the organometallic compound and the

polymer.

**15.** The pattern forming method of claims 13 or 14,

wherein the exposed resist film includes an exposed portion and an unexposed portion, and the unexposed portion is removed in the developing of the exposed resist film.

# FIG. 1

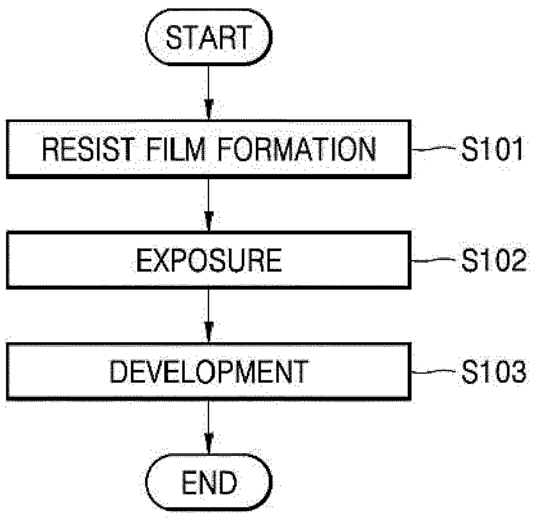
START
RESIST FILM FORMATION
S101
EXPOSURE
S102
DEVELOPMENT
S103
END

FIG. 2A

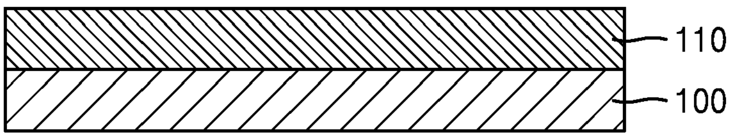

FIG. 2B

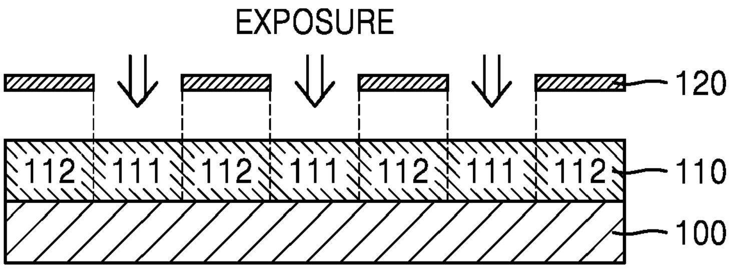

FIG. 2C

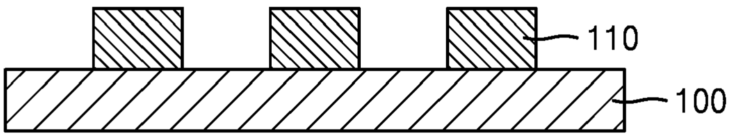

FIG. 3A

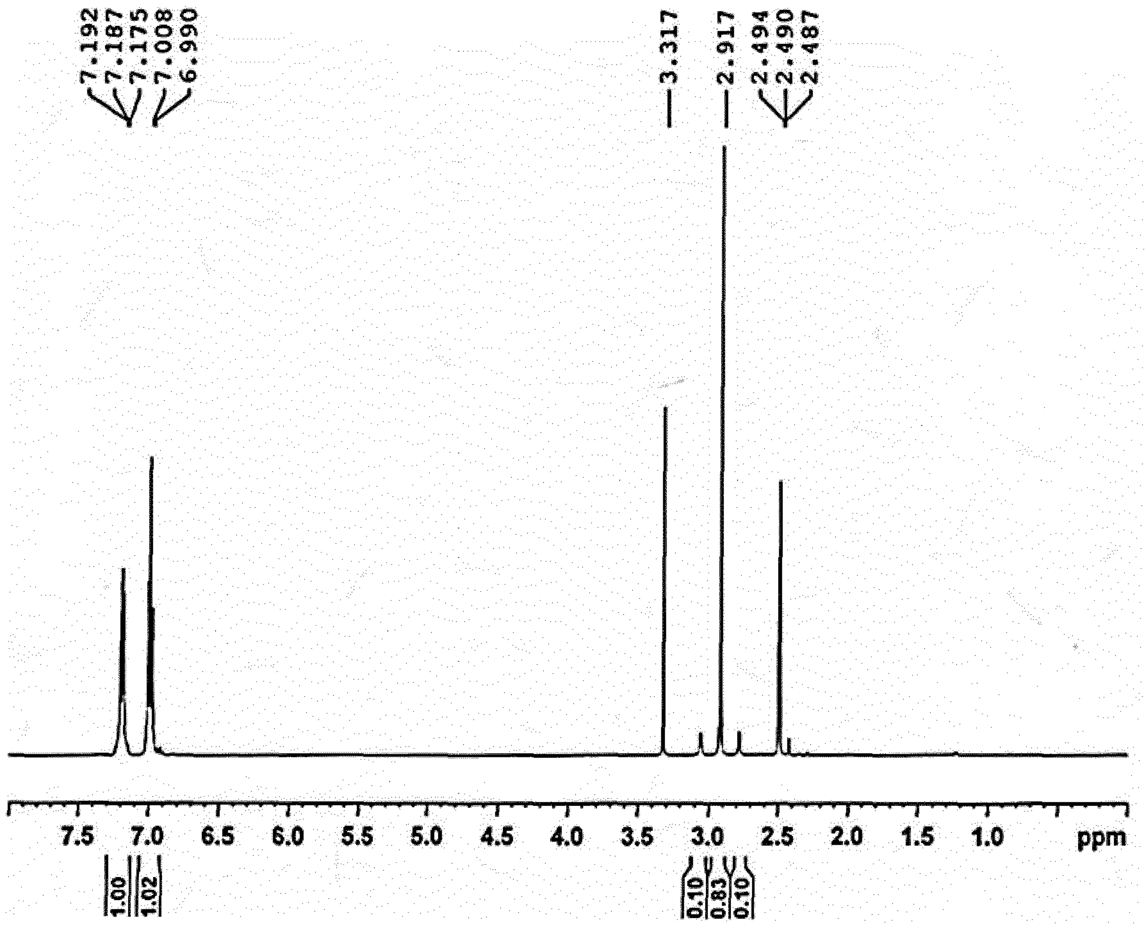
7.192
7.187
7.175
7.008
6.990
3.317
2.917
2.494
2.490
2.487
7.5
7.0
6.5
6.0
5.5
5.0
4.5
4.0
3.5
3.0
2.5
2.0
1.5
1.0
ppm
1.00
1.02
0.10
0.83
0.10

FIG. 3B

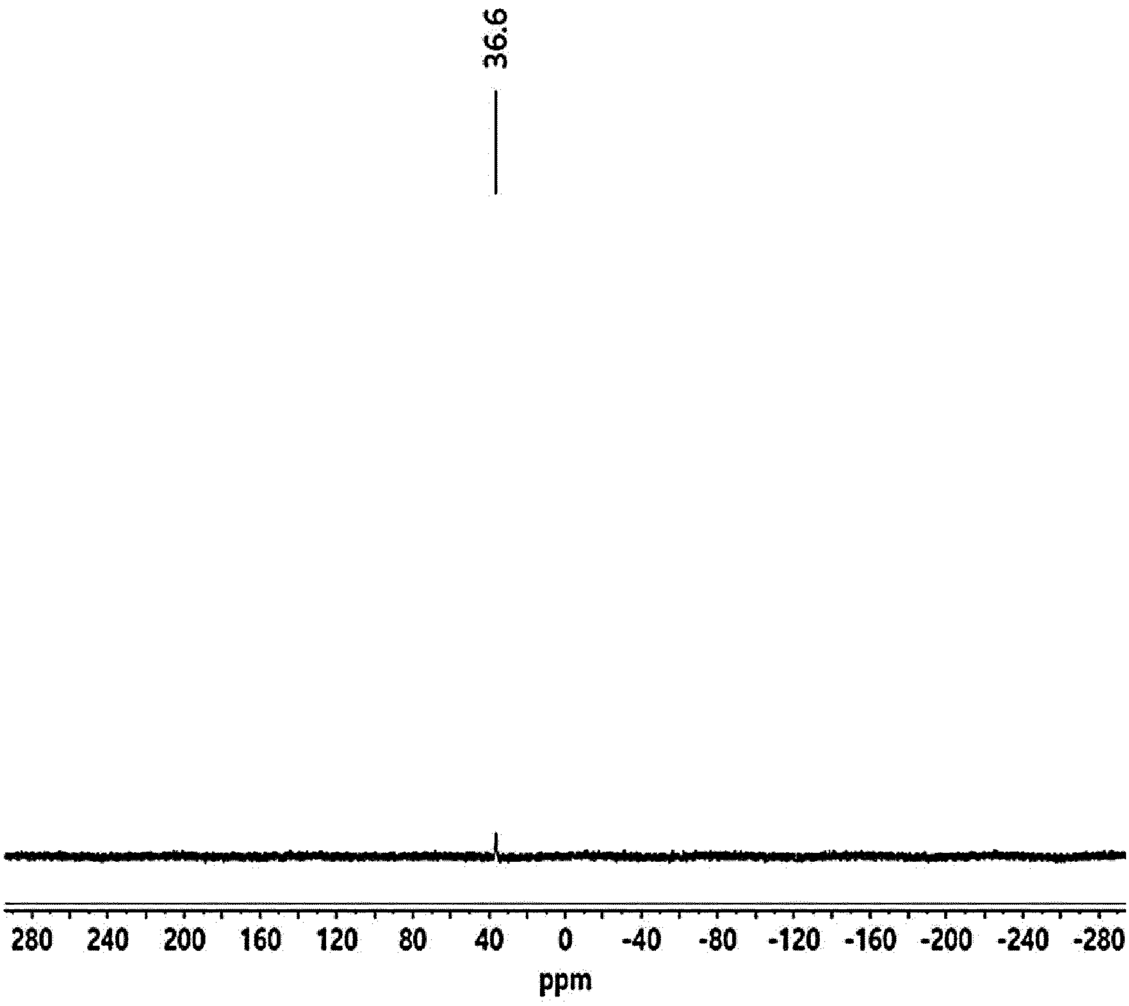

FIG. 3C

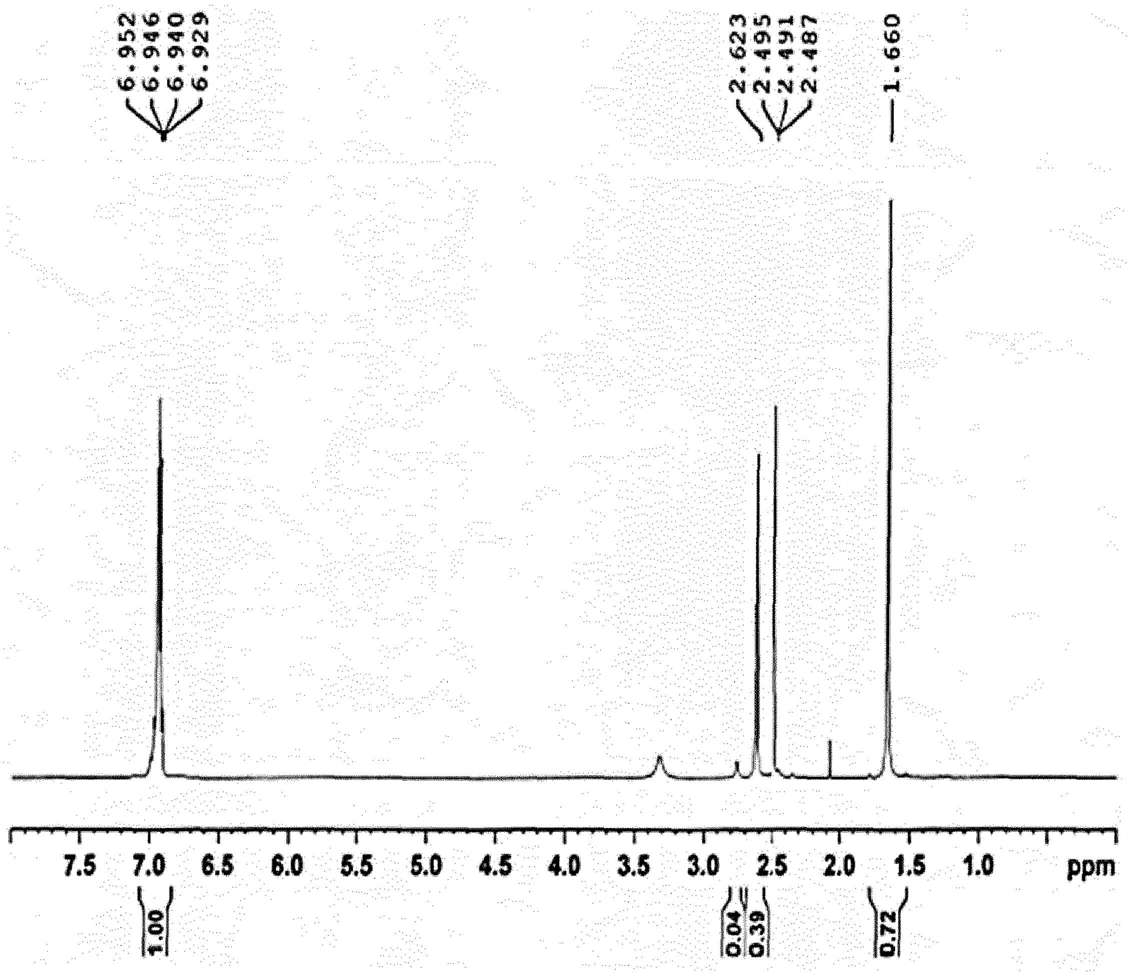
6.952
6.946
6.940
6.929
2.623
2.495
2.491
2.487
1.660
7.5 7.0 6.5 6.0 5.5 5.0 4.5 4.0 3.5 3.0 2.5 2.0 1.5 1.0 ppm
1.00
0.04
0.39
0.72

FIG. 3D

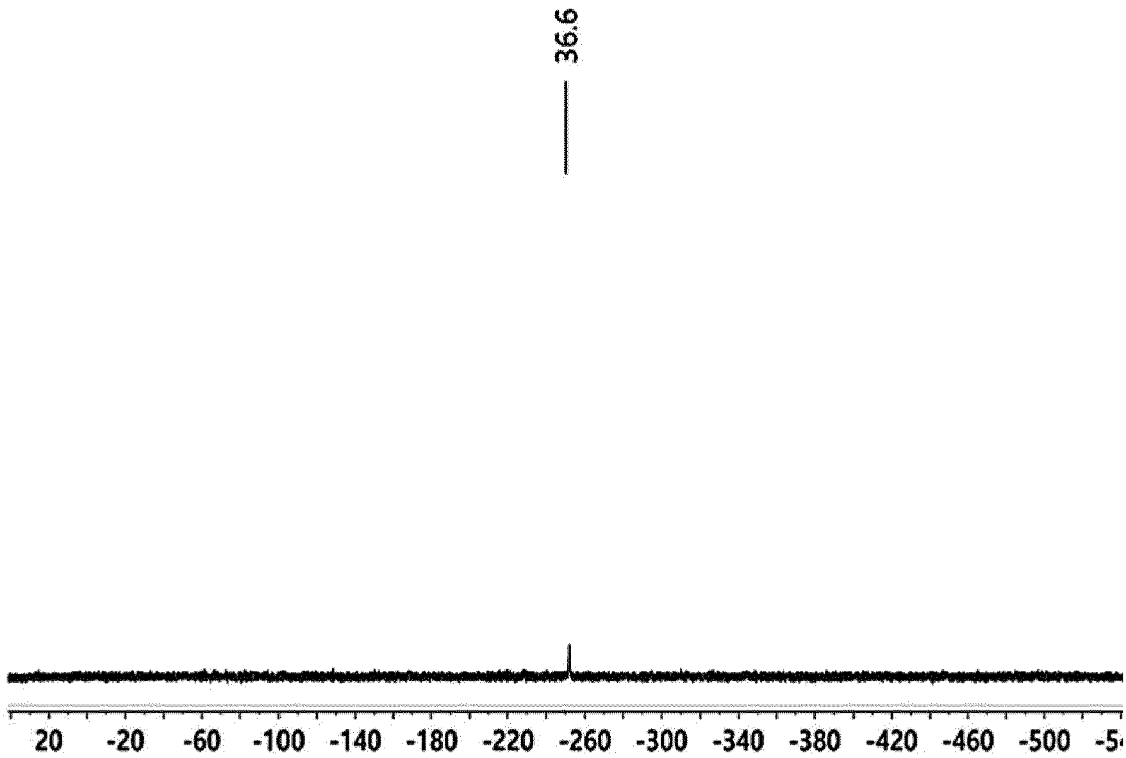

FIG. 4A

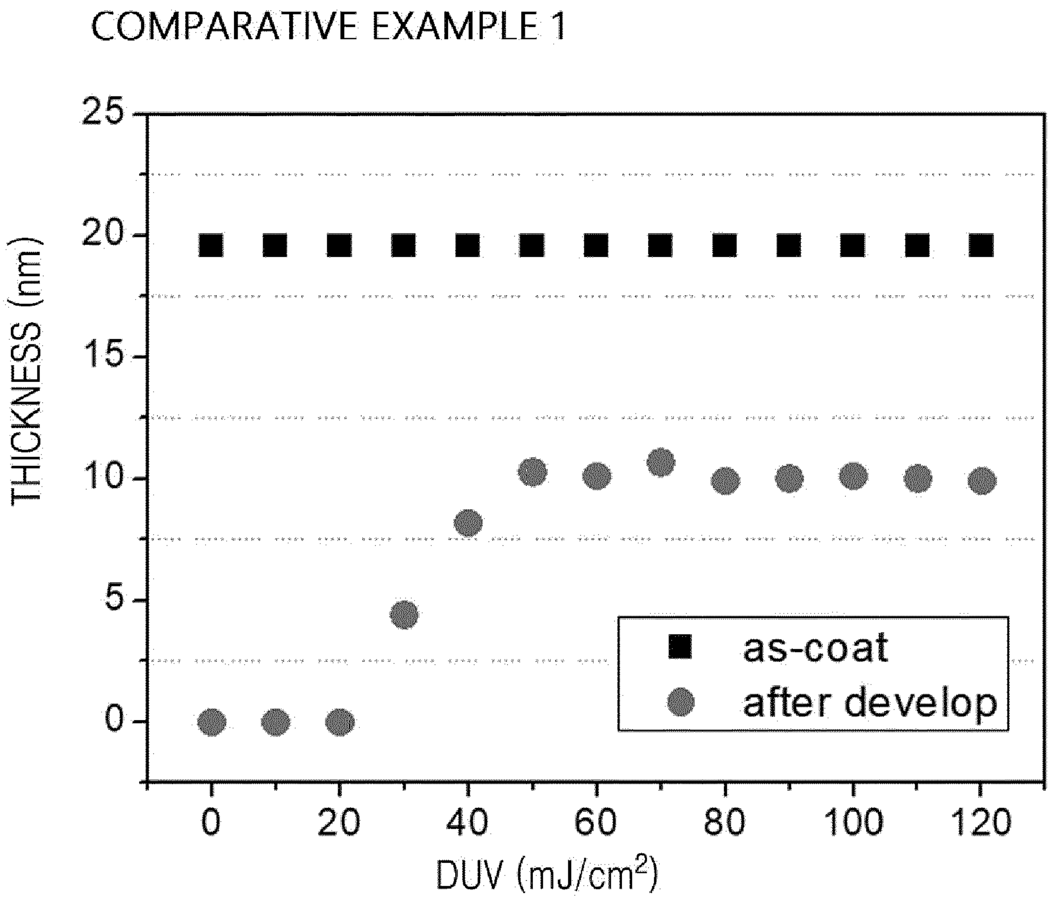
COMPARATIVE EXAMPLE 1
THICKNESS (nm)
25
20
15
10
5
0
0
20
40
60
80
100
120
DUV (mJ/cm2)
as-coat
after develop

# FIG. 4B

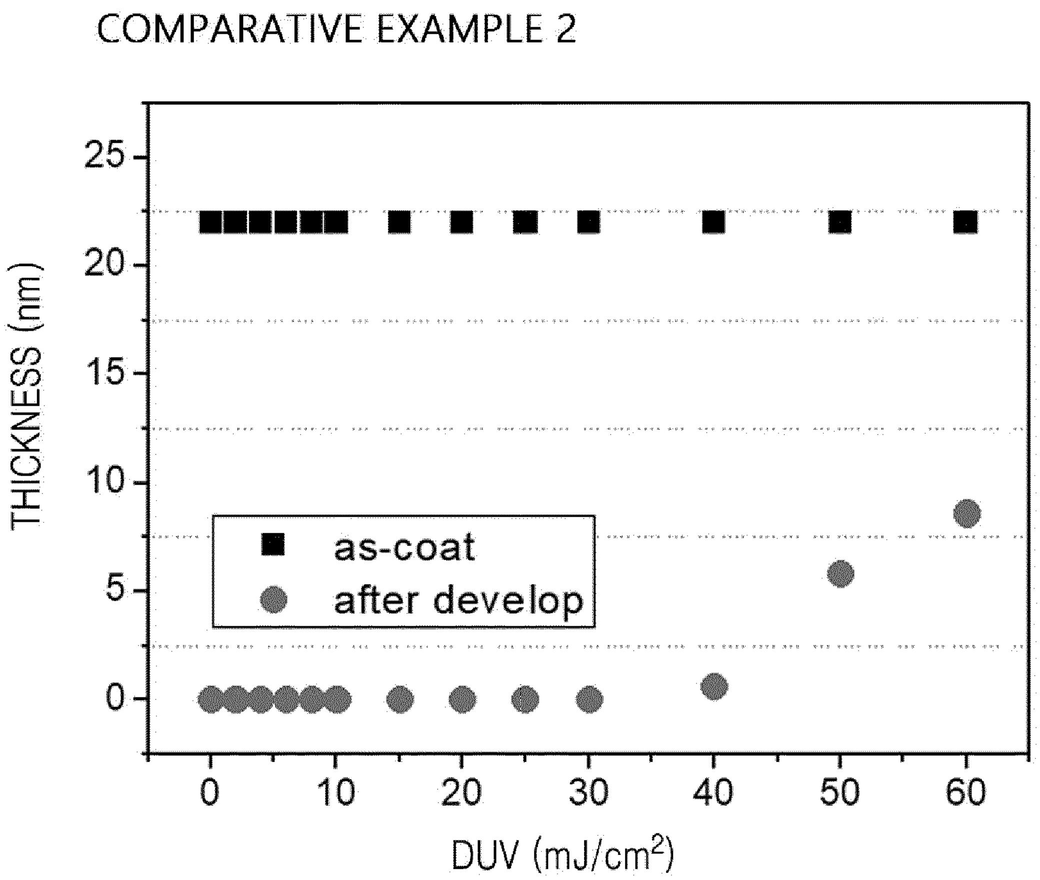
COMPARATIVE EXAMPLE 2
THICKNESS (nm)
25
20
15
10
5
0
as-coat
after develop
0
10
20
30
40
50
60
DUV (mJ/cm2)

# FIG. 4C

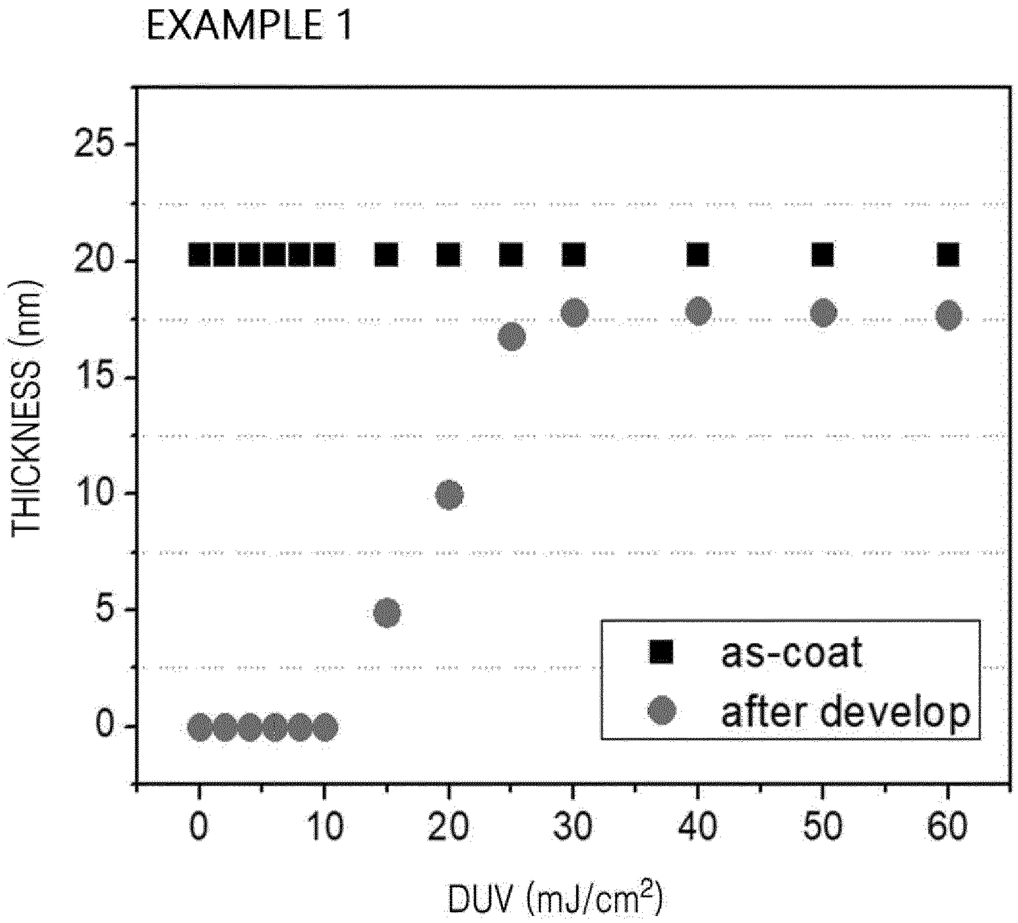
EXAMPLE 1
THICKNESS (nm)
25
20
15
10
5
0
0
10
20
30
40
50
60
DUV (mJ/cm2)
as-coat
after develop

# FIG. 4D

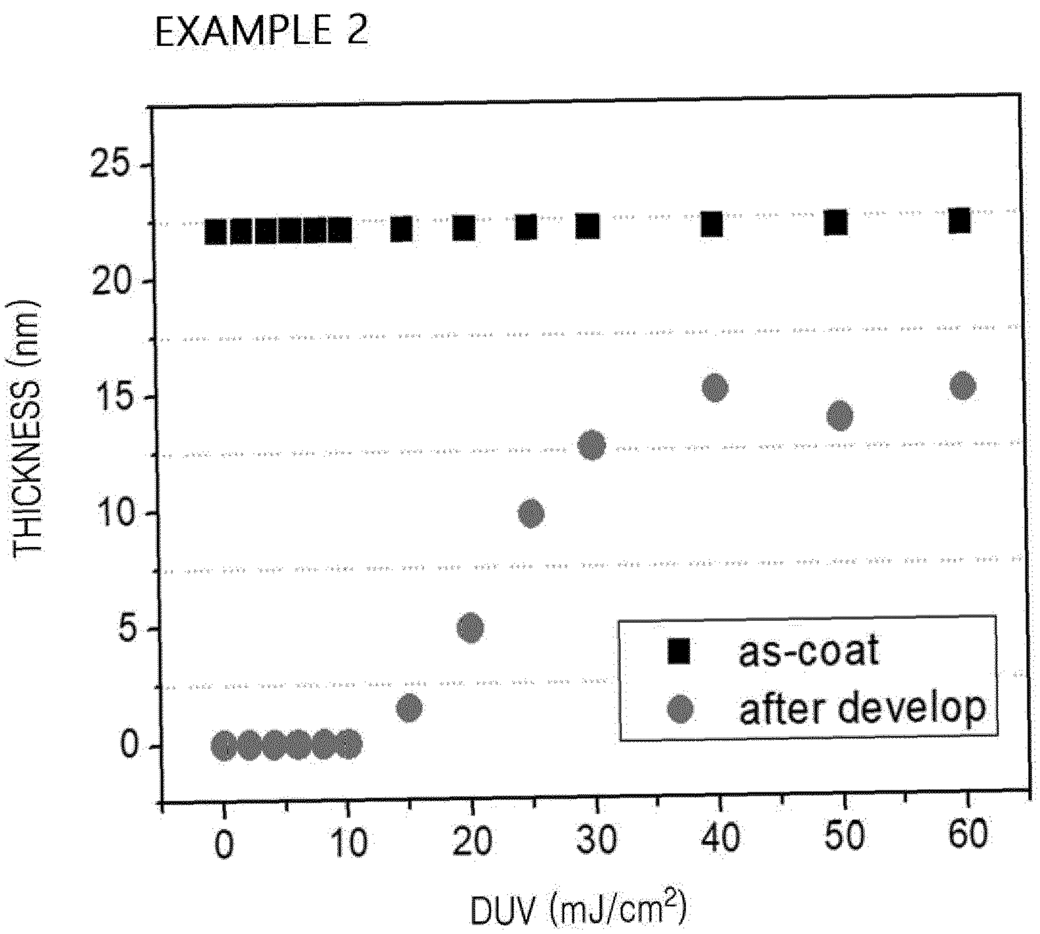
EXAMPLE 2
THICKNESS (nm)
25
20
15
10
5
0
0
10
20
30
40
50
60
DUV (mJ/cm2)
as-coat
after develop

FIG. 4E

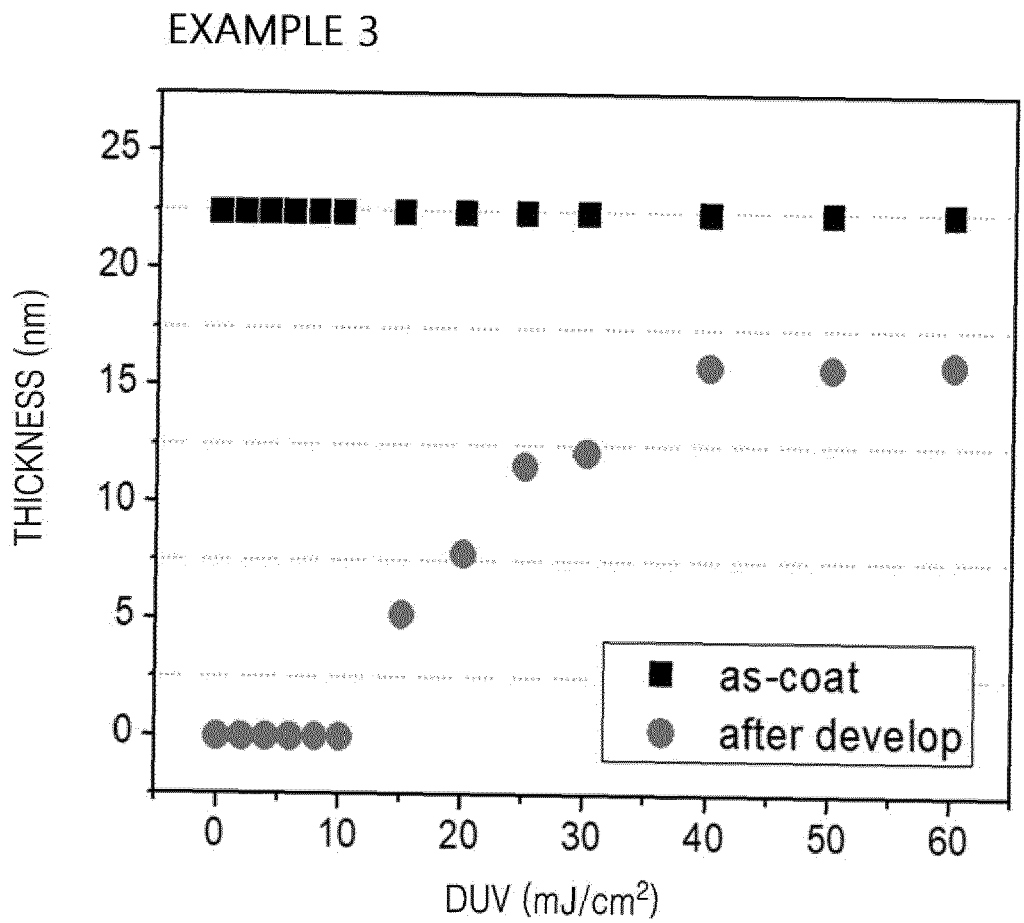
EXAMPLE 3
THICKNESS (nm)
25
20
15
10
5
0
0
10
20
30
40
50
60
DUV (mJ/cm2)
as-coat
after develop

# FIG. 4F

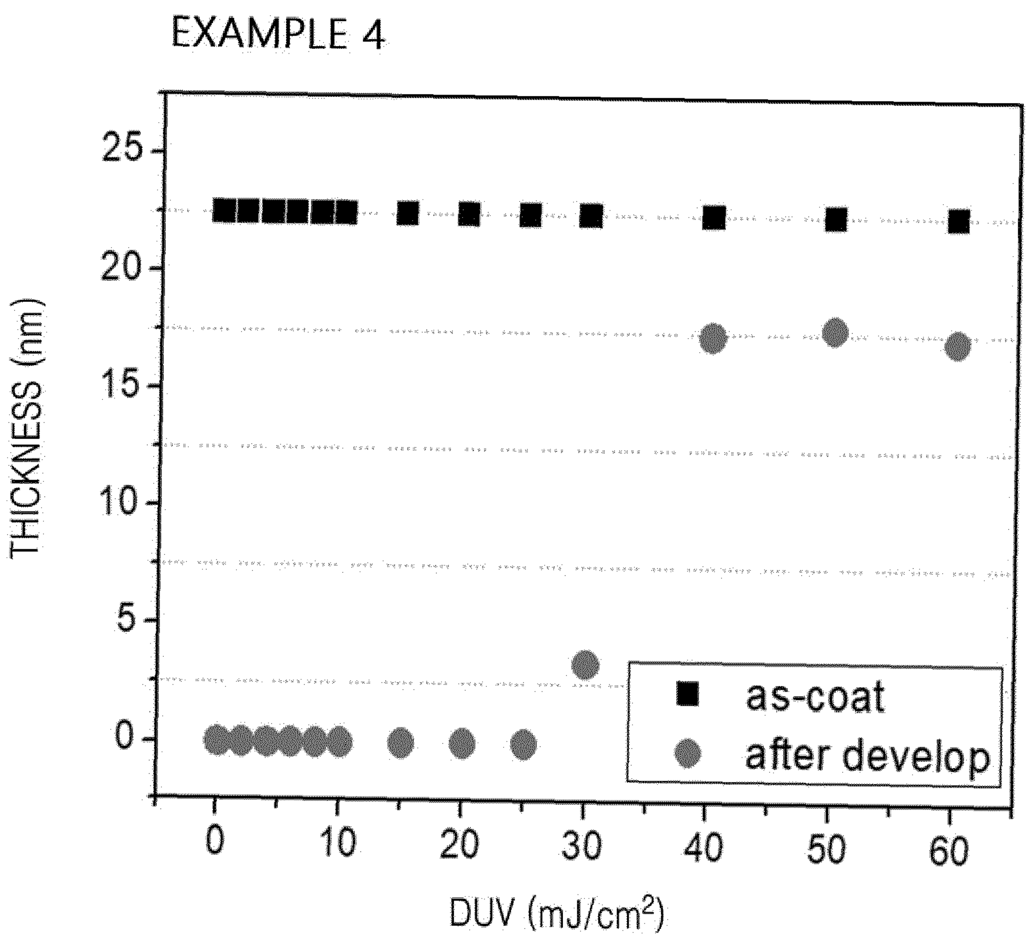
EXAMPLE 4
THICKNESS (nm)
25
20
15
10
5
0
0
10
20
30
40
50
60
DUV (mJ/cm2)
as-coat
after develop

# FIG. 4G

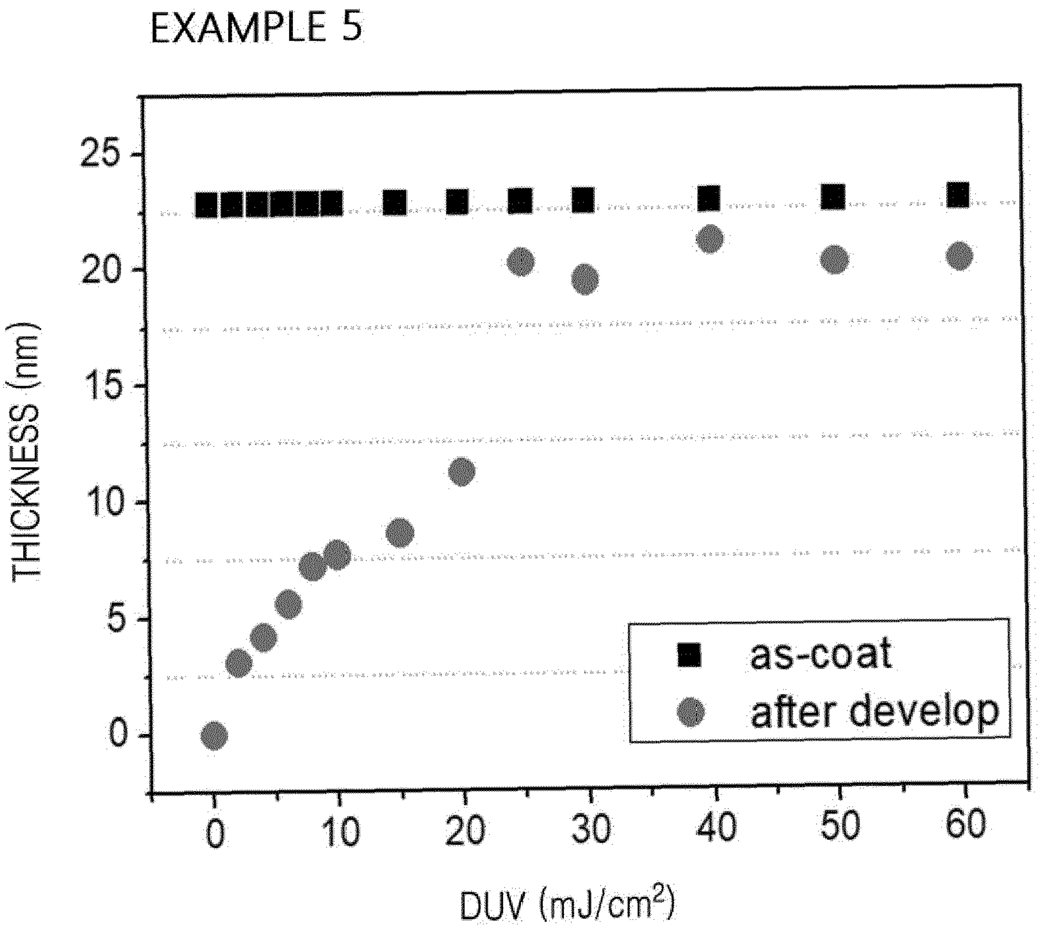
EXAMPLE 5
THICKNESS (nm)
DUV (mJ/cm2)
0
5
10
15
20
25
0
10
20
30
40
50
60
as-coat
after develop

# FIG. 4H

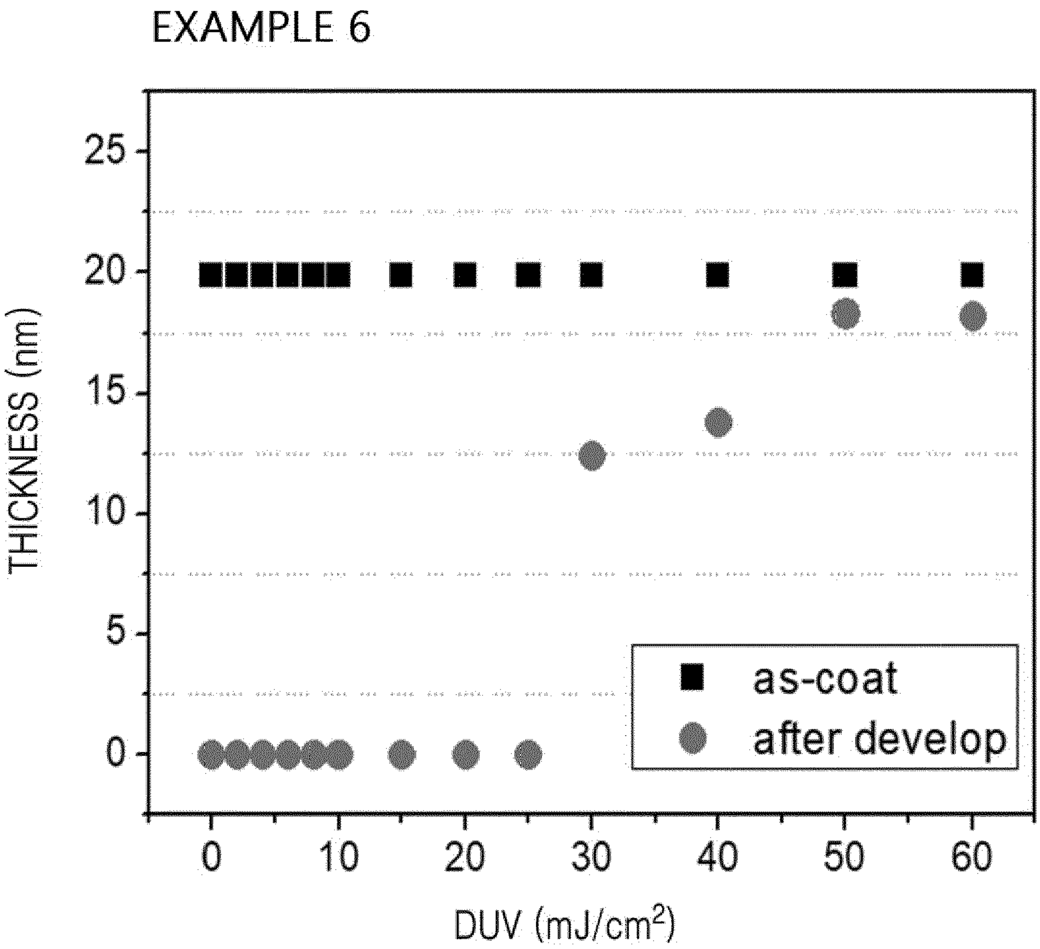
EXAMPLE 6
THICKNESS (nm)
25
20
15
10
5
0
0
10
20
30
40
50
60
DUV (mJ/cm2)
as-coat
after develop

# FIG. 4I

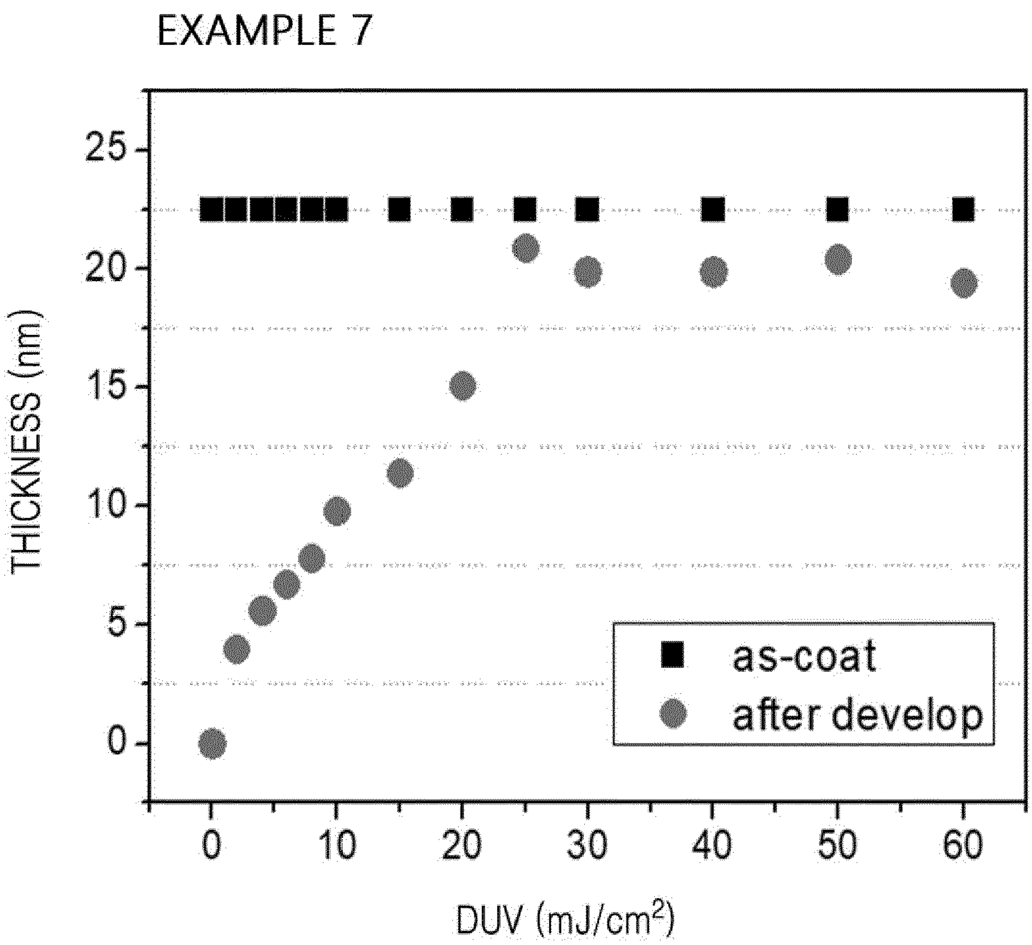
EXAMPLE 7
THICKNESS (nm)
25
20
15
10
5
0
0
10
20
30
40
50
60
DUV (mJ/cm2)
as-coat
after develop

# FIG. 4J

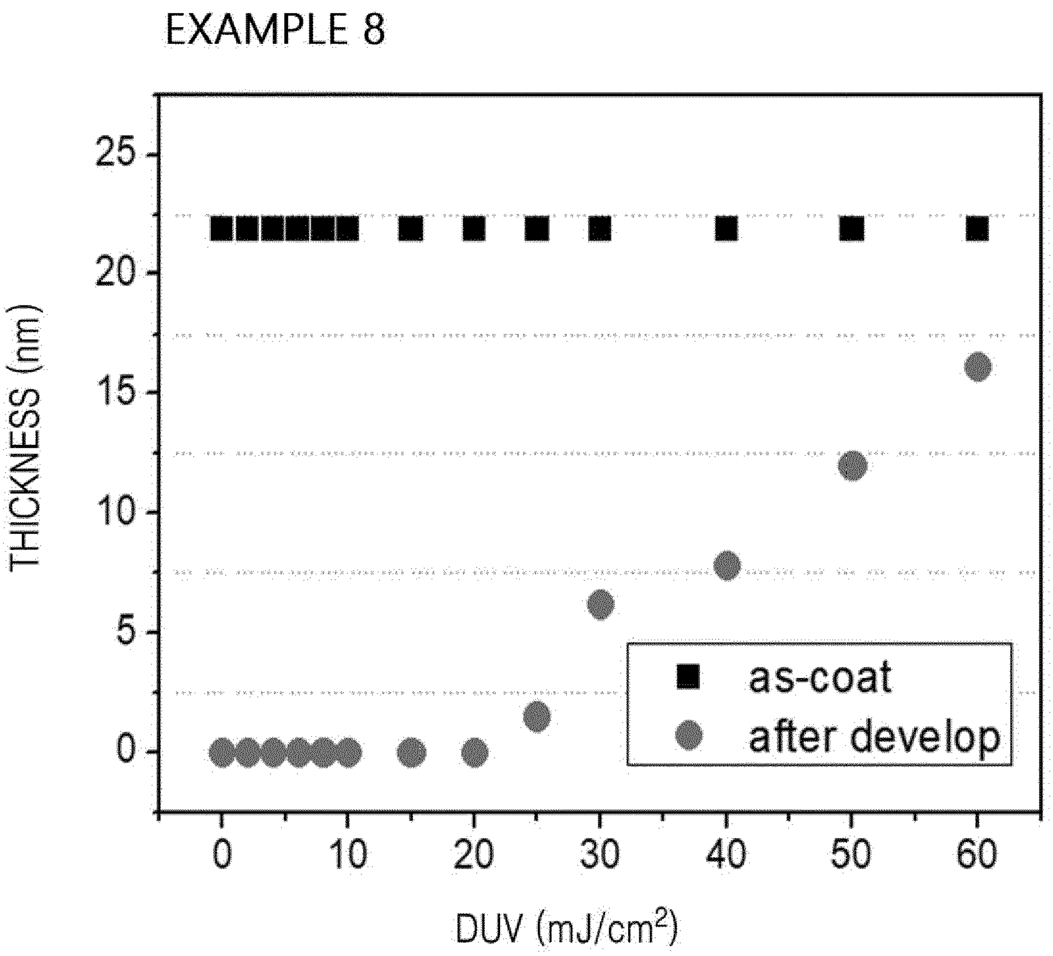
EXAMPLE 8
THICKNESS (nm)
25
20
15
10
5
0
0
10
20
30
40
50
60
DUV (mJ/cm2)
as-coat
after develop

FIG. 5A

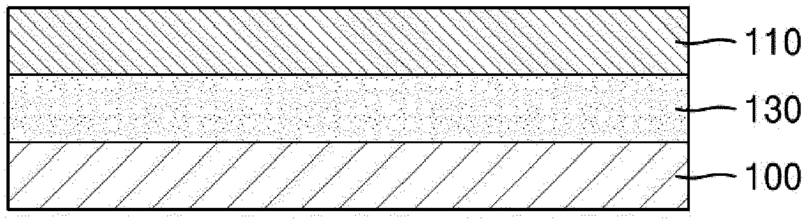

FIG. 5B

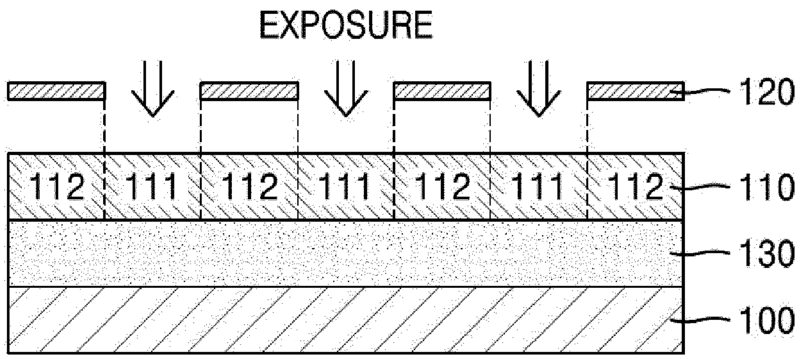

FIG. 5C

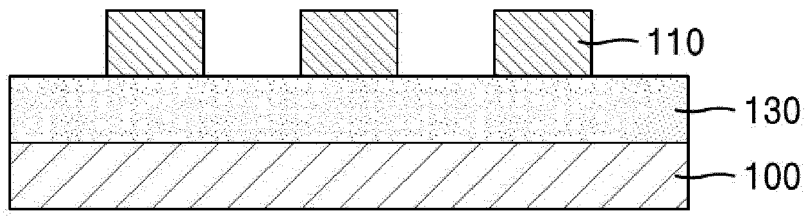

FIG. 5D

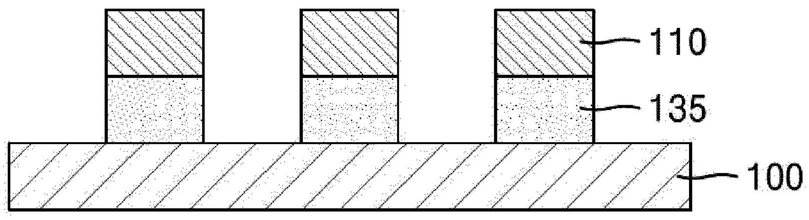

FIG. 5E

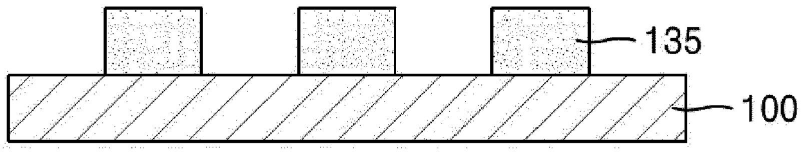

Europäisches Patentamt
European Patent Office
Office européen des brevets

# EUROPEAN SEARCH REPORT

Application Number
EP 23 17 9243

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/334474 A1 (LEE HONGJOON [KR] ET AL) 20 October 2022 (2022-10-20) * paragraphs [0017] - [0023], [0029], [0030], [0033], [0063] - [0065], [0071] - [0104]; claims 1-20; figures 2, 3B, 3C; examples 1-6 * ----- | 1,3-11, 13-15 | INV. G03F7/004 C07F7/22 |
| A | US 2021/311387 A1 (WOO CHANGSOO [KR] ET AL) 7 October 2021 (2021-10-07) * experimental part; paragraphs [0109] - [0111]; claims 1-15 * ----- | 1-15 | |
| A | US 2020/041896 A1 (MOON KYUNG SOO [KR] ET AL) 6 February 2020 (2020-02-06) * experimental part; paragraphs [0060] - [0062]; claims 1-20 * ----- | 1-15 | |

TECHNICAL FIELDS SEARCHED (IPC)

G03F
C07F

The present search report has been drawn up for all claims

| Place of search | Date of completion of the search | Examiner |
|---|---|---|
| Munich | 1 December 2023 | Eggers, Karin |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 23 17 9243

This annex lists the patent family members relating to the patent documents cited in the above-mentioned European search report. The members are as contained in the European Patent Office EDP file on The European Patent Office is in no way liable for these particulars which are merely given for the purpose of information.

01-12-2023

| Patent document cited in search report | Publication date | Patent family member(s) | Publication date |
|---|---|---|---|
| US 2022334474 A1 | 20-10-2022 | NONE | |
| US 2021311387 A1 | 07-10-2021 | CN 113495429 A | 12-10-2021 |
| | | JP 7168715 B2 | 09-11-2022 |
| | | JP 2021162865 A | 11-10-2021 |
| | | KR 20210123138 A | 13-10-2021 |
| | | TW 202138380 A | 16-10-2021 |
| | | US 2021311387 A1 | 07-10-2021 |
| US 2020041896 A1 | 06-02-2020 | KR 20200014043 A | 10-02-2020 |
| | | US 2020041896 A1 | 06-02-2020 |

EPO FORM P0459

For more details about this annex : see Official Journal of the European Patent Office, No. 12/82